(19) Europäisches Patentamt
European Patent Office
Office européen des brevets

(11) EP 2 924 773 B1

(12) **EUROPEAN PATENT SPECIFICATION**

(45) Date of publication and mention of the grant of the patent:
**02.08.2017 Bulletin 2017/31**

(21) Application number: **13856614.6**

(22) Date of filing: **19.11.2013**

(51) Int Cl.:
***C23C 14/06*** *(2006.01)* ***C23C 14/35*** *(2006.01)*
***C22C 18/00*** *(2006.01)* ***C22C 18/04*** *(2006.01)*
***C22C 24/00*** *(2006.01)* ***C22C 27/02*** *(2006.01)*
***C22C 28/00*** *(2006.01)* ***H01M 4/134*** *(2010.01)*
***H01M 4/38*** *(2006.01)* ***H01M 4/42*** *(2006.01)*
***H01M 4/62*** *(2006.01)* ***C22C 13/00*** *(2006.01)*
***C22C 30/04*** *(2006.01)* ***C22C 30/06*** *(2006.01)*
*H01M 10/052 (2010.01)* *H01M 4/02 (2006.01)*

(86) International application number:
**PCT/JP2013/081147**

(87) International publication number:
**WO 2014/080896 (30.05.2014 Gazette 2014/22)**

(54) **NEGATIVE ELECTRODE FOR ELECTRICAL DEVICE AND ELECTRICAL DEVICE PROVIDED WITH SAME**

NEGATIVELEKTRODE FÜR EINE ELEKTRISCHE VORRICHTUNG UND ELEKTRISCHE VORRICHTUNG DAMIT

ÉLECTRODE NÉGATIVE POUR UN DISPOSITIF ÉLECTRIQUE ET DISPOSITIF ÉLECTRIQUE POURVU DE CETTE DERNIÈRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.11.2012 JP 2012256939**

(43) Date of publication of application:
**30.09.2015 Bulletin 2015/40**

(73) Proprietor: **NISSAN MOTOR CO., LTD.**
**Yokohama-shi, Kanagawa 220-8623 (JP)**

(72) Inventors:
- **YAMAMOTO, Kensuke**
  **Atsugi-shi**
  **Kanagawa 243-0123 (JP)**
- **WATANABE, Manabu**
  **Atsugi-shi**
  **Kanagawa 243-0123 (JP)**
- **MIKI, Fumihiro**
  **Atsugi-shi**
  **Kanagawa 243-0123 (JP)**
- **SANADA, Takashi**
  **Atsugi-shi**
  **Kanagawa 243-0123 (JP)**
- **CHIBA, Nobutaka**
  **Atsugi-shi**
  **Kanagawa 243-0123 (JP)**

(74) Representative: **Hoefer & Partner Patentanwälte mbB**
**Pilgersheimer Straße 20**
**81543 München (DE)**

(56) References cited:
**EP-A1- 2 793 301** **WO-A1-2004/086539**
**WO-A1-2011/065504** **WO-A1-2012/121240**
**WO-A1-2012/160854** **WO-A1-2013/088846**
**JP-A- 2004 311 429** **JP-A- 2007 149 604**
**JP-A- 2012 051 078** **US-A1- 2010 119 942**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 924 773 B1

## Description

TECHNICAL FIELD

The present invention relates to a negative electrode for an electric device and an electric device using the same. In particular, the negative electrode for an electric device and the electric device using the same according to the present invention are used for a driving power source and an auxiliary power source of a motor serving as, for example, a secondary battery or a capacitor for use in a vehicle such as an electric vehicle, a fuel cell vehicle and a hybrid electric vehicle.

BACKGROUND ART

There has been a strong demand for reduction of the amount of carbon dioxide in order to deal with atmospheric pollution and global warming. In the automobile industry, the reduction of emissions of carbon dioxide is highly expected in association with the spread of electric vehicles (EV) and hybrid electric vehicles (HEV). Thus, development of electric devices such as secondary batteries for driving motors as a key to practical application of such vehicles, is actively being carried out.

The secondary batteries for driving motors are required to have quite high output performance and high energy as compared with lithium ion secondary batteries for general use in mobile phones, laptop computers and the like. Therefore, lithium ion secondary batteries having the highest theoretical energy among all types of batteries are gaining increasing attention, which is leading to rapid development of the lithium ion secondary batteries.

A lithium ion secondary battery generally includes: a positive electrode including a positive electrode current collector to which a positive electrode active material and the like is applied on both surfaces via a binder, a negative electrode including a negative electrode current collector to which a negative electrode active material and the like is applied on both surfaces via a binder, and an electrolyte layer, the positive electrode and the negative electrode being connected to each other via the electrolyte layer and housed in a battery case.

In such a conventional lithium ion secondary battery, a carbon/graphite-based material having the advantage of charge-discharge cycle life or costs has been used for the negative electrode. However, the carbon/graphite-based negative electrode material has the disadvantage that a sufficient theoretical charge-discharge capacity of 372 mAh/g or higher obtained from $LiC_6$ as a lithium introduction compound accounting for the largest amount, cannot be ensured because the battery is charged/discharged by absorbing lithium ions into graphite crystals and releasing the lithium ions therefrom. As a result, it is difficult to ensure a capacity and energy density sufficient to satisfy vehicle usage on the practical level by use of the carbon/graphite-based negative electrode material.

On the other hand, a battery using a material alloyed with Li for a negative electrode has higher energy density than the conventional battery using the carbon/graphite-based negative electrode material. Therefore, such a negative electrode material is highly expected to be used for a battery in a vehicle. For example, 1 mole of a Si material absorbs and releases 4.4 moles of lithium ions, in accordance with the following reaction formula (1), during charge and discharge, and a theoretical capacity of $Li_{22}Si_5$ (=$Li_{4.4}Si$) is 2100 mAh/g. Further, the Si material has an initial capacity as high as 3200 mAh/g (refer to sample 42 in Reference Example C) in the case of calculation per Si weight.

[Chem. 1]

$$Si+4.4Li^{+}+e^{-} \leftrightarrow Li_{4.4}Si \qquad (A)$$

However, in the lithium ion secondary battery using the material alloyed with Li for the negative electrode, expansion-shrinkage in the negative electrode at the time of charge and discharge is large. For example, volumetric expansion of the graphite material in the case of absorbing Li ions is approximately 1.2 times. However, the Si material has a problem of a reduction in cycle life of the electrode due to a large volumetric change (approximately 4 times) which is caused by transition from an amorphous state to a crystal state when Si is alloyed with Li. In addition, when using the Si negative electrode active material, a capacity has a trade-off relationship with cycle durability. Thus, it is difficult to increase the capacity and improve the cycle durability concurrently.

In order to deal with the problems described above, there is known a negative electrode active material for a lithium ion secondary battery containing an amorphous alloy having a formula: $Si_xM_yAl_z$ (for example, refer to Patent Document 1). In the formula, x, y, and z represent atomic percent values and satisfy the conditions of $x+y+z=100$, $x\geq55$, $y<22$, and $z>0$, and M is a metal formed of at least one of Mn, Mo, Nb, W, Ta, Fe, Cu, Ti, V, Cr, Ni, Co, Zr, and Y. Patent Document 1 teaches in paragraph [0018] that good cycle life is ensured in addition to a high capacity by minimizing the content of the metal M.

CITATION LIST

PATENT DOCUMENT

Patent Document 1: Japanese Translation of PCT International Application Publication No. JP-T-2009-517850

SUMMARY OF INVENTION

TECHNICAL PROBLEM

In the case of using the lithium ion secondary battery including the negative electrode containing the amorphous alloy having the formula: $Si_xM_yAl_z$, as disclosed in Patent Document 1, although good cycle property can be exhibited, an initial capacity is not ensured sufficiently. Further, the cycle property is not very satisfactory to the lithium ion secondary battery.

An object of the present invention is to provide a negative electrode for an electric device such as a Li ion secondary battery capable of exhibiting well-balanced characteristics of a high cycle property and a high initial capacity.

SOLUTION TO PROBLEM

The inventors of the present invention devoted themselves to continuous studies to solve the conventional problems. As a result, the inventors found out that it is possible to solve the problems by using a predetermined ternary Si alloy as a negative electrode active material and further using a negative electrode current collector having predetermined elastic elongation to accomplish the present invention.

The present invention is defined in the appended claims.

The present invention relates to a negative electrode for an electric device including a current collector and an electrode layer containing a negative electrode active material, a conductive auxiliary agent and a binder and formed on a surface of the current collector. The negative electrode active material is an alloy represented by the following formula (1).

[Chem. 2]

$$Si_xZn_yM_zA_a \qquad (1)$$

In addition, elastic elongation of the current collector is 1.30% or greater. In the formula (1), M is Sn, and A is an inevitable impurity. Further, x, y, z and a represent mass percent values and satisfy the conditions of 23<x<64, 0<y<65, 4<z<34 0<a<0.5, and x+y+z+a=100.

BRIEF DESCRIPTION OF DRAWINGS

[Fig. 1] Fig. 1 is a cross-sectional view schematically showing an outline of a laminated-type flat non-bipolar lithium ion secondary battery which is a typical embodiment of an electric device according to the present invention.

[Fig. 2] Fig. 2 is a perspective view schematically showing an appearance of the laminated-type flat lithium ion secondary battery which is the typical embodiment of the electric device according to the present invention.

[Fig. 3] Fig. 3 is a ternary composition diagram showing composition ranges of a Si-Zn-V series alloy contained in a negative electrode active material included in a negative electrode for an electric device not belonging to the present invention, wherein alloy compositions obtained in Reference Example A are plotted.

[Fig. 4] Fig. 4 is a ternary composition diagram showing preferable composition ranges of the Si-Zn-V series alloy contained in the negative electrode active material included in the negative electrode for an electric device not belonging to the present invention.

[Fig. 5] Fig. 5 is a ternary composition diagram showing composition ranges of a Si-Zn-Sn series alloy contained in the negative electrode active material included in the negative electrode for an electric device according to the present invention, wherein alloy compositions obtained in Reference Example B are plotted.

[Fig. 6] Fig. 6 is a ternary composition diagram showing preferable composition ranges of the Si-Zn-Sn series alloy contained in the negative electrode active material included in the negative electrode for an electric device according to the present invention.

[Fig. 7] Fig. 7 is a ternary composition diagram showing more preferable composition ranges of the Si-Zn-Sn series alloy contained in the negative electrode active material included in the negative electrode for an electric device according to the present invention.

[Fig. 8] Fig. 8 is a ternary composition diagram showing still more preferable composition ranges of the Si-Zn-Sn series alloy contained in the negative electrode active material included in the negative electrode for an electric device according to the present invention.

[Fig. 9] Fig. 9 is a diagram showing an influence of the alloy composition of the negative electrode active material on an initial discharge capacity in each battery obtained in Reference Example B of the present invention.

[Fig. 10] Fig. 10 is a diagram showing a relationship between a discharge capacity retention rate at the 50th cycle and the alloy composition of the negative electrode active material in each battery obtained in Reference Example B of the present invention.

[Fig. 11] Fig. 11 is a diagram showing a relationship between a discharge capacity retention rate at the 100th cycle and the alloy composition of the negative electrode active material in each battery obtained in Reference Example B of the present invention.

[Fig. 12] Fig. 12 is a composition diagram of a Si-Zn-Al series ternary alloy, wherein a discharge capacity (mAh/g) at the 1st cycle in a battery using each sample (samples No. 1 to 48) obtained in Reference Example C is plotted while being sorted according to color (shaded) depending on the level of the capacity.

[Fig. 13] Fig. 13 is a composition diagram of the Si-Zn-Al series ternary alloy, wherein a discharge capacity retention rate (%) at the 50th cycle in the battery using each sample (samples No. 1 to 48) obtained in Reference Example C is plotted while being sorted according to color (shaded) depending on the level of the discharge capacity retention rate.

[Fig. 14] Fig. 14 is a composition diagram of the Si-Zn-Al series alloy samples prepared in Reference Example C, wherein the area corresponding to composition ranges of the Si-Zn-Al series ternary alloy samples is hatched (shaded) on the composition diagram of Fig. 12. In the figure, the area satisfies $0.21 \leq Si(wt\%/100) < 1.00$, $0 < Zn(wt\%/100) < 0.79$, and $0 < Al(wt\%/100) < 0.79$.

[Fig. 15] Fig. 15 is a composition diagram of the Si-Zn-Al series alloy samples prepared in Reference Example C, wherein the area corresponding to preferable composition ranges among the Si-Zn-Al series ternary alloy samples is hatched (shaded) on the composition diagram of Fig. 13. In the figure, the area satisfies $0.26 \leq Si(wt\%/100) \leq 0.78$, $0.16 \leq Zn(wt\%/100) \leq 0.69$, and $0 < Al(wt\%/100) \leq 0.51$.

[Fig. 16] Fig. 16 is a composition diagram of the Si-Zn-Al series alloy samples prepared in Reference Example C, wherein the area corresponding to more preferable composition ranges among the Si-Zn-Al series ternary alloy samples is hatched (shaded) on the composition diagram of Fig. 13. In the figure, the area satisfies $0.26 \leq Si(wt\%/100) \leq 0.66$, $0.16 \leq Zn(wt\%/100) \leq 0.69$, and $0.02 \leq Al(wt\%/100) \leq 0.51$.

[Fig. 17] Fig. 17 is a composition diagram of the Si-Zn-Al series alloy samples prepared in Reference Example C, wherein the area corresponding to particularly preferable composition ranges among the Si-Zn-Al series ternary alloy samples is hatched (shaded) on the composition diagram of Fig. 13. In the figure, the area satisfies $0.26 \leq Si(wt\%/100) \leq 0.47$, $0.18 \leq Zn(wt\%/100) \leq 0.44$, and $0.22 \leq Al(wt\%/100) \leq 0.46$.

[Fig. 18] Fig. 18 is a diagram showing a dQ/dV curve during discharge at the 1st cycle (initial cycle) in each battery using a sample of each of pure Si (sample 42) and the Si-Zn-Al series ternary alloy (sample 14) obtained in Reference Example C not belonging to the present invention.

[Fig. 19] Fig. 19 is a diagram showing charge-discharge curves of each charge curve during charge and each discharge curve during discharge up to the 50th cycle in a cell for evaluation (CR2032 type coin cell) using an electrode for evaluation including the Si-Zn-Al series ternary alloy (sample 14) obtained in Reference Example C not belonging to the present invention. In the figure, arrows from "initial" to "end" each represent a direction in which a charge-discharge cycle curve at the 1st cycle (initial) shifts to a charge-discharge cycle curve at the 50th cycle (end).

[Fig. 20] Fig. 20 is a ternary composition diagram showing composition ranges of a Si-Zn-C series alloy contained in the negative electrode active material included in the negative electrode for an electric device not belonging to the present invention, wherein alloy compositions obtained in Reference Example D are plotted.

[Fig. 21] Fig. 21 is a ternary composition diagram showing preferable composition ranges of the Si-Zn-C series alloy contained in the negative electrode active material included in the negative electrode for an electric device not belonging to the present invention.

[Fig. 22] Fig. 22 is a diagram showing a relationship between elastic elongation of a negative electrode current collector and an improvement rate of a discharge capacity retention rate of a battery of each of examples.

## DESCRIPTION OF EMBODIMENTS

As described above, the present invention is characterized by using a predetermined ternary Si alloy as a negative electrode active material and using a negative electrode current collector having predetermined elastic elongation.

According to the present invention, when the predetermined Si alloy is used as a negative electrode active material, amorphous-crystal phase transition is suppressed when Si is alloyed with Li so as to improve a cycle property. Further, in a negative electrode using the predetermined Si alloy, the current collector having predetermined elastic elongation can be elastically deformed by following a volumetric change of a negative electrode active material layer due to expansion-contraction of the negative electrode active material in association with charge and discharge of the battery. Thus, plastic deformation of the current collector hardly occurs, and a distortion of the negative electrode active material layer caused by the plastic deformation of the current collector can be prevented so as to keep an even distance between the negative electrode and the positive electrode. Accordingly, an electric device having a high capacity and high cycle durability can be ensured.

Hereinafter, the embodiment of a negative electrode for an electric device and an electric device using the same according to the present invention will be explained with reference to the drawings. It should be noted that the technical scope of the present invention should be defined based on the appended claims and is not limited to the embodiment described below. In the description of the drawings, the same elements are indicated by the same reference numerals, and overlapping explanations thereof are not repeated. In addition, dimensional ratios in the drawings are magnified for convenience of explanation and may be different from actual ratios.

Hereinafter, a fundamental configuration of the electric device to which the negative electrode for an electric device according to the present invention is applied will be explained with reference to the drawings. In the present embodiment, a lithium ion secondary battery is exemplified as the electric device. Note that, in the present invention, "an electrode layer" represents a compound layer including a negative electrode active material, a conductive auxiliary agent and a binder and is also referred to as "a negative electrode active material layer" in the explanation of the present specification. Similarly, an electrode layer on the positive electrode side is also referred to as "a positive electrode active material layer".

In a negative electrode for a lithium ion secondary battery, which is a typical embodiment of the negative electrode for an electric device according to the present invention, and a lithium ion secondary battery using the same, a cell (single cell layer) has large voltage so that high energy density and high output density can be ensured. Thus, the lithium ion secondary battery using the negative electrode for a lithium ion secondary battery according to the present embodiment is suitable for a driving power source or an auxiliary power source for a vehicle and is therefore desirable to be used as a lithium ion secondary battery for a driving power source and the like for use in a vehicle. Further, the present invention can be applied appropriately to lithium ion secondary batteries for mobile devices such as mobile phones.

In other words, other constituent requirements in the lithium ion secondary battery as an object of the present embodiment are not particularly limited as long as the lithium ion secondary battery is obtained by use of the negative electrode for a lithium ion secondary battery according to the present embodiment described below.

For example, when the lithium ion secondary battery is differentiated from other batteries in terms of the shape and structure, the lithium ion secondary battery may be applicable to any batteries having known shapes and structures such as a laminated (flat) battery and a wound (cylindrical) battery. The structure of the laminated (flat) battery contributes to ensuring long-term reliability by a simple sealing technology such as thermocompression bonding and therefore has the advantage of costs and workability.

In terms of electrical connection (electrode structure) inside the lithium ion secondary battery, the lithium ion secondary battery may be applicable not only to a non-bipolar (internal parallel connection type) battery but also to a bipolar (internal serial connection type) battery.

When the lithium ion secondary battery is differentiated from other batteries in terms of the type of an electrolyte layer used therein, the lithium ion secondary battery may be applicable to batteries including various types of known electrolyte layers such as a solution electrolyte battery in which a solution electrolyte such as a non-aqueous electrolyte liquid is used for an electrolyte layer and a polymer battery in which a polymer electrolyte is used for an electrolyte layer. The polymer battery is classified into a gel electrolyte battery using a polymer gel electrolyte (also simply referred to as a gel electrolyte) and a solid polymer (all solid state) battery using a polymer solid electrolyte (also simply referred to as a polymer electrolyte).

In the following explanation, a non-bipolar (internal parallel connection type) lithium ion secondary battery using the negative electrode for a lithium ion secondary battery according to the present embodiment will be explained briefly with reference to the drawings. However, the technical scope of the lithium ion secondary battery according to the present embodiment should not be limited to the following explanations.

<Entire Configuration of Battery>

Fig. 1 is a schematic cross-sectional view showing the entire configuration of a flat (laminated) lithium ion secondary battery (hereinafter, also simply referred to as a "laminated battery") which is a typical embodiment of the electric device according to the present invention.

As shown in Fig. 1, a laminated battery 10 according to the present embodiment has a configuration in which a substantially rectangular power generation element 21, in which a charge-discharge reaction actually progresses, is sealed inside a laminated sheet 29 as a battery exterior member. The power generation element 21 has a configuration in which positive electrodes, electrolyte layers 17 and negative electrodes are stacked, each positive electrode having a configuration in which positive electrode active material layers 13 are provided on both surfaces of a positive electrode current collector 11, each negative electrode having a configuration in which negative electrode active material layers 15 are provided on both surfaces of a negative electrode current collector 12. In other words, several sets of the positive electrode, the electrolyte layer and the negative electrode arranged in this order are stacked on top of each other in a manner such that one positive electrode active material layer 13 faces one negative electrode active material layer 15 with the electrolyte layer 17 interposed therebetween.

The positive electrode, the electrolyte layer and the negative electrode that are adjacent to one another thus constitute a single cell layer 19. Thus, the laminated battery 10 shown in Fig. 1 has a configuration in which the plural single cell layers 19 are stacked on top of each other so as to be electrically connected in parallel. Here, the positive electrode current collectors located on both outermost layers of the power generation element 21 are each provided with the positive electrode active material layer 13 only on one side thereof. Alternatively, the outermost positive electrode current collectors may each be provided with the positive electrode active material layers 13 on both sides thereof. That is, the current collectors each provided with the positive electrode active material layers on both sides thereof may be used as the respective outermost layers, in addition to the case where the current collectors each provided with the positive electrode active material layer 13 only on one side thereof are used as the respective outermost layers. Similarly, the negative electrode current collectors each provided with the negative electrode active material layer on one side or both sides thereof, may be located on the respective outermost layers of the power generation element 21 in a manner such that the positions of the positive electrodes and the negative electrodes shown in Fig. 1 are reversed.

A positive electrode current collecting plate 25 and a negative electrode current collecting plate 27 which are electrically conductive to the respective electrodes (the positive electrodes and the negative electrodes) are attached to the positive electrode current collectors 11 and the negative electrode current collectors 12, respectively. The positive electrode current collecting plate 25 and the negative electrode current collecting plate 27 are held by the respective end portions of the laminated sheet 29 and exposed to the outside of the laminated sheet 29. The positive electrode current collecting plate 25 and the negative electrode current collecting plate 27 may be attached to the positive electrode current collectors 11 and the negative electrode current collectors 12 of the respective electrodes via a positive electrode lead and a negative electrode lead (not shown in the figure) as appropriate by, for example, ultrasonic welding or resistance welding.

The lithium ion secondary battery described above is characterized by the negative electrode. Main constituent members of the battery including the negative electrode will be explained below.

<Positive Electrode>

[Positive Electrode Active Material Layer]

The positive electrode active material layer 13 contains a positive electrode active material and other additives as necessary.

(Positive Electrode Active Material)

Examples of the positive electrode active material include a lithium-transition metal composite oxide, a lithium-transition metal phosphate compound, a lithium-transition metal sulfated compound, a solid solution series material, a ternary series material, an NiMn series material, an NiCo series material, and a spinel-manganese series material.
Examples of the lithium-transition metal composite oxide include $LiMn_2O_4$, $LiCoO_2$, $LiNiO_2$, $Li(Ni, Mn, Co)O_2$, $Li(Li, Ni, Mn, Co)O_2$, $LiFePO_4$, and an oxide in which part of the transition metal contained in each of these composite oxides is substituted with other elements.
Examples of the solid solution series material include $xLiMO_2 \cdot (1-x)Li_2NO_3$ (where $0<x<1$, M represents at least one transition metal in an average oxidation state of 3+, and N represents at least one transition metal in an average oxidation state of 4+), and $LiRO_2$-$LiMn_2O_4$ (where R represents a transition metal element such as Ni, Mn, Co, and Fe).
The ternary series material may be a nickel-cobalt-manganese (composite) positive electrode material.
The NiMn series material may be $LiNi_{0.5}Mn_{1.5}O_4$.
The NiCo series material may be $Li(NiCo)O_2$.
The spinel-manganese series material may be $LiMn_2O_4$.
Two or more kinds of the positive electrode active materials may be combined together according to circumstances. In view of a capacity and output performance, the lithium-transition metal composite oxide is preferably used for the positive electrode active material. Note that other positive electrode active materials not listed above can, of course, be used instead. In the case that the respective active materials require different particle diameters in order to achieve their own appropriate effects, the active materials having different particle diameters may be selected and mixed together so as to optimally function to achieve their own effects. Thus, it is not necessary to equalize the particle diameter of all of the active materials.
An average particle diameter of the positive electrode active material contained in the positive electrode active material layer 13 is not particularly limited; however, in view of higher output performance, the average particle diameter is preferably in the range from 1 μm to 30 μm, more preferably in the range from 5 μm to 20 μm. Note that, in the present specification, "the particle diameter" represents the greatest length between any two points on the circumference of the active material particle (the observed plane) observed by observation means such as a scanning electron microscope (SEM) and a transmission electron microscope (TEM). In addition, "the average particle diameter" represents a value calculated with the scanning electron microscope (SEM) or the transmission electron microscope (TEM) as an average value of particle diameters of the particles observed in several to several tens of fields of view. Particle diameters and average particle diameters of other constituents may also be determined in the same manner.
The positive electrode (the positive electrode active material layer) may be formed by a method of applying (coating) ordinary slurry thereto, or by any of a kneading method, a sputtering method, a vapor deposition method, a CVD method, a PVD method, an ion plating method, and a thermal spraying method.

<Positive Electrode Current Collector>

The positive electrode current collector 11 is made from an electrically conductive material. The size of the current collector may be determined depending on the intended use of the battery. For example, a current collector having a large area is used for a large-size battery for which high energy density is required.
The thickness of the current collector is not particularly limited. The thickness is generally approximately in the range from 1 μm to 100 μm.
The shape of the current collector is not particularly limited. The laminated battery 10 shown in Fig. 1 may use a current collecting foil or a mesh current collector (such as an expanded grid).
The material used for the current collector is not particularly limited. For example, a metal or resin in which electrically conductive filler is added to an electrically conductive polymer material or a non-conductive polymer material may be used.
Examples of the metal include aluminum, nickel, iron, stainless steel, titanium and copper. In addition, a clad metal of nickel and aluminum, a clad metal of copper and aluminum, or an alloyed material of these metals combined together, may be preferably used. A foil in which a metal surface is covered with aluminum may also be used.
Examples of the electrically conductive polymer material include polyaniline, polypyrrole, polythiophene, polyacetylene, polyparaphenylene, polyphenylene vinylene, polyacrylonitrile and polyoxadiazole. These electrically conductive polymer materials have the advantage in simplification of the manufacturing process and lightness of the current collector, since these materials have sufficient electric conductivity even if electrically conductive filler is not added thereto.

Examples of the non-conductive polymer material include polyethylene (PE; such as high-density polyethylene (HDPE) and low-density polyethylene (LDPE)), polypropylene (PP), polyethylene terephthalate (PET), polyether nitrile (PEN), polyimide (PI), polyamide imide (PAI), polyamide (PA), polytetrafluoroethylene (PTFE), styrene-butadiene rubber (SBR), polyacrylonitrile (PAN), polymethyl acrylate (PMA), polymethyl methacrylate (PMMA), polyvinyl chloride (PVC), polyvinylidene fluoride (PVdF), and polystyrene (PS). These non-conductive polymer materials have high potential resistance or solvent resistance.

The electrically conductive polymer material or the non-conductive polymer material may include electrically conductive filler that is added as necessary. In particular, when the resin serving as a substrate of the current collector only contains a non-conductive polymer, the electrically conductive filler is essential to impart electric conductivity to the resin.

The electrically conductive filler is not particularly limited as long as it is a substance having electric conductivity. Examples of the material having high electric conductivity, potential resistance or lithium ion insulation property, include metal and electrically conductive carbon. The metal is not particularly limited; however, the metal is preferably at least one element selected from the group consisting of Ni, Ti, Al, Cu, Pt, Fe, Cr, Sn, Zn, In, Sb, and K, or an alloy or metal oxide containing these metals. The electrically conductive carbon is not particularly limited; however, the electrically conductive carbon is preferably at least one material selected from the group consisting of acetylene black, Vulcan, Black Pearls, carbon nanofiber, Ketjenblack, carbon nanotube, carbon nanohorn, carbon nanoballoon, and fullerene.

The amount of the electrically conductive filler added in the current collector is not particularly limited as long as it imparts sufficient electric conductivity to the current collector. In general, the amount thereof is approximately in the range from 5 to 35% by mass.

<Negative Electrode>

The negative electrode according to the present embodiment is characterized by including a current collector and an electrode layer provided on each surface of the current collector and containing a particular negative electrode active material, a conductive auxiliary agent and a binder, and characterized in that elastic elongation of the current collector is 1.30% or higher.

[Negative Electrode Active Material Layer]

The negative electrode active material layer 15 contains a negative electrode active material and other additives as necessary.

(Negative Electrode Active Material)

A Si-Zn-M ternary alloy used in the negative electrode active material according to the present embodiment is represented by the following chemical formula (1).
[Chem. 3]

$$Si_xZn_yM_zA_a \qquad (1)$$

In the formula (1), M is Sn, and A represents inevitable impurities. Further, x, y, z and a represent mass percent values and satisfy the conditions of $23<x<64$, $0<y<65$, $4<z<34$, $0<a<0.5$, and $x+y+z+a=100$. Note that, in the present specification, the "inevitable impurities" described above are substances in the Si alloy which are derived from the raw materials or inevitably mixed in the production process. The inevitable impurities contained are essentially unnecessary but permissible substances, since the amount thereof is quite small and there is no influence on the characteristics of the Si alloy.

In the present embodiment, a first additive element Zn and a second additive element M (Sn) are selected as a negative electrode active material so as to suppress amorphous-crystal phase transition at the time of the alloying with Li and extend cycle life. Accordingly, the negative electrode active material thus obtained has a higher capacity than conventional negative electrode active materials such as carbon-based negative electrode active materials.

The reason the amorphous-crystal phase transition should be suppressed at the time of the alloying with Li is that the function as an active material is lost by breakage of particles per se due to a large volumetric change (approximately 4 times) in the Si material which is caused by transition from an amorphous state to a crystal state when Si is alloyed with Li. In other words, the suppression of the amorphous-crystal phase transition can prevent breakage of the particles per se, secure the function as an active material (high capacity) and extend cycle life. The first and second additive elements selected as described above can provide the Si alloy negative electrode active material having a high capacity and high cycle durability.

As described above, M is Sn. The following is the detail of the Si alloy having such a composition $Si_xZn_ySn_zA_a$. Further described but not part of the present invention are alloys having the composition $Si_xZn_yV_zA_a$, $Si_xZn_yAl_zA_a$ and $Si_xZn_yC_zA_a$.

(Si Alloy Represented by $Si_xZn_yV_zA_a$) - not belonging to the present invention

The composition $Si_xZn_yV_zA_a$ obtained by selecting Zn as a first additive element and V as a second additive element as described above can suppress the amorphous-crystal phase transition at the time of the alloying with Li so as to extend cycle life. Accordingly, the negative electrode active material thus obtained has a higher capacity than conventional negative electrode active materials such as carbon-based negative electrode active materials.

In the alloy composition described above, x is preferably in the range from 33 to 50, y is preferably greater than 0 and 46 or less, and z is preferably in the range from 21 to 67. These numerical ranges correspond to the area indicated by sign A in Fig. 3. This Si alloy negative electrode active material is used for a negative electrode for an electric device, for example, a negative electrode for a lithium ion secondary battery. The alloy contained in the negative electrode active material absorbs lithium ions at the time of charge of the battery and releases the lithium ions at the time of discharge.

More particularly, the negative electrode active material described above, which is the Si alloy negative electrode active material, contains zinc (Zn) as a first additive element and vanadium (V) as a second additive element. The appropriately selected combination of the first additive element Zn and the second additive element V can suppress the amorphous-crystal phase transition at the time of the alloying with Li so as to extend cycle life. Accordingly, the negative electrode active material thus obtained has a higher capacity than carbon-based negative electrode active materials. Further, the first and second additive elements Zn and V having the optimized composition ranges can provide the Si (Si-Zn-V series) alloy negative electrode active material exhibiting good cycle life even after 50 cycles.

When the negative electrode active material contains the Si-Zn-V series alloy in which x is 33 or greater, y is greater than 0 and z is 67 or less, a sufficient initial capacity can be ensured. When x is 50 or less, y is 46 or less and z is 21 or greater, good cycle life can be achieved.

In order to further improve the above-described characteristics of the negative electrode active material, x is preferably in the range from 33 to 47, y is preferably in the range from 11 to 27, and z is preferably in the range from 33 to 56. These numerical ranges correspond to the area indicated by sign B in Fig. 4.

As described above, A is impurities (inevitable impurities) derived from the raw materials or the production process other than the three components described above, where a satisfies $0 \leq a < 0.5$, preferably $0 \leq a < 0.1$.

(Si Alloy Represented by $Si_xZn_ySn_zA_a$)

The composition $Si_xZn_ySn_zA_a$ obtained by selecting Zn as a first additive element and Sn as a second additive element as described above can suppress the amorphous-crystal phase transition at the time of the alloying with Li so as to extend cycle life. Accordingly, the negative electrode active material thus obtained has a higher capacity than conventional negative electrode active materials such as carbon-based negative electrode active materials.

In the alloy composition described above, x is greater than 23 and less than 64, y is greater than 0 and less than 65, and z is 4 or greater and 34 or less. These numerical ranges correspond to the area indicated by sign X in Fig. 5. This Si alloy negative electrode active material is used for a negative electrode for an electric device, for example, a negative electrode for a lithium ion secondary battery. The alloy contained in the negative electrode active material absorbs lithium ions at the time of charge of the battery and releases the lithium ions at the time of discharge.

More particularly, the negative electrode active material described above, which is the Si alloy negative electrode active material, contains zinc (Zn) as a first additive element and tin (Sn) as a second additive element. The appropriately selected combination of the first additive element Zn and the second additive element Sn can suppress the amorphous-crystal phase transition at the time of the alloying with Li so as to extend cycle life. Accordingly, the negative electrode active material thus obtained has a higher capacity than carbon-based negative electrode active materials.

Further, the first and second additive elements Zn and Sn having the optimized composition ranges can provide the Si (Si-Zn-Sn series) alloy negative electrode active material exhibiting good cycle life after 50 cycles and even after 100 cycles.

When the negative electrode active material contains the Si-Zn-Sn series alloy in which x is greater than 23, a sufficient discharge capacity at the 1 st cycle can be ensured. When z is 4 or greater, a good discharge capacity retention rate at the 50th cycle can sufficiently be ensured. When x, y and z are within the above-mentioned composition ranges, the cycle durability can be improved, and a good discharge capacity retention rate at the 100th cycle (for example, 50% or higher) can sufficiently be ensured.

In order to further improve the above-described characteristics of the Si alloy negative electrode active material, the alloy preferably satisfies the composition ranges of $23<x<64$, $2<y<65$ and $4\leq z<34$ corresponding to the area indicated by sign A in Fig. 6. Further, the alloy preferably satisfies the composition ranges of $23<x<44$, $0<y<43$ and $34<z<58$ corresponding to the area indicated by sign B in Fig. 6. Accordingly, the discharge capacity retention rate of 92% or higher at the 50th cycle and exceeding 55% at the 100th cycle can be obtained, as shown in Table 2. In order to further improve the cycle property, the alloy preferably satisfies the composition ranges of $23<x<64$, $27<y<61$ and $4<z<34$ corresponding to the area indicated by sign C in Fig. 7. Further, the alloy preferably satisfies the composition ranges of $3<x<34$, $8<y<43$ and $34<z<58$ corresponding to the area indicated by sign D in Fig. 7. Accordingly, the cycle property and durability can be improved, and the discharge capacity retention rate exceeding 65% at the 100th cycle can be obtained, as shown in Table 2.

The alloy more preferably satisfies the composition ranges of $23<x<58$, $38<y<61$ and $4<z<24$ corresponding to the area indicated by sign E in Fig. 8, the composition ranges of $23<x<38$, $27<y<53$ and $24\leq z<35$ corresponding to the area indicated by sign F in Fig. 8, the composition ranges of $23<x<38$, $27<y<44$ and $35<z<40$ corresponding to the area indicated by sign G in Fig. 8, or the composition ranges of $23<x<29$, $13<y<37$ and $40\leq z<58$ corresponding to the area indicated by sign H in Fig. 8. Accordingly, the cycle durability can be improved, and the discharge capacity retention rate exceeding 75% at the 100th cycle can be obtained, as shown in Table 2.

Here, a satisfies $0<a<0.5$, preferably $0<a<0.1$.

(Si Alloy Represented by $Si_xZn_yAl_zA_a$) - not belonging to the present invention

The composition $Si_xZn_yAl_zA_a$ obtained by selecting Zn as a first additive element and Al as a second additive element as described above can suppress the amorphous-crystal phase transition at the time of the alloying with Li so as to extend cycle life. Accordingly, the negative electrode active material thus obtained has a higher capacity than conventional negative electrode active materials such as carbon-based negative electrode active materials.

In the alloy composition described above, x, y and z preferably satisfy $21\leq x<100$, $0<y<79$, and $0<z<79$. The alloy having these composition ranges according to the present embodiment is obtained by selecting the first additive element Zn which suppresses amorphous-crystal phase transition at the time of the alloying with Li to extend cycle life and the second additive element Al which does not decrease the capacity of the electrode even when the concentration of the first additive element increases and by determining an appropriate composition ratio of these additive elements and the high-capacity element Si. The reason the amorphous-crystal phase transition should be suppressed at the time of the alloying with Li is that the function as an active material is lost by breakage of particles per se due to a large volumetric change (approximately 4 times) in the Si material which is caused by transition from an amorphous state to a crystal state when Si is alloyed with Li. In other words, the suppression of the amorphous-crystal phase transition can prevent breakage of the particles per se, secure the function as an active material (high capacity) and extend cycle life. By selecting the first and second additive elements as described above and determining the appropriate composition ratio of these additive elements and the high-capacity element SI, the Si alloy negative electrode active material having a high capacity and high cycle durability can be provided. In particular, when the composition ratio of the Si-Zn-Al alloy is within the ranges described above corresponding to the area surrounded by the thick solid line in Fig. 14 (inside the triangle), the Si-Zn-Al alloy can achieve a significantly high capacity which cannot be achieved by existing carbon-based negative electrode active materials. In addition, the Si-Zn-Al alloy can ensure a higher capacity (824 mAh/g or higher of an initial capacity) than existing Sn-based alloy negative electrode active materials. Further, the Si-Zn-Al alloy can achieve significantly high cycle durability, which generally has a trade-off relationship with a high capacity, as compared with the Sn-based alloy negative electrode active materials having a high capacity but poor cycle durability or the multi-component alloy negative electrode active materials described in Patent Document 1. In particular, the Si-Zn-Al alloy can achieve a high discharge capacity retention rate at the 50th cycle. Accordingly, the Si alloy negative electrode active material having good characteristics can be provided.

x, y and z preferably satisfy $26\leq x\leq 78$, $16\leq y\leq 69$, and $0<z\leq 51$. The Si alloy negative electrode active material having good characteristics can be provided when the composition ratio of Zn as a first additive element, Al as a second additive element and Si as a high capacity element is within the preferable ranges as specified above. In particular, when the composition ratio of the Si-Zn-Al alloy is within the area surrounded by the thick solid line in Fig. 15 (inside the hexagon in Fig. 15), the Si-Zn-Al alloy can achieve a significantly high capacity which cannot be achieved by the existing carbon-based negative electrode active materials. In addition, the Si-Zn-Al alloy can ensure a higher capacity (824 mAh/g or higher of an initial capacity) than the existing Sn-based alloy negative electrode active materials. Further, the Si-Zn-Al alloy can achieve significantly high cycle durability, which generally has a trade-off relationship with a high capacity, as compared with the Sn-based alloy negative electrode active materials having a high capacity but poor cycle durability or the multi-component alloy negative electrode active materials described in Patent Document 1. The composition ratio specified above corresponds to the composition ranges by which significantly high cycle durability could be achieved, selected among the composition ranges particularly achieving a high capacity in samples 1 to 35 in Reference Example C, as compared with the Sn-based alloy negative electrode active materials or the multi-component alloy negative electrode active materials described in Patent Document 1. In particular, the composition ratio corresponds to the selected composition ranges (indicated by the hexagon surrounded by the thick solid line in Fig. 15) by which 85% or higher of the discharge capacity retention rate at the 50th cycle could be achieved. Accordingly, the Si alloy negative electrode active material having well-balanced characteristics of the high capacity and the high cycle durability can be provided (refer to Table 3, and Fig. 15).

x, y and z preferably satisfy $26 \leq x \leq 66$, $16 \leq y \leq 69$, and $2 \leq z \leq 51$. Herewith can be provided the Si alloy negative electrode active material having particularly preferable characteristics when the composition ratio of Zn as a first additive element, Al as a second additive element and Si as a high capacity element is within the preferable ranges as specified above. In particular, when the composition ratio of the Si-Zn-Al alloy is within the area surrounded by the thick solid line in Fig. 16 (inside the small hexagon), the Si-Zn-Al alloy can also achieve a significantly high capacity which cannot be achieved by the existing carbon-based negative electrode active materials. In addition, the Si-Zn-Al alloy can ensure a higher capacity (1072 mAh/g or higher of an initial capacity) than the existing Sn-based alloy negative electrode active materials. Further, the Si-Zn-Al alloy can achieve significantly high cycle durability, which generally has a trade-off relationship with a high capacity, as compared with the Sn-based alloy negative electrode active materials having a high capacity but poor cycle durability or the multi-component alloy negative electrode active materials described in Patent Document 1. In particular, the Si-Zn-Al alloy can exhibit 90% or higher of the discharge capacity retention rate at the 50th cycle. The composition ratio specified above corresponds to the composition ranges (indicated by the hexagon surrounded by the thick solid line in Fig. 16) by which a preferable balance of a high capacity and high cycle durability could particularly be achieved, selected among the composition ranges of samples 1 to 35 in Reference Example C. Accordingly, the high-performance Si alloy negative electrode active material can be provided (refer to Table 3, and Fig. 16).

x, y and z particularly preferably satisfy $26 \leq x \leq 47$, $18 \leq y \leq 44$, and $22 \leq z \leq 46$. Herewith can be provided the Si alloy negative electrode active material having the most preferable characteristics when the composition ratio of Zn as a first additive element, Al as a second additive element and Si as a high capacity element is within the preferable ranges as specified above. In particular, when the composition ratio of the Si-Zn-Al alloy is within the area surrounded by the thick solid line in Fig. 17 (inside the smallest hexagon), the Si-Zn-Al alloy can also achieve a significantly high capacity which cannot be achieved by the existing carbon-based negative electrode active materials. In addition, the Si-Zn-Al alloy can ensure a higher capacity (1072 mAh/g or higher of an initial capacity) than the existing Sn-based alloy negative electrode active materials. Further, the Si-Zn-Al alloy can achieve significantly high cycle durability, which generally has a trade-off relationship with a high capacity, as compared with the Sn-based alloy negative electrode active materials having a high capacity but poor cycle durability or the multi-component alloy negative electrode active materials described in Patent Document 1. In particular, the Si-Zn-Al alloy can exhibit 95% or higher of the discharge capacity retention rate at the 50th cycle. The composition ratio specified above corresponds to the most preferable composition ranges (best mode) (indicated by the smallest hexagon surrounded by the thick solid line in Fig. 17) by which the best balance of a much higher capacity and much higher cycle durability could particularly be achieved, selected among the composition ranges of samples 1 to 35 in Reference Example C. Accordingly, the significantly high-performance Si alloy negative electrode active material can be provided (refer to Table 3, and Fig. 17). In contrast, a binary alloy not containing one of the metal additive elements to be added to the high-capacity element Si in the ternary alloy represented by the composition formula $Si_xZn_yAl_zA_a$ (that is, Si-Al alloy with y=0 or Si-Zn alloy with z=0) or a single substance of Si cannot keep a high cycle property, particularly a high discharge capacity retention rate at the 50th cycle, which leads to a rapid decrease (deterioration) in cycle performance. Thus, the well-balanced characteristics of the high capacity and the high cycle durability cannot be achieved.

More particularly, the Si-Zn-Al series alloy negative electrode active material described above in a newly-produced state (non-charged state) is a ternary amorphous alloy represented by $Si_xZn_yAl_zA_a$ having the above-described appropriate composition ratio. The lithium ion secondary battery using the Si-Zn-Al series alloy negative electrode active material has the remarkable effect of suppressing a large volumetric change which is caused by transition from an amorphous state to a crystal state when Si is alloyed with Li due to charge and discharge. Since other ternary alloys represented by $Si_xM_yAl_z$ or quaternary alloys described in Patent Document 1 cannot keep a high cycle property, especially a high discharge capacity retention rate at the 50th cycle, a critical problem of a rapid decrease (deterioration) in cycle performance occurs. More specifically, the ternary and quaternary alloys described in Patent Document 1 have a significantly higher initial capacity (discharge capacity at the 1 st cycle) than the existing carbon-based negative electrode active materials (theoretical capacity: 372 mAh/g) and also have a high capacity as compared with the Sn-based negative electrode active materials (theoretical capacity: approximately 600 to 700 mAh/g). However, the cycle property of these alloys is poor and insufficient as compared with the cycle property, particularly the discharge capacity retention rate at the 50th cycle (approximately 60%) of the Sn-based negative electrode active materials which have the capacity as high as approximately 600 to 700 mAh/g. In other words, these alloys cannot achieve a good balance of a high capacity and high cycle durability which have a trade-off relationship therebetween so as not to satisfy the practical use. In particular, although the quaternary alloy $Si_{62}Al_{18}Fe_{16}Zr_4$ described in Example 1 of Patent Document 1 has a high initial capacity of approximately 1150 mAh/g, the circulation capacity only after 5 to 6 cycles is approximately as low as 1090 mAh/g, as is apparent from Fig. 2. In other words, it is apparent from Example 1 of Patent Document 1 that the discharge capacity retention rate is largely reduced to approximately 95% at the 5th or 6th cycle, and that the discharge capacity retention rate is reduced by substantially 1% per cycle, as shown in Fig. 2. It is assumed that the discharge capacity retention rate is reduced by approximately 50% at the 50th cycle (that is, the discharge capacity retention rate is reduced to approximately 50%). Similarly, although the ternary alloy $Si_{55}Al_{29.3}Fe_{15.7}$ described in Example 2 of Patent Document 1 has a high initial capacity of approximately 1430 mAh/g, the circulation capacity only after 5 to 6 cycles is largely reduced to approximately 1300 mAh/g, as is apparent from Fig. 4. In other words, it is apparent from Example 2 of Patent Document 1 that the discharge capacity retention rate is rapidly reduced to approximately 90% at the 5th or 6th cycle, and that the discharge capacity retention rate is reduced by substantially 2% per cycle, as shown in Fig. 4. It is assumed that the discharge capacity retention rate is reduced by approximately 100% at the 50th cycle (that is, the discharge capacity retention rate is reduced to approximately 0%). Although Patent Document 1 does not mention the initial capacity of each of the quaternary alloy $Si_{60}Al_{20}Fe_{12}Ti_8$ in Example 3 and the quaternary alloy $Si_{62}Al_{16}Fe_{14}Ti_8$ in Example 4, it is apparent from Table 2 that the circulation capacity only after 5 to 6 cycles is reduced to as low as 700 to 1200 mAh/g. The discharge capacity retention rate at the 5th or 6th cycle in Example 3 of Patent Document 1 is equal to or less than those in Examples 1 and 2, and it is assumed that the discharge capacity retention rate at the 50th cycle is approximately reduced by 50% to 100% (that is, the discharge capacity retention rate is reduced to approximately 50% to 0%). Here, since the alloy compositions described in Patent Document 1 are indicated by the atomic ratio, it is recognized that the alloy composition including Fe as a first additive element with the content of approximately 20% by mass is disclosed in Examples when the atomic ratio is converted into the mass ratio.

Accordingly, since the batteries using the existing ternary and quaternary alloys described in Patent Document 1 have the problem of reliability and safety due to the cycle property not sufficient to satisfy, for example, vehicle usage on the practical level in the field where cycle durability is strongly demanded, it is difficult to put such batteries into practical use. On the other hand, the negative electrode active material using the ternary alloy represented by $Si_xZn_yAl_zA_a$ having the above-described appropriate composition ratio has a high cycle property, namely, a high discharge capacity retention rate at 50th cycle (refer to Fig. 13). Further, since the initial capacity (the discharge capacity at the 1st cycle) is significantly higher than that of the existing carbon-based negative electrode active materials, and is also higher than that of the existing Sn-based negative electrode active materials (refer to Fig. 12), the negative electrode active material exhibiting well-balanced characteristics can be provided. That is, it was found out that the negative electrode active martial including the alloy capable of exhibiting a high-level and well-balanced capacity and cycle durability concurrently could be obtained, which could not be achieved by the existing carbon-based and Sn-based negative electrode active materials or the ternary and quaternary alloys described in Patent Document 1 because of a trade-off relationship between a high capacity and high cycle durability. More particularly, it was found out that the expected object can be achieved by selecting the two elements Zn and Al from the group consisting of one or more additive elements having considerably various combinations and by determining the predetermined composition ratio (the composition ranges) of these additive elements and the high-capacity element Si. As a result, a lithium ion secondary battery having a high capacity and good cycle durability can be provided.

The Si-Zn-Al series alloy negative electrode active material is explained in more detail below.

(1) Total Mass Percent Value of Alloy

The Si-Zn-Al series alloy is represented by the composition formula $Si_xZn_yAl_zA_a$. In the formula, A is inevitable impurities. In addition, x, y, z and a represent mass percent values and satisfy the conditions of $0<x<100$, $0<y<100$, $0<z<100$, $0\leq a<0.5$, and $x+y+z+a=100$. The total mass percent value of the alloy having the composition formula $Si_xZn_yAl_zA_a$ is: $x+y+z+a=100$. That is, the negative electrode active material is required to contain the Si-Zn-Al series ternary alloy. In other words, the negative electrode active material does not contain a binary alloy, a ternary alloy having a different composition, a quaternary or multi-component alloy to which other metals are added. It should be noted that, as described above, the inevitable impurities A may be contained within the range of $0\leq a<0.5$. Here, the negative electrode active material layer 15 accordingly it is only required to contain at least one alloy having the composition formula $Si_xZn_yAl_zA_a$, and may contain two or more alloys of this type having different composition ratios together. In addition, other negative electrode active materials such as carbon-based materials may be used together as long as those materials do not impair the effectsdescribed herein.

(2) Mass Percent Value of Si in Alloy

The mass percent value of x for Si in the alloy having the composition formula $Si_xZn_yAl_zA_a$ preferably satisfies $21\leq x<100$, more preferably $26\leq x\leq 78$, still more preferably $26\leq x\leq 66$, particularly preferably $26\leq x\leq 47$ (refer to Table 3, and Fig. 14 to Fig. 17). As the mass percent value of the high-capacity element Si (the value of x) in the alloy is higher, a higher capacity can be ensured. In addition, the preferable range $21\leq x\leq 100$ can achieve a significantly high capacity (824 mAh/g or higher) which cannot be achieved by the existing carbon-based negative electrode active materials. Such a range can also enable the alloy to have a higher capacity than the existing Si-based negative electrode active materials (refer to Fig. 14). Further, the range $21\leq x<100$ can ensure a high discharge capacity retention rate (cycle durability) at the 50th cycle.

The mass percent value of the high-capacity element Si (the value of x) in the alloy more preferably satisfies $26\leq x\leq 78$ in order to provide the negative electrode active material with well-balanced characteristics to exhibit the high initial capacity and keep the high cycle property (particularly, the high discharge capacity retention rate at the 50th cycle). In addition, when the composition ratio of Zn as a first additive element to Al as a second additive element is within an appropriate range as described below, the Si alloy negative electrode active material exhibiting good characteristics (well-balanced characteristics of a high capacity and high cycle durability, which have a trade-off relationship in the existing alloy negative electrode active materials) can be provided. In other words, the range $26\leq x\leq 78$ is preferable because the alloy having this range not only can deal with the problem that the capacity increases as the mass percent value of the high-capacity element Si (the value of x) in the alloy increases but at the same time the cycle durability tends to decrease, but also can keep the high capacity (1072 mAh/g or higher) and the high discharge capacity retention rate (87% or higher) concurrently (refer to Table 3, and Fig. 15).

The mass percent value of the high-capacity element Si (the value of x) in the alloy still more preferably satisfies $26\leq x\leq 66$ in order to provide the negative electrode active material having well-balanced characteristics to exhibit the high initial capacity and keep the higher cycle property (the higher discharge capacity retention rate). In addition, when the composition ratio of Zn as a first additive element to Al as a second additive element is within a more preferable range as described below, the Si alloy negative electrode active material exhibiting better characteristics can be provided (refer to Table 3, and the area surrounded by the thick solid line in Fig. 16). In other words, this preferable range $26\leq x\leq 66$ has the advantage of keeping the high capacity (1072 mAh/g or higher) and the higher discharge capacity retention rate (90% or higher) at the 50th cycle concurrently (refer to Table 3, and the area surrounded by the thick solid line in Fig. 16).

The mass percent value of the high-capacity element Si (the value of x) in the alloy particularly preferably satisfies $26\leq x\leq 47$ in order to provide the negative electrode active material having well-balanced characteristics to exhibit the high initial capacity and keep the significantly high cycle property (the significantly high discharge capacity retention rate). In addition, when the composition ratio of Zn as a first additive element to Al as a second additive element is within a still more preferable range as described below, the Si alloy negative electrode active material exhibiting the most preferable characteristics can be provided (refer to Table 3, and the area surrounded by the thick solid line in Fig. 17). In other words, this particularly preferable range $26\leq x\leq 47$ has the remarkable advantage of keeping the higher capacity (1072 mAh/g or higher) and the significantly high discharge capacity retention rate (95% or higher) at the 50th cycle concurrently (refer to Table 3, and the area surrounded by the thick solid line in Fig. 17). In contrast, a binary alloy not containing one of the metal additive elements (Zn, Al) to be added to the high-capacity element Si in the ternary alloy represented by the composition formula $Si_xZn_yAl_zA_a$ (that is, Si-Al alloy with y=0 or Si-Zn alloy with z=0) cannot keep the cycle property at a high level. In particular, the binary alloy cannot sufficiently keep the high discharge capacity retention rate at the 50th cycle, which leads to a rapid decrease (deterioration) in cycle performance. Thus, the well-balanced characteristics of the high initial capacity and the significantly high discharge capacity retention rate at the 50th cycle cannot be achieved. Further, in the case of x=100 (in the case of pure Si to which neither of the additive elements Zn, Al is added), it is difficult to ensure higher cycle durability while exhibiting a high capacity because the capacity and the cycle durability have a trade-off relationship. That is, a negative electrode active material only containing Si as a high-capacity element has the highest capacity but remarkably deteriorates due to an expansion-contraction phenomenon of Si in association with charge and discharge. As a result, the worst and quite poor discharge capacity retention rate is merely obtained. Thus, the well-balanced characteristics of the high initial capacity and the significantly high discharge capacity retention rate at the 50th cycle cannot be achieved.

Here, when the value of x satisfies $x\geq 26$, the content ratio (the balance) of the Si material having the initial capacity as high as 3200 mAh/g, the first additive element Zn and the second additive element Al corresponds to the appropriate composition ranges (refer to the areas surrounded by the thick solid lines in Fig. 15 to Fig. 17). The content ratio corresponding to the appropriate ranges has the advantage of achieving the most preferable characteristics and keeping the high capacity on the vehicle usage level stably and safely for a long period of time. In addition, when the value of x satisfies $x\leq 78$, preferably $x\leq 66$, particularly preferably $x\leq 47$, the content ratio (the balance) of the Si material having the initial capacity as high as 3200 mAh/g, the first additive element Zn and the second additive element Al corresponds to the appropriate composition ranges (refer to the areas surrounded by the thick solid lines in Fig. 15 to Fig. 17). The content ratio corresponding to the appropriate ranges has the advantage of significantly suppressing amorphous-crystal phase transition when Si is alloyed with Li so as to greatly extend the cycle life. That is, 85% or higher, preferably 90% or higher, particularly preferably 95% or higher of the discharge capacity retention rate at the 50th cycle can be achieved. It should be noted that the value of x deviating from the above-described appropriate range ($26\leq x\leq 78$,

preferably $26 \leq x \leq 66$, particularly preferably $26 \leq x \leq 47$) can, of course, be encompassed as long as it can effectively exhibit the effects described above.

As described above, the alloys disclosed in the examples of Patent Document 1 have a cycle property that deteriorates only after 5 or 6 cycles due to the significant decrease of the capacity. In particular, the discharge capacity retention rate is largely reduced to 90% to 95% at the 5th or 6th cycle, and reduced to approximately 50% to 0% at the 50th cycle in the examples described in Patent Document 1. On the other hand, herein selected is the combination of the first additive element Zn and the second additive element Al (only one combination), which have a mutually complementing relationship, added to the high-capacity Si material through a great deal of trial and error and extreme experiments using a variety of combinations of different elements (metal or nonmetal). The selected combination and the high-capacity Si material having the content within the above-described range have the advantage of achieving the higher capacity and suppressing a significant decrease of the discharge capacity retention rate at the 50th cycle. In other words, the remarkable combined effects derived from the appropriate composition ranges of the first additive element Zn and the second additive element Al having the mutually complementing relationship with Zn can suppress transition from an amorphous state to a crystal state when Si is alloyed with Li so as to prevent a large volumetric change. Further, such a combination also has the advantage of exhibiting the high capacity and improving the cycle durability of the electrode concurrently (refer to Table 3, and Fig. 15 to Fig. 17).

(3) Mass Percent Value of Zn in Alloy

The mass percent value of y for Zn in the alloy having the composition formula $Si_xZn_yAl_zA_a$ preferably satisfies $0<y<79$, more preferably $16 \leq y \leq 69$, particularly preferably $18 \leq y \leq 44$. When the mass percent value of the first additive element Zn (the value of y) in the alloy satisfies the preferable range $0<y<79$, amorphous-crystal phase transition of the high-capacity Si material can be suppressed effectively due to the characteristics of Zn (in addition to the combined effects with Al). Accordingly, the significant effects on the cycle life (cycle durability), particularly the high discharge capacity retention rate (85% or higher, preferably 90% or higher, particularly preferably 95% or higher) at the 50th cycle can be achieved (refer to Fig. 15 to Fig. 17). In addition, the value of x as the content of the high-capacity Si material can be kept at a constant level or higher ($21 \leq x<100$) so as to achieve a significantly high capacity which cannot be achieved by the existing carbon-based negative electrode active materials. Further, the alloy having a higher capacity (an initial capacity of 824 mAh/g or higher, preferably 1072 mAh/g or higher) than the existing Sn-based alloy negative electrode active materials can be obtained (refer to Table 3, and Fig. 15 to Fig. 17).

The mass percent value of the first additive element Zn (the value of y) in the alloy more preferably satisfies $16 \leq y \leq 69$ in order to provide the negative electrode active material with well-balanced characteristics to exhibit the high initial capacity and keep the high cycle property (particularly, the high discharge capacity retention rate at the 50th cycle). When the first additive element Zn having the effect of suppressing amorphous-crystal phase transition at the time of the alloying with Li so as to extend cycle life is contained in the appropriate ratio, the Si alloy negative electrode active material having good characteristics can be provided (refer to Table 3, and the composition ranges surrounded by the thick solid lines in Fig. 15 and Fig. 16). Thus, the mass percent value of the first additive element Zn (the value of y) in the alloy satisfying the more preferable range $16 \leq y \leq 69$ has the advantage of effectively suppressing amorphous-crystal phase transition at the time of the alloying so as to extend cycle life, and further keeping the high discharge capacity retention rate (85% or higher, preferably 90% or higher) at the 50th cycle (refer to Table 3, and Fig. 15 and Fig. 16). The mass percent value is included in the selected composition ranges (particularly, $16 \leq y \leq 69$ for the Zn content) (indicated by the hexagon surrounded by the thick solid lines in Fig. 15 and Fig. 16) by which the higher capacity could particularly be achieved in samples 1 to 35 in Reference Example C. The selected composition ranges, particularly $16 \leq y \leq 69$ for the Zn content, can provide the Si alloy negative electrode active material achieving the significantly good cycle durability (85% or higher, preferably 90% or higher of the discharge capacity retention rate) as compared with the existing Sn-based alloy negative electrode active materials or the multi-component alloy negative electrode active materials described in Patent Document 1 (refer to Table 3, and Fig. 15 and Fig. 16).

The mass percent value of the first additive element Zn (the value of y) in the alloy particularly preferably satisfies $18 \leq y \leq 44$ in order to provide the negative electrode active material with well-balanced characteristics to exhibit the high initial capacity and keep the higher cycle property (the high discharge capacity retention rate at the 50th cycle). When the first additive element Zn having the effect of suppressing amorphous-crystal phase transition at the time of the alloying with Li so as to extend cycle life is contained in the particularly appropriate ratio, the Si alloy negative electrode active material having the most preferable characteristics can be provided (refer to Table 3, and Fig. 17). Thus, the mass percent value satisfying the particularly preferable range $18 \leq y \leq 44$ has the advantage of effectively suppressing amorphous-crystal phase transition at the time of the alloying so as to extend cycle life, and further keeping the discharge capacity retention rate of 95% or higher at the 50th cycle (refer to Table 3, and Fig. 17). The mass percent value is included in the composition ranges (particularly, $18 \leq y \leq 44$ for the Zn content) (indicated by the smallest hexagon surrounded by the thick solid line in Fig. 17), selected among samples 1 to 35 in Reference Example C, by which the much higher capacity and the discharge capacity retention rate of 95% or higher at the 50th cycle could particularly be achieved. The selected composition ranges, particularly 18≤y≤44 for the Zn content, can provide the Si alloy negative electrode active material achieving the high capacity and the significantly good cycle durability (the much higher discharge capacity retention rate) as compared with the existing Sn-based alloy negative electrode active materials or the multi-component alloy negative electrode active materials described in Patent Document 1. In contrast, a binary alloy (particularly Si-Al alloy with y=0) not containing one of the metal additive elements (Zn, Al) to be added to Si in the ternary alloy represented by the composition formula $Si_xZn_yAl_zA_a$ cannot keep the cycle property at a high level. In particular, the binary alloy cannot sufficiently keep the high discharge capacity retention rate at the 50th cycle, which leads to a rapid decrease (deterioration) in cycle performance. Thus, the particularly well-balanced characteristics of the high capacity and the good cycle durability (the significantly high discharge capacity retention rate at the 50th cycle) cannot be achieved.

Here, when the value of y satisfies y≥16, preferably y≥18, the content ratio (the balance) of the high-capacity Si material having the initial capacity as high as 3200 mAh/g and the first additive element Zn (and the remaining second additive element Al) corresponds to the appropriate composition ranges (refer to the areas surrounded by the thick solid lines in Fig. 15 to Fig. 17). In such a case, amorphous-crystal phase transition of the Si material can be suppressed effectively due to the effect of Zn (and the combined effects with Al), and the cycle life (particularly, the discharge capacity retention rate) can be extended remarkably. That is, 85% or higher, preferably 90% or higher, particularly preferably 95% or higher of the discharge capacity retention rate at the 50th cycle can be achieved. Thus, the negative electrode active material (the negative electrode) having the preferable content ratio has the advantage of achieving the most preferable characteristics and keeping the high capacity on the vehicle usage level stably and safely for a long period of time. In addition, when the value of y satisfies y≤69, preferably y≤44, the content ratio (the balance) of the high-capacity Si material having the initial capacity as high as 3200 mAh/g and the first additive element Zn (and the remaining second additive element Al) corresponds to the appropriate composition ranges (refer to the areas surrounded by the thick solid lines in Fig. 15 to Fig. 17). In such a case, amorphous-crystal phase transition can be effectively suppressed when Si is alloyed with Li, and the cycle life can be extended remarkably. That is, 85% or higher, preferably 90% or higher, particularly preferably 95% or higher of the discharge capacity retention rate at the 50th cycle can be achieved. It should be noted that the value of y deviating from the above-described appropriate range (16≤y≤69, particularly preferably 18≤y≤44) can, of course, be encompassed as long as it can effectively exhibit the effects described above.

As described above, the alloys disclosed in the examples of Patent Document 1 have a cycle property that deteriorates only after 5 or 6 cycles due to the significant decrease of the capacity. In particular, the discharge capacity retention rate is largely reduced to 90% to 95% at the 5th or 6th cycle, and reduced to approximately 50% to 0% at the 50th cycle in the examples described in Patent Document 1. On the other hand, herein selected is the first additive element Zn (and the combination with the second additive element Al which has the mutually complementing relationship with Zn) (only one combination) added to the high-capacity Si material through a great deal of trial and error and extreme experiments using a variety of combinations of different elements (metal or nonmetal). The selected combination in which Zn is contained within the above-described appropriate range has the advantage of suppressing a significant decrease of the discharge capacity retention rate at the 50th cycle. In other words, the remarkable combined effects derived from the appropriate composition range of the first additive element Zn (and the second additive element Al having the mutually complementing relationship with Zn) can suppress transition from an amorphous state to a crystal state when Si is alloyed with Li so as to prevent a large volumetric change. Further, the appropriate composition range also has the advantage of exhibiting the high capacity and improving the cycle durability of the electrode concurrently (refer to Table 3, and Fig. 15 to Fig. 17).

(4) Mass Percent Value of Al in Alloy

The mass percent value of z for Al in the alloy having the composition formula $Si_xZn_yAl_zA_a$ preferably satisfies 0<z<79, more preferably 0<z≤51, still more preferably 2≤z≤51, particularly preferably 22≤z≤46. When the mass percent value of the second additive element Al (the value of z), which does not decrease the capacity of the electrode even when a concentration of the first additive element in the alloy increases, satisfies the preferable range 0<z<79, amorphous-crystal phase transition of the high-capacity Si material can be effectively suppressed due to the characteristics of Zn and the combined effects with Al. Accordingly, the significant effects on the cycle life (cycle durability), particularly the high discharge capacity retention rate (85% or higher, preferably 90% or higher, particularly preferably 95% or higher) at the 50th cycle can be achieved (refer to Fig. 15 to Fig. 17). In addition, the content of x for the high-capacity Si material can be kept at a constant level or higher (21≤x<100) so as to achieve a significantly high capacity which cannot be achieved by the existing carbon-based negative electrode active materials. Further, the alloy having a higher capacity (an initial capacity of 824 mAh/g or higher, preferably 1072 mAh/g or higher) than the existing Sn-based alloy negative electrode active materials can be obtained (refer to Table 3, and Fig. 14 to Fig. 17).

The mass percent value of the second additive element Al (the value of z) in the alloy more preferably satisfies 0<z≤51 in order to provide the negative electrode active material with well-balanced characteristics to exhibit the high initial capacity and keep the high cycle property (particularly, the high discharge capacity retention rate at the 50th cycle). Selecting both the first additive element Zn which suppresses amorphous-crystal phase transition at the time of the alloying with Li to extend cycle life and the second additive element Al which does not decrease the capacity of the negative electrode active material (the negative electrode) even when the concentration of the first additive element in the alloy increases, is considerably important and useful. It was found out that the first and second additive elements considerably differ in the effects from the known ternary alloys, quaternary and multi-element alloys as described in Patent Document 1 and binary alloys such as a Si-Zn alloy and a Si-Al alloy. When the second additive element Al (and the first additive element Zn having the mutually complementing relationship with Al) is contained in the appropriate ratio, the Si alloy negative electrode active material having good characteristics can be provided (refer to Table 3, and the composition ranges surrounded by the thick solid line in Fig. 15). Thus, the mass percent value of the second additive element Al (the value of z) in the alloy satisfying the more preferable range $0<z\leq51$ has the advantage of effectively suppressing amorphous-crystal phase transition at the time of the alloying so as to extend cycle life. As a result, a high discharge capacity retention rate (85% or higher) at the 50th cycle can be ensured (refer to Table 3, and Fig. 15). The mass percent value is included in the selected composition ranges (particularly, $0<z\leq51$ for the Zn content) (indicated by the hexagon surrounded by the thick solid line in Fig. 15) by which the higher capacity could particularly be achieved in samples 1 to 35 in Reference Example C. The selected composition ranges, particularly $0<z\leq51$ for the Zn content, can exhibit the significantly good cycle durability due to the combined effects (the mutually complementing relationship) with the first additive element Zn, as compared with the existing Sn-based alloy negative electrode active materials or the multi-component alloy negative electrode active materials described in Patent Document 1. Accordingly, the Si alloy negative electrode active material achieving 85% or higher of the discharge capacity retention rate at the 50th cycle can be provided (refer to Table 3, and the composition ranges surrounded by the thick solid line in Fig. 15).

The mass percent value of the second additive element Al (the value of z) in the alloy still more preferably satisfies $2\leq z\leq51$ in order to provide the negative electrode active material with well-balanced characteristics to exhibit the high initial capacity and keep the higher cycle property (the high discharge capacity retention rate at the 50th cycle). When the second additive element Al capable of suppressing amorphous-crystal phase transition at the time of the alloying with Li so as to extend cycle life due to the combined effects (the mutually complementing relationship) with Zn, is contained in the more appropriate ratio, the Si alloy negative electrode active material having better characteristics can be provided. Thus, the mass percent value satisfying the still more preferable range $2\leq z\leq51$ has the advantage of effectively suppressing amorphous-crystal phase transition at the time of the alloying so as to extend cycle life due to the combined effects (the mutually complementing relationship) with Zn. As a result, 90% or higher of the high discharge capacity retention rate at the 50th cycle can be ensured (refer to Table 3, and Fig. 16). The mass percent value is included in the composition ranges (particularly, $2\leq z\leq51$ for the Al content) (indicated by the small hexagon surrounded by the thick solid line in Fig. 16), selected among samples 1 to 35 in Reference Example C, by which the higher capacity and the discharge capacity retention rate of 90% or higher at the 50th cycle could particularly be achieved. The selected composition ranges, particularly $2\leq z\leq51$ for the Al content, can provide the Si alloy negative electrode active material having well-balanced characteristics of the high capacity due to the combined effects with Zn and the significantly good cycle durability as compared with the existing Sn-based alloy negative electrode active materials or the multi-component alloy negative electrode active materials described in Patent Document 1.

The mass percent value of the second additive element Al (the value of z) in the alloy particularly preferably satisfies $22\leq z\leq46$ in order to provide the negative electrode active material with well-balanced characteristics to exhibit the high initial capacity and keep the higher cycle property (the high discharge capacity retention rate at the 50th cycle). When the second additive element Zn capable of suppressing amorphous-crystal phase transition at the time of the alloying with Li so as to extend cycle life due to the combined effects (the mutually complementing relationship) with Zn, is contained in the particularly appropriate ratio, the Si alloy negative electrode active material having the most preferable characteristics can be provided. Thus, the mass percent value satisfying the most preferable range $22\leq z\leq46$ has the advantage of effectively suppressing amorphous-crystal phase transition at the time of the alloying so as to extend cycle life due to the combined effects (the mutually complementing relationship) with Zn. As a result, 95% or higher of the high discharge capacity retention rate at the 50th cycle can be ensured (refer to Table 3, and Fig. 17). The mass percent value is included in the composition ranges (particularly, $22\leq z\leq46$ for the Al content) (indicated by the smallest hexagon surrounded by the thick solid line in Fig. 17), selected among samples 1 to 35 in Reference Example C, by which the much higher capacity and the discharge capacity retention rate of 95% or higher at the 50th cycle could particularly be achieved. The selected composition ranges, particularly $22\leq z\leq46$ for the Al content, can provide the Si alloy negative electrode active material having particularly well-balanced characteristics of the high capacity due to the combined effects with Zn and the significantly good cycle durability as compared with the existing Sn-based alloy negative electrode active materials or the multi-component alloy negative electrode active materials described in Patent Document 1. In contrast, a binary alloy (particularly Si-Zn alloy with z=0) not containing one of the metal additive elements (Zn, Al) to be added to Si in the ternary alloy represented by the composition formula $Si_xZn_yAl_zA_a$ cannot keep the cycle property at a high level. In particular, the binary alloy cannot sufficiently keep the high discharge capacity retention rate at the 50th cycle, which leads to a rapid decrease (deterioration) in cycle performance. Thus, the particularly well-balanced characteristics of the high capacity and the good cycle durability (the significantly high discharge capacity retention rate at the 50th cycle) cannot be achieved.

Here, when the value of z satisfies z≥2, preferably z≥22, the content ratio (the balance) of the high-capacity Si material having the initial capacity as high as 3200 mAh/g, the first additive element Zn and the second additive element Al corresponds to the appropriate composition ranges (refer to the areas surrounded by the thick solid lines in Fig. 16 and Fig. 17). In such a case, the characteristics of Al can be exhibited in which a decrease of the capacity of the negative electrode active material (the negative electrode) can be effectively prevented even when the concentration of Zn capable of suppressing amorphous-crystal phase transition increases, so as to remarkably extend the cycle life (particularly, the discharge capacity retention rate). That is, 90% or higher, preferably 95% or higher of the discharge capacity retention rate at the 50th cycle can be ensured. Thus, the negative electrode active material (the negative electrode) having the preferable content ratio has the advantage of achieving the most preferable characteristics and keeping the high capacity on the vehicle usage level stably and safely for a long period of time. In addition, when the value of z satisfies z≤51, preferably z≤46, the content ratio (the balance) of the high-capacity Si material having the initial capacity as high as 3200 mAh/g, the first additive element Zn and the second additive element Al corresponds to the appropriate composition ranges (refer to the areas surrounded by the thick solid lines in Fig. 15 to Fig. 17). In such a case, amorphous-crystal phase transition can be effectively suppressed when Si is alloyed with Li, and the cycle life (particularly, the discharge capacity retention rate at the 50th cycle) can be extended remarkably. That is, 85% or higher, preferably 90% or higher, particularly preferably 95% or higher of the discharge capacity retention rate at the 50th cycle can be ensured. It should be noted that the value of z deviating from the above-described appropriate range (2≤z≤51, preferably 22≤z≤46) can, of course, be encompassed as long as it can effectively exhibit the effects described above.

As described above, the alloys disclosed in the examples of Patent Document 1 have a cycle property that deteriorates only after 5 or 6 cycles due to the significant decrease of the capacity. In particular, the discharge capacity retention rate is largely reduced to 90% to 95% at the 5th or 6th cycle, and reduced to approximately 50% to 0% at the 50th cycle in the examples disclosed in Patent Document 1. On the other hand, here it has been selected the combination of the first additive element Zn and the second additive element Al, which have the mutually complementing relationship, added to the high-capacity Si material through a great deal of trial and error and extreme experiments using a variety of combinations of different elements (metal or nonmetal). The selected combination in which Al is contained within the above-described appropriate range has the advantage of suppressing a significant decrease of the discharge capacity retention rate at the 50th cycle. In other words, the remarkable combined effects derived from the appropriate composition range of the second additive element Al (and the first additive element Zn having the mutually complementing relationship with Al) can suppress transition from an amorphous state to a crystal state when Si is alloyed with Li so as to prevent a large volumetric change. Further, the appropriate composition range also has the advantage of exhibiting the high capacity and improving the cycle durability of the electrode concurrently.

(5) Mass Percent Value of A in Alloy

The mass percent value of a for A in the alloy having the composition formula $Si_xZn_yAl_zA_a$ satisfies 0≤a<0.5, preferably 0≤a<0.1. As described above, A in the Si alloy is derived from the raw materials or inevitably mixed in the production process, and is essentially unnecessary but permissible substances, since the amount thereof is quite small and there is no influence on the characteristics of the Si alloy.

(Si Alloy Represented by $Si_xZn_yC_zA_a$)

The composition $Si_xZn_yC_zA_a$ obtained by selecting Zn as a first additive element and C as a second additive element as described above can suppress the amorphous-crystal phase transition at the time of the alloying with Li so as to extend cycle life. Accordingly, the negative electrode active material thus obtained has a higher capacity than conventional negative electrode active materials such as carbon-based negative electrode active materials.

In the alloy composition described above, x is preferably greater than 25 and less than 54, y is preferably greater than 13 and less than 69, and z is preferably greater than 1 and less than 47. These numerical ranges correspond to the area indicated by sign A in Fig. 20. This Si alloy negative electrode active material is used for a negative electrode for an electric device, for example, a negative electrode for a lithium ion secondary battery. The alloy contained in the negative electrode active material absorbs lithium ions at the time of charge of the battery and releases the lithium ions at the time of discharge.

More particularly, the negative electrode active material described above, which is the Si alloy negative electrode active material, contains zinc (Zn) as a first additive element and carbon (C) as a second additive element. The appropriately selected combination of the first additive element Zn and the second additive element C can suppress the amorphous-crystal phase transition at the time of the alloying with Li so as to extend cycle life. Accordingly, the negative electrode active material thus obtained has a higher capacity than carbon-based negative electrode active materials. Further, the first and second additive elements Zn and C having the optimized composition ranges can provide the Si (Si-Zn-C series) alloy negative electrode active material exhibiting good cycle life after 50 cycles. The Si (Si-Zn-C series) alloy negative electrode active material can exhibit a high capacity and high cycle durability and further exhibit high charge-discharge efficiency in the initial stage.

When the negative electrode active material contains the Si-Zn-C series alloy in which x is greater than 25, a sufficient discharge capacity at the 1 st cycle can be achieved. Further, when x is less than 54, a good cycle property can be ensured as compared with the conventional case of using pure Si. When y is greater than 13, a good cycle property can be ensured as compared with the conventional case of using pure Si. Further, when y is less than 69, a decrease of the content of Si can be suppressed, and a decrease of the initial capacity can be suppressed effectively as compared with existing pure Si negative electrode active materials and accordingly, a high capacity and high charge-discharge efficiency can be ensured in the initial stage. When z is greater than 1, a good cycle property can be ensured as compared with the conventional case of using pure Si. Further, when z is less than 47, a decrease of the content of Si can be suppressed, and a decrease of the initial capacity can be suppressed effectively as compared with the existing pure Si negative electrode active materials and accordingly, a high capacity and high charge-discharge efficiency can be ensured in the initial stage.

In order to further improve the above-described characteristics of the Si alloy negative electrode active material, z is preferably greater than 1 and less than 34, as indicated by sign B in Fig. 21. In addition, y is preferably greater than 17 and less than 69.

Here, a satisfies $0 \leq a < 0.5$, preferably $0 \leq a < 0.1$.

(Average Particle Diameter of Si Alloy)

An average particle diameter of the Si alloy is not particularly limited as long as it is substantially identical to that of the negative electrode active material contained in the existing negative electrode active material layer 15. The average particle diameter may be preferably in the range from 1 μm to 20 μm in view of higher output power. However, the average particle diameter is not limited to this range and can, of course, deviate therefrom as long as the effects of the present embodiment can effectively be exhibited. The shape of the Si alloy is not particularly limited and may be a spherical shape, an elliptical shape, a cylindrical shape, a polygonal prism shape, a scale shape or an unfixed shape.

(Method for Producing Alloy)

A method for producing the alloy represented by the composition formula $Si_xZn_yM_zA_a$ according to the present embodiment is not particularly limited, and several kinds of known methods may be used for the production of the alloy. Namely, a variety of production methods may be used because there is little difference in the conditions and characteristics of the alloy produced by the production methods.

Examples of the method for producing the alloy in a particle state having the composition formula $Si_xZn_yM_zA_a$ include a mechanical alloying method and an arc plasma melting method.

According to the methods for producing the alloy in a particle state, a binder, a conductive auxiliary agent and a viscosity control solvent may be added to the particles to prepare slurry, so as to form a slurry electrode by use of the slurry thus obtained. These producing methods are superior in terms of mass production and practicality for actual battery electrodes.

<Negative Electrode Current Collector>

The negative electrode current collector 12 is made from an electrically conductive material. The size of the current collector may be determined depending on the intended use of the battery. For example, a current collector having a large area is used for a large-size battery for which high energy density is required.

The shape of the current collector is not particularly limited. The laminated battery 10 shown in Fig. 1 may use a current collecting foil or a mesh current collector (such as an expanded grid). According to the present embodiment, a current collecting foil is preferably used.

The material used for the current collector is not particularly limited. For example, a metal or resin in which electrically conductive filler is added to an electrically conductive polymer material or a non-conductive polymer material may be used.

Examples of the metal include copper, aluminum, nickel, iron, stainless steel, titanium, and an alloy thereof. In addition, a clad metal of nickel and aluminum, a clad metal of copper and aluminum, or an alloyed material of these metals combined together, may be used. A foil in which a metal surface is covered with aluminum may also be used. In particular, copper may be preferable as described below in view of electron conductivity, battery action potential, and adhesion of the negative electrode active material to the current collector by sputtering.

Examples of the electrically conductive polymer material include polyaniline, polypyrrole, polythiophene, polyacetylene, polyparaphenylene, polyphenylene vinylene, polyacrylonitrile, and polyoxadiazole. These electrically conductive polymer materials have the advantage in simplification of the manufacturing process and lightness of the current collector, since these materials have sufficient electric conductivity even if electrically conductive filler is not added thereto.

Examples of the non-conductive polymer material include polyethylene (PE; such as high-density polyethylene (HDPE) and low-density polyethylene (LDPE)), polypropylene (PP), polyethylene terephthalate (PET), polyether nitrile (PEN), polyimide (PI), polyamide imide (PAI), polyamide (PA), polytetrafluoroethylene (PTFE), styrene-butadiene rubber (SBR), polyacrylonitrile (PAN), polymethyl acrylate (PMA), polymethyl methacrylate (PMMA), polyvinyl chloride (PVC), polyvinylidene fluoride (PVdF), and polystyrene (PS). These non-conductive polymer materials have high potential resistance or solvent resistance.

The electrically conductive polymer material or the non-conductive polymer material may include electrically conductive filler that is added as necessary. In particular, when the resin serving as a substrate of the current collector only contains a non-conductive polymer, the electrically conductive filler is essential to impart electric conductivity to the resin.

The electrically conductive filler is not particularly limited as long as it is a substance having electric conductivity. Examples of the material having high electric conductivity, potential resistance or lithium ion insulation property, include metal and electrically conductive carbon. The metal is not particularly limited; however, the metal is preferably at least one element selected from the group consisting of Ni, Ti, Al, Cu, Pt, Fe, Cr, Sn, Zn, In, Sb, and K, or an alloy or metal oxide containing these metals. The electrically conductive carbon is not particularly limited; however, the electrically conductive carbon is preferably at least one material selected from the group consisting of acetylene black, Vulcan, Black Pearls, carbon nanofiber, Ketjenblack, carbon nanotube, carbon nanohorn, carbon nanoballoon, and fullerene.

The amount of the electrically conductive filler added in the current collector is not particularly limited as long as it imparts sufficient electric conductivity to the current collector. In general, the amount thereof is approximately in the range from 5 to 35% by mass.

The negative electrode according to the present embodiment is characterized in that elastic elongation of the current collector in a planar direction is 1.30% or higher. Here, the elastic elongation (%) of the current collector is a ratio (%) of magnitude of elastic elongation up to a proportional limit in an extension direction to an original size.

The negative electrode according to the present embodiment using the predetermined ternary Si alloy as a negative electrode active material can concurrently ensure an initial discharge capacity as high as a Si negative electrode and achieve the effects of suppressing amorphous-crystal phase transition so as to extend cycle life when Si is alloyed with Li.

However, when a battery is manufactured by use of a negative electrode obtained in a manner such that a negative electrode active material layer containing the predetermined ternary Si alloy described above together with a conductive auxiliary agent and a binder is applied to each surface of a negative electrode current collector, expansion-contraction of a negative electrode active material may occur in association with charge and discharge of the battery. The expansion-contraction leads to a volumetric change of the negative electrode active material layer so that stress acts on the current collector adhering to the negative electrode active material layer. If the current collector cannot follow the volumetric change of the negative electrode active material layer, plastic deformation is caused in the current collector so that the current collector is wrinkled. Wrinkles formed on the current collector cause distortion of the negative electrode active material layer so that an even distance between the negative electrode and the positive electrode cannot be kept. This may lead to a decrease in Li reactivity or cause electrode concentration. Further, the current collector may be cracked or broken because of the plastic deformation caused therein, or the negative electrode active material layer may be damaged directly by the plastic deformation, which results in a decrease in discharge capacity of the battery.

The negative electrode according to the present embodiment has been provided to solve the problems described above. The negative electrode with elastic elongation of 1.30% or higher enables the current collector to elastically follow a volumetric change of the negative electrode active material layer caused by expansion-contraction of the negative electrode active material due to charge and discharge. Thus, wrinkles caused in association with stress acting on the current collector adhering to the negative electrode active material layer can be prevented so as to suppress distortion of the negative electrode active material layer or breakage of the negative electrode active material layer or the current collector. As a result, the even distance between the negative electrode and the positive electrode can be kept. In addition, a side reaction hardly occurs and therefore, a high discharge capacity can be ensured. Further, since plastic deformation of the current collector is not easily caused even when the battery is charged and discharged repeatedly, the cycle durability can also be improved.

In addition, a decrease in capacity and cycle durability can be minimized when the current collector has the elastic elongation of 1.30% or higher, since the current collector adhering to the negative electrode active material layer can be elastically deformed even if elasticity of the negative electrode active material layer is lost because of expansion-contraction of the negative electrode active material in association with charge and discharge,.

The elastic elongation of the current collector used in the negative electrode according to the present embodiment is preferably 1.40% or higher. The current collector with the elastic elongation of 1.40% or higher can more easily follow the volumetric change in the negative electrode active material used in the present embodiment caused in association with charge and discharge. Accordingly, an improvement rate of the discharge capacity retention rate greatly increases so as to further improve the cycle property. Further, the current collector with the elastic elongation of 1.50% or higher can ensure further improved effects when used together with the negative electrode active material according to the present embodiment.

The upper limit of the elastic elongation is not particularly limited because the current collector can elastically follow the volumetric change of the negative electrode active material layer more easily as the elastic elongation of the current collector is higher.

Although the negative electrode active material used in the present embodiment has a large volumetric change in association with charge and discharge compared with a carbon material such as graphite, the use of the current collector described above can suppress plastic deformation thereof, and suppress distortion of the negative electrode active material layer and a decrease of the discharge capacity derived from the distortion. In contrast, when pure Si is used for the negative electrode active material, the volumetric change in association with charge and discharge increases and therefore, even the current collector described above cannot sufficiently follow such a volumetric change of the negative electrode active material layer. As a result, it may be difficult to prevent a decrease in discharge capacity. On the other hand, when using the ternary Si alloy active material according to the present embodiment, the current collector is only required to have 1.30% or higher of the elastic elongation and contributes to providing the battery having a high discharge capacity and cycle property (refer to Fig. 22).

Note that, in the present specification, the elastic elongation (%) of the current collector is measured in accordance with a tension test method prescribed in JIS K 6251 (2010). In addition, the elastic elongation (%) of the current collector represents a value measured at 25°C.

The current collector according to the present embodiment preferably has tensile strength of 150 $N/mm^2$ or higher. When the tensile strength is 150 $N/mm^2$ or higher, the effect of preventing breakage of the current collector is improved.

Note that, in the present specification, the tensile strength ($N/mm^2$) of the current collector is measured in accordance with the tension test method prescribed in JIS K 6251 (2010). In addition, the tensile strength ($N/mm^2$) of the current collector represents a value measured at 25°C.

As described above, the material composing the current collector according to the present embodiment is not particularly limited as long as 1.30% or higher of the elastic elongation of the current collector is obtained. However, a metal such as copper, aluminum, nickel, iron, stainless steel, titanium or cobalt, or an alloy of these metals may be preferably used for the current collector.

With regard to the metals listed above, a metal foil using copper, nickel, stainless steel, or an alloy in which another metal is added to these metals is preferable in view of mechanical strength, adhesion to the active material layer, chemical stability, electrochemical stability in potential where a battery reaction progresses, electrical conductivity, and costs. Among them, copper or a copper alloy is particularly preferable in view of standard oxidation reduction potential.

As for the copper foil, a rolled copper foil (a copper foil obtained by a rolling method) or an electrolytic copper foil (a copper foil obtained by an electrolytic method) may be used. As for the copper alloy foil, an electrolytic copper alloy foil or a rolled copper alloy foil may be used. Since the negative electrode according to the present embodiment has high tensile strength and bending performance, the rolled copper foil or the rolled copper alloy foil is preferably used.

As for the copper alloy, an alloy in which an element such as Zr, Cr, Zn or Sn is added to copper may be preferably used. Such an alloy has a high elastic modulus, easily follows the volumetric change of the negative electrode active material layer, and hardly causes plastic deformation, as compared with pure copper, so as not easily cause wrinkles or breakage on the current collector. In addition, the alloy in which the element such as Zr, Cr, Zn or Sn is added to copper can have higher heat resistance than pure copper. In particular, an alloy having a softening point which is higher than a heat treatment temperature (approximately 300°C) at which slurry containing a negative electrode active material applied to a current collector is dried in a process of manufacturing a negative electrode, is preferable since the elasticity thereof can be maintained even after the heat treatment. Among them, the alloy to which Cr, Zn or Sn is added is particularly preferable in view of elastic retention after heat treatment. Each of these alloy elements may be used singly, or two or more thereof may be contained together. The total content of these alloy elements is, for example, in the range from 0.01 to 0.9% by mass, preferably in the range from 0.03 to 0.9% by mass, more preferably in the range from 0.3 to 0.9% by mass. The content of the alloy elements that is 0.03% by mass or greater is favorable in view of elastic retention after heat treatment.

A method of obtaining the current collector having 1.30% or higher of the elastic elongation is not particularly limited. When the current collector according to the present embodiment is formed of a metal foil, the mechanical characteristics can vary by heating, cooling applying pressure, or adding an impurity element. Alternatively, a commercially-available metal foil having the elongation described above may be used.

The thickness of the current collector of the negative electrode is not particularly limited; however, the thickness is preferably in the range from 5 μm to 15 μm, more preferably in the range from 5 μm to 10 μm when used in the negative electrode according to the present embodiment. The thickness of the current collector of the negative electrode that is 5 μm or greater is preferable because sufficient mechanical strength can be ensured. In addition, the thickness of the current collector of the negative electrode that is 15 μm or less is preferable in view of a decrease in thickness of the battery.

A current collector for a bipolar electrode may be the same as the negative electrode current collector. In particular, a current collector having resistance to both positive electrode potential and negative electrode potential is preferably used.

(Elements Common to Positive Electrode and Negative Electrode)

Hereinafter, elements common to both the positive electrode and the negative electrode will be explained.

The positive electrode active material layer 13 and the negative electrode active material layer 15 each contain, for example, a binder, a conductive auxiliary agent, electrolyte salt (lithium salt), and an ion-conducting polymer.

Binder

The binder used in the respective active material layers is not particularly limited. Examples of the binder include: a thermoplastic polymer such as polyethylene, polypropylene, polyethylene terephthalate (PET), polyethernitrile (PEN), polyacrylonitrile, polyimide, polyamide, polyamide imide, cellulose, carboxymethylcellulose (CMC), an ethylene-vinyl acetate copolymer, polyvinyl chloride, styrene butadiene rubber (SBR), isoprene rubber, butadiene rubber, ethylene propylene rubber, an ethylene propylene diene copolymer, a styrene-butadiene-styrene block copolymer and a hydrogen additive thereof, and a styrene-isoprene-styrene block copolymer and a hydrogen additive thereof; fluorine resin such as polyvinylidene fluoride (PVdF), polytetrafluoroethylene (PTFE), a tetrafluoroethylene-hexafluoropropylene copolymer (FEP), a tetrafluoroethylene-perfluoroalkyl vinyl ether copolymer (PFA), an ethylene-tetrafluoroethylene copolymer (ETFE), polychlorotrifluoroethylene (PCTFE), an ethylene-chlorotrifluoroethylene copolymer (ECTFE), and polyvinyl fluoride (PVF); vinylidene fluoride fluoro rubber such as vinylidene fluoride-hexafluoropropylene fluoro rubber (VDF-HFP fluoro rubber), vinylidene fluoride-hexafluoropropylene-tetrafluoroethylene fluoro rubber (VDF-HFP-TFE fluoro rubber), vinylidene fluoride-pentafluoropropylene fluoro rubber (VDF-PFP fluoro rubber), vinylidene fluoride-pentafluoropropylene-tetrafluoroethylene fluoro rubber (VDF-PFP-TFE fluoro rubber), vinylidene fluoride-perfluoromethyl vinyl ether-tetrafluoroethylene fluoro rubber (VDF-PFMVE-TFE fluoro rubber), and vinylidene fluoride-chlorotrifluoroethylene fluoro rubber (VDF-CTFE fluoro rubber); and epoxy resin. Among these, polyvinylidene fluoride, polyimide, styrene-butadiene rubber, carboxymethyl cellulose, polypropylene, polytetrafluoroethylene, polyacrylonitrile, polyamide, and polyamide imide are particularly preferable. These binders are suitable for use in the respective active material layers since these binders have high heat resistance, have quite a wide potential window, and are stable with respect to both positive electrode potential and negative electrode potential. These binders may be used alone or in combination of two or more.

The amount of the binder contained in the respective active material layers is not particularly limited as long as it is sufficient to bind the active materials. However, the amount of the binder is preferably in the range from 0.5 to 15% by mass, more preferably in the range from 1 to 10% by mass.

Conductive Auxiliary Agent

The conductive auxiliary agent is an additive added in order to improve electric conductivity in the positive electrode active material layer or the negative electrode active material layer. The conductive auxiliary agent may be a carbon material such as carbon black (such as acetylene black), graphite, and vapor-grown carbon fiber. The addition of the conductive auxiliary agent in the active material layers contributes to effectively establishing an electronic network in the active material layers and improving the output performance of the battery.

The conductive auxiliary agent and the binder may be replaced with an electrically conductive binder having both functions of the conductive auxiliary agent and the binder. Alternatively, the electrically conductive binder may be used together with one of or both the conductive auxiliary agent and the binder. The electrically conductive binder may be a commercially available binder such as TAB-2 manufactured by Hohsen Corp.

The content of the conductive auxiliary agent added to the respective active material layers, with respect to the total amount of each active material layer, is 1% by mass or greater, preferably 3% by mass or greater, more preferably 5% by mass or greater. Also, the content of the conductive auxiliary agent added to the respective active material layers, with respect to the total amount of each active material layer, is 15% by mass or less, preferably 10% by mass or less, more preferably 7% by mass or less. The mixing ratio (the content) of the conductive auxiliary agent contained in the positive electrode active material layer, which has low electronic conductivity of the active material per se and can reduce electrode resistance depending on the amount of the conductive auxiliary agent, is regulated within the range described above so as to achieve the following effects. The conductive auxiliary agent having the content within the range described above can secure sufficient electronic conductivity without impairing an electrode reaction, prevent a decrease in energy density due to a decrease in electrode density, and even increase the energy density in association with an increase of the electrode density.

Electrolyte Salt (Lithium Salt)

Examples of the electrolyte salt (lithium salt) include $Li(C_2F_5SO_2)_2N$, $LiPF_6$, $LiBF_4$, $LiClO_4$, $LiAsF_6$, and $LiCF_3SO_3$.

Ion-conducting Polymer

Examples of the ion-conducting polymer include a polyethylene oxide (PEO)-based polymer and a polypropylene oxide (PPO)-based polymer.

A mixing ratio of the components contained in each of the positive electrode active material layer and the negative electrode active material layer using the alloy in a particle state is not particularly limited. The mixing ratio may be adjusted by appropriately referring to the known findings on non-aqueous secondary batteries.

The thickness of each active material layer (the active material layer provided on one surface of each current collector) is not particularly limited, and the known findings on batteries may be appropriately referred to. As an example, the thickness of the respective active material layers is generally approximately in the range from 1 μm to 500 μm, preferably in the range from 2 μm to 100 μm, in view of the intended use of the battery (for example, priority on output, priority on energy) and ion conductivity.

<Electrolyte Layer>

A liquid electrolyte or a polymer electrolyte may be used for an electrolyte contained in the electrolyte layer 17.

The liquid electrolyte has a constitution in which electrolyte salt (lithium salt) is dissolved in an organic solvent. The organic solvent may be carbonate such as ethylene carbonate (EC), propylene carbonate (PC), butylene carbonate (BC), vinylene carbonate (VC), dimethyl carbonate (DMC), diethyl carbonate (DEC), ethyl methyl carbonate (EMC), or methyl propyl carbonate (MPC).

The lithium salt may be a compound that can be added to the active material layers in the respective electrodes, such as $Li(CF_3SO_2)_2N$, $Li(C_2F_5SO_2)_2N$, $LiPF_6$, $LiBF_4$, $LiAsF_6$, $LiTaF_6$, $LiClO_4$, or $LiCF_3SO_3$.

The polymer electrolyte is divided into two types; a gel electrolyte containing an electrolysis solution and an intrinsic polymer electrolyte not containing an electrolysis solution.

The gel electrolyte has a constitution in which the liquid electrolyte (electrolysis solution) is injected into a matrix polymer containing an ion-conducting polymer. The use of the gel polymer electrolyte has the advantage of decreasing fluidity of the electrolyte so as to easily interrupt ion conduction between the respective layers.

Examples of the ion-conducting polymer used for the matrix polymer include polyethylene oxide (PEO), polypropylene oxide (PPO), and a copolymer thereof. In such a polyalkylene oxide polymer, electrolyte salt such as lithium salt can be dissolved sufficiently.

The content ratio of the liquid electrolyte (the electrolysis solution) in the gel electrolyte should not be particularly limited, but is preferably in the range from several % by mass to 98% by mass in view of ion conductivity or the like. According to the present embodiment, the gel electrolyte exhibits better effects particularly when containing a large amount of the electrolysis solution of which the content ratio is 70% by mass or greater.

Here, a separator may be used in the respective electrolyte layers when the electrolyte layers contain the liquid electrolyte, the gel electrolyte or the intrinsic polymer electrolyte. Examples of the specific configuration of the separator (including nonwoven fabric) include a microporous film or a porous flat plate made from polyolefin such as polyethylene and polypropylene, and a nonwoven fabric.

The intrinsic polymer electrolyte has a constitution in which supporting salt (lithium salt) is dissolved in the matrix polymer, but no organic solvent serving as a plasticizer is contained therein. Thus, the use of the intrinsic polymer electrolyte contributes to reducing the risk of liquid leakage from the battery and thereby enhancing the reliability of the battery.

The matrix polymer of the gel electrolyte or the intrinsic polymer electrolyte can exhibit high mechanical strength when a cross-linked structure is formed. The cross-linked structure may be formed in a manner such that a polymerizable polymer used for polymer electrolyte formation (for example, PEO and PPO) is subjected to polymerization, such as thermal polymerization, ultraviolet polymerization, radiation polymerization, or electron beam polymerization, by use of an appropriate polymerization initiator.

<Current Collecting Plate and Lead>

Current collecting plates may be used to extract a current outward from the battery. Such current collecting plates are electrically connected to the current collectors or leads and exposed to the outside of the laminated sheet as a battery exterior member.

The material constituting the current collecting plates is not particularly limited and may be a highly electrically conductive material conventionally used for current collecting plates for lithium ion secondary batteries. For example, the constituent material for the current collecting plates is preferably a metallic material such as aluminum, copper, titanium, nickel, stainless steel (SUS), or an alloy thereof, more preferably aluminum or copper in view of lightness, corrosion resistance and high electric conductivity. The positive electrode current collecting plate and the negative electrode current collecting plate may be made from the same material or may be made from different materials.

A positive terminal lead and a negative terminal lead are used as necessary. The positive terminal lead and the negative terminal lead may be terminal leads conventionally used for lithium ion secondary batteries. Each part exposed to the outside of the battery exterior member 29 is preferably covered with, for example, a heat shrinkable tube having a heat resistant insulating property so as not to exert influence on surrounding products (such as components in the vehicle, in particular, electronic devices) due to a short circuit because of contact with peripheral devices or wires.

<Battery Exterior Member>

As the battery exterior member 29, a known metal can casing may be used. Alternatively, a sac-like casing capable of covering the power generation element and formed of a laminated film containing aluminum may be used. The laminated film may be a film having a three-layer structure in which PP, aluminum and nylon are laminated in this order, but is not particularly limited thereto. The laminated film is preferable in view of higher output power and cooling performance, and suitability for use in batteries used for large devices such as EV and HEV.

The lithium ion secondary battery described above may be manufactured by a conventionally-known method.

<Appearance of Lithium Ion Secondary Battery>

Fig. 2 is a perspective view showing an appearance of a laminated flat lithium ion secondary battery.

As shown in Fig. 2, a laminated flat lithium ion secondary battery 50 has a flat rectangular shape, and a positive electrode current collecting plate 58 and a negative electrode current collecting plate 59 for extracting electricity are exposed to the outside of the battery on both sides. A power generation element 57 is enclosed by a battery exterior member 52 of the lithium ion secondary battery 50, and the periphery thereof is thermally fused. The power generation element 57 is tightly sealed in a state where the positive electrode current collecting plate 58 and the negative electrode current collecting plate 59 are exposed to the outside of the battery. The power generation element 57 corresponds to the power generation element 21 of the lithium ion secondary battery (the laminated battery) 10 shown in Fig. 1. The power generation element 57 is obtained in a manner such that the plural single cell layers (single cells) 19 are stacked on top of each other, each single cell layer 19 being formed of the positive electrode (positive electrode active material layer 13), the electrolyte layer 17 and the negative electrode (negative electrode active material layer 15).

The lithium ion secondary battery is not limited to the laminated flat battery (laminated cell). Examples of a wound lithium ion battery may include, without particular limitation, a battery having a cylindrical shape (coin cell), a prismatic shape (prismatic cell) or a rectangular flat shape obtained by deforming the cylindrical shape, and a cylinder-like cell. A laminated film or a conventional cylinder can (metal can) may be used as an exterior material for the cylindrical shape battery or the prismatic shape battery without particular limitation. Preferably, a power generation element of each battery is enclosed by an aluminum laminated film. Such a configuration can contribute to a reduction in weight.

The exposed state of the positive electrode current collecting plate 58 and the negative electrode current collecting plate 59 shown in Fig. 2 is not particularly limited. The positive electrode current collecting plate 58 and the negative electrode current collecting plate 59 may protrude from the same side. Alternatively, the positive electrode current collecting plate 58 and the negative electrode current collecting plate 59 may each be divided into some pieces to protrude separately from each side. Thus, the current collecting plates are not limited to the configuration shown in Fig. 2. In the wound lithium ion battery, a terminal may be formed by use of, for example, a cylinder can (metal can) in place of the current collecting plate.

As described above, the negative electrode and the lithium ion secondary battery using the negative electrode active material for a lithium ion secondary battery according to the present embodiment can suitably be used as a large-capacity power source for an electric vehicle, a hybrid electric vehicle, a fuel cell vehicle, or a hybrid fuel cell vehicle. Thus, the negative electrode and the lithium ion secondary battery can suitably be applied to a power source for driving a vehicle and an auxiliary power source that are required to have high volumetric energy density and high volumetric output density.

The lithium ion battery was exemplified above as the electric device in the present embodiment. However, the present embodiment is not limited to this and may be applicable to secondary batteries of different types and, further, to primary batteries. In addition, the present embodiment may be applicable not only to batteries but also to capacitors.

EXAMPLES

Hereinafter, the present invention will be explained in more detail with reference to examples; however, the scope of the present invention is not limited only to the following examples.

First, as reference examples, each Si alloy represented by the chemical formula (1) contained in the negative electrode for an electric device according to the present invention was subjected to performance evaluation. Herein, reference Examples A, C and D are not belonging to the present invention but represent background art that is useful for understanding the present invention.

(Reference Example A): Performance Evaluation of $Si_xZn_yV_zA_a$ - not forming part of the present invention

[1] Production of Negative Electrode

As a sputtering apparatus, an independently controllable ternary DC magnetron sputtering apparatus (manufactured by Yamato-Kiki Industrial Co., Ltd.; combinatorial sputter coating apparatus; gun-sample distance: approximately 100 mm) was used. Thin films of negative electrode active material alloys having various compositions were each formed on a substrate (a current collector) made of a nickel foil having a thickness of 20 μm under the following conditions for targets and film formation, so as to obtain 31 negative electrode samples (Reference Examples 1 to 9 and Comparative Reference Examples 1 to 27).

(1) Targets (manufactured by Kojundo Chemical Laboratory Co., Ltd.; purity: 4N)

Si: diameter of 50.8 mm; thickness of 3 mm (with a backing plate made of oxygen-free copper having a thickness of 2 mm)

Zn: diameter of 50.8 mm; thickness of 5 mm

V: diameter of 50.8 mm; thickness of 5 mm

(2) Conditions of Film Formation

Base pressure: up to $7\times10^{-6}$ Pa

Sputtering gas: Ar (99.9999% or higher)

Sputtering gas introduction amount: 10 sccm

Sputtering pressure: 30 mTorr

DC power source: Si (185 W), Zn (0 to 50 W), V (0 to 150 W)

Pre-sputtering time: 1 min.

Sputtering time: 10 min.

Substrate temperature: room temperature (25°C)

In particular, the negative electrode samples including the thin alloy films having various compositions were obtained in such a manner as to use the Si target, the Zn target and the V target described above, fix the sputtering time for 10 minutes, change the power levels of the DC power source for each target within the above-described ranges, and form the thin alloy films in an amorphous state on the Ni substrates.

As for the sample preparation, for example, in sample No. 22 (Reference Example), the DC power source 1 (Si target) was set to 185 W, the DC power source 2 (Zn target) was set to 40 W, and the DC power source 3 (V target) was set to 75 W. In sample No. 30 (Comparative Reference Example), the DC power source 1 (Si target) was set to 185 W, the DC power source 2 (Zn target) was set to 0 W, and the DC power source 3 (V target) was set to 80 W. In sample No. 35 (Comparative Reference Example), the DC power source 1 (Si target) was set to 185 W, the DC power source 2 (Zn target) was set to 42 W, and the DC power source 3 (V target) was set to 0 W.

Table 1 and Fig. 3 show the respective component compositions of the thin alloy films thus obtained. The obtained thin alloy films were analyzed by using the following analysis method and analysis device.

(3) Analysis Method

Composition analysis: SEM-EDX analysis (manufactured by JEOL Ltd.), EPMA analysis (manufactured by JEOL Ltd.)

Film thickness measurement (for calculating sputtering rate): film thickness meter (manufactured by Tokyo Instruments, Inc.)

Film state analysis: Raman spectroscopic analysis (manufactured by Bruker Corporation)

[2] Production of Battery

Each of the negative electrode samples obtained as described above was placed to face the counter electrode (the positive electrode) made of a lithium foil via a separator, and an electrolysis solution was injected therein so as to prepare a CR2032 type coin cell prescribed in IEC60086 for each example.

The counter electrode was made of a lithium foil manufactured by Honjo Metal Co., Ltd. and punched into a shape having a diameter of 15 mm and a thickness of 200 μm. The separator used was Celgard 2400 manufactured by Celgard, LLC. The electrolysis solution used was prepared in a manner such that $LiPF_6$ (lithium hexafluorophosphate) was dissolved, at a concentration of 1 M, into a mixed non-aqueous solvent in which ethylene carbonate (EC) and diethyl carbonate (DEC) were mixed in a volume ratio of 1:1. Here, the counter electrode may be a positive electrode-slurry electrode (such as $LiCoO_2$, $LiNiO_2$, $LiMn_2O_4$, Li(Ni, Mn, Co)$O_2$, Li(Li, Ni, Mn, Co)$O_2$, or $LiRO_2$-$LiMn_2O_4$ (where R represents a transition metal element such as Ni, Mn, and Co)).

[3] Charge-discharge Test of Battery

The following charge-discharge tests were performed on the respective batteries obtained as described above.

The respective batteries were charged and discharged by use of a charge-discharge tester in a thermostat bath set at 300 K (27°C). The charge-discharge tester used was HJ0501SM8A manufactured by Hokuto Denko Corporation, and the thermostat bath used was PFU-3K manufactured by ESPEC Corp.

In particular, each battery was charged at 0.1 mA from 2 V to 10 mV in a constant-current/constant-voltage mode during charging, that is, in the process of Li intercalation to the negative electrode as an evaluation target. Subsequently, each cell was discharged at 0.1 mA from 10 mV to 2 V in a constant-current mode during discharging, that is, in the process of Li release from the negative electrode. This procedure, which is regarded as a single charge-discharge cycle, was repeated 50 times.

Thereafter, a discharge capacity at each of the 1st cycle and the 50th cycle was obtained. Table 1 shows the results thus obtained. Note that, in Table 1, "discharge capacity retention rate (%) at 50th cycle" represents a ratio of the discharge capacity at the 50th cycle to the discharge capacity at the 1st cycle ((discharge capacity at 50th cycle)/(discharge capacity at 1st cycle)×100)). In addition, the charge-discharge capacity represents a value calculated per alloy weight.

In the present specification, "a discharge capacity (mAh/g)" represents a value per pure Si or alloy weight and represents a capacity when Li reacts to the Si-Zn-M (M=V, Sn, Al or C) alloy (Si-M alloy, pure Si or Si-Zn alloy). Here, "the initial capacity" described in the present specification corresponds to "the discharge capacity (mAh/g)" of the initial cycle (at the 1st cycle).

[Table 1]

| No. | Composition (mass%) | | | 1st Cycle | 50th Cycle | | Category |
|---|---|---|---|---|---|---|---|
| | Si | Zn | V | Discharge Capacity (mAh/g) | Discharge Capacity (mAh/g) | Discharge Capacity Retention Rate (%) | |
| 1 | 41 | 8 | 51 | 1075 | 986 | 89 | Reference Example A1 |
| 2 | 31 | 5 | 64 | 697 | 648 | 90 | Comparative Reference Example A1 |
| 3 | 59 | 20 | 21 | 1662 | 1378 | 82 | Comparative Reference Example A2 |
| 4 | 39 | 13 | 48 | 1019 | 962 | 91 | Reference Example A2 |
| 5 | 29 | 10 | 61 | 676 | 658 | 93 | Comparative Reference Example A3 |
| 6 | 54 | 27 | 19 | 1467 | 1311 | 87 | Comparative Reference Example A4 |
| 7 | 37 | 18 | 45 | 989 | 952 | 93 | Reference Example A3 |
| 8 | 28 | 14 | 59 | 687 | 691 | 95 | Comparative Reference Example A5 |
| 9 | 49 | 33 | 18 | 1405 | 1252 | 87 | Comparative Reference Example A6 |
| 10 | 34 | 23 | 43 | 912 | 885 | 93 | Reference Example A4 |
| 11 | 27 | 17 | 56 | 632 | 653 | 96 | Comparative Reference Example A7 |
| 12 | 46 | 37 | 17 | 1261 | 1112 | 84 | Comparative Reference Example A8 |
| 13 | 33 | 27 | 40 | 862 | 836 | 93 | Reference Example A5 |
| 14 | 51 | 9 | 40 | 1413 | 1178 | 81 | Comparative Reference Example A9 |
| 15 | 35 | 6 | 59 | 841 | 815 | 93 | Reference Example A6 |
| 16 | 27 | 5 | 68 | 570 | 542 | 90 | Comparative Reference Example A10 |
| 17 | 47 | 16 | 37 | 1245 | 1148 | 90 | Reference Example A7 |
| 18 | 33 | 11 | 56 | 821 | 782 | 93 | Reference Example A8 |
| 19 | 26 | 9 | 65 | 532 | 541 | 95 | Comparative Reference Example All |
| 20 | 31 | 16 | 53 | 746 | 765 | 94 | Comparative Reference Example A12 |
| 21 | 25 | 12 | 63 | 566 | 576 | 94 | Comparative Reference Example A13 |
| 22 | 41 | 27 | 32 | 1079 | 1045 | 93 | Reference Example A9 |

(continued)

| No. | Composition (mass%) | | | 1st Cycle | 50th Cycle | | Category |
|---|---|---|---|---|---|---|---|
| | Si | Zn | V | Discharge Capacity (mAh/g) | Discharge Capacity (mAh/g) | Discharge Capacity Retention Rate (%) | |
| 23 | 30 | 20 | 50 | 699 | 718 | 94 | Comparative Reference Example A14 |
| 24 | 24 | 16 | 60 | 530 | 567 | 97 | Comparative Reference Example A15 |
| 25 | 22 | 22 | 56 | 481 | 492 | 93 | Comparative Reference Example A16 |
| 26 | 100 | 0 | 0 | 3232 | 1529 | 47 | Comparative Reference Example A17 |
| 27 | 65 | 0 | 35 | 1451 | 1241 | 85 | Comparative Reference Example A18 |
| 28 | 53 | 0 | 47 | 1182 | 1005 | 85 | Comparative Reference Example A19 |
| 29 | 45 | 0 | 55 | 886 | 824 | 83 | Comparative Reference Example A20 |
| 30 | 34 | 0 | 66 | 645 | 589 | 90 | Comparative Reference Example A21 |
| 31 | 30 | 0 | 70 | 564 | 510 | 88 | Comparative Reference Example A22 |
| 32 | 27 | 0 | 73 | 459 | 422 | 86 | Comparative Reference Example A23 |
| 33 | 25 | 0 | 75 | 366 | 345 | 86 | Comparative Reference Example A24 |
| 34 | 75 | 25 | 0 | 2294 | 1742 | 76 | Comparative Reference Example A25 |
| 35 | 58 | 42 | 0 | 1625 | 1142 | 70 | Comparative Reference Example A26 |
| 36 | 47 | 53 | 0 | 1302 | 961 | 74 | Comparative Reference Exmaple A27 |

The tests revealed that the batteries each using the Si-Zn-V series alloy as a negative electrode active material containing the components within the predetermined ranges could exhibit a good balance of the initial capacity and the cycle property. Particularly, the batteries each using the Si-Zn-V series alloy as a negative electrode active material having the alloy composition in which x is between 33 and 50, y is greater than 0 and 46 or less, and z is between 21 and 67, could exhibit a significantly good balance of the initial capacity and the cycle property. More particularly, the batteries of No. 1, 4, 7, 10, 13, 15, 17, 18 and 22 (Reference Examples A1 to A9) each using the Si alloy negative electrode active material having the composition ranges described above exhibited the initial capacity exceeding 800 mAh/g and 89% or higher of the discharge capacity retention rate. It was revealed that the batteries of Reference Examples A1 to A9 could exhibit a significantly good balance of the initial capacity and the cycle property.

(Reference Example B): Performance Evaluation of $Si_xZn_ySn_zA_a$ belonging to the present invention

[1] Production of Negative Electrode

The same production procedure in Reference Example A was repeated so as to obtain 44 negative electrode samples (Reference Examples B1 to B32 and Comparative Reference Examples B1 to B14) except that "Zn: diameter of 50.8 mm; thickness of 5 mm" and "V: diameter of 50.8 mm; thickness of 5 mm" of the targets in item (1) of Reference Example A were changed to "Zn: diameter of 50.8 mm; thickness of 3 mm" and "Sn: diameter of 50.8 mm; thickness of 5 mm", respectively, and "Zn (0 to 50 W), V (0 to 150 W)" with regard to the DC power source in item (2) of Reference Example A was changed to "Zn (0 to 150 W), Sn (0 to 40 W)".

In particular, the negative electrode samples including the thin alloy films having various compositions were obtained in such a manner as to use the Si target, the Zn target and the Sn target described above, fix the sputtering time for 10 minutes, change the power levels of the DC power source for each target within the above-described ranges, and form the thin alloy films in an amorphous state on the Ni substrates.

As for the sample preparation conditions in item (2), for example, in Reference Example B4, the DC power source 1 (Si target) was set to 185 W, the DC power source 2 (Sn target) was set to 22 W, and the DC power source 3 (Zn target) was set to 100 W. In Comparative Reference Example B2 the DC power source 1 (Si target) was set to 185 W, the DC power source 2 (Sn target) was set to 30 W, and the DC power source 3 (Zn target) was set to 0 W. In Comparative Reference Example B5, the DC power source 1 (Si target) was set to 185 W, the DC power source 2 (Sn target) was set to 0 W, and the DC power source 3 (Zn target) was set to 25 W.

Table 2-1 and Table 2-2 show the respective component compositions of the thin alloy films thus obtained. The obtained thin alloy films were analyzed by using the same analysis method and analysis device as those in Reference Example A.

[2] Production of Battery

A CR2032 type coin cell was prepared for each example in the same manner as Reference Example A.

[3] Charge-discharge Test of Battery

The charge-discharge tests were performed on the respective batteries in the same manner as Reference Example A except that the charge-discharge cycle was repeated 100 times in this Reference Example B, although the charge-discharge cycle was repeated 50 times in Reference Example A.

The discharge capacities at the 1 st cycle, the 50th cycle and the 100th cycle were obtained. Then, the respective discharge capacity retention rates (%) at the 50th cycle and the 100th cycle with respect to the discharge capacity at the 1st cycle were calculated. Table 2-1 and Table 2-2, and Figs. 9 to 11 show the results thus obtained. With regard to the discharge capacity retention rates (%) at the 50th cycle and the 100th cycle, the discharge capacity retention rate at the 50th cycle, for example, was calculated as follows: discharge capacity retention rate (%)=(discharge capacity at 50th cycle)/(discharge capacity at 1st cycle)×100.

[Table 2-1]

| Reference Example B | Composition (mass%) | | | Discharge Capacity at 1st Cycle (mAh/g) | Discharge Capacity Retention Rate (%) | |
|---|---|---|---|---|---|---|
| | Si | Sn | Zn | | 50th Cycle | 100th Cycle |
| 1 | 57 | 7 | 36 | 2457 | 94 | 69 |
| 2 | 53 | 7 | 40 | 2357 | 100 | 89 |

(continued)

| Reference Example B | Composition (mass%) | | | Discharge Capacity at 1st Cycle (mAh/g) | Discharge Capacity Retention Rate (%) | |
|---|---|---|---|---|---|---|
| | Si | Sn | Zn | | 50th Cycle | 100th Cycle |
| 3 | 47 | 6 | 47 | 2200 | 100 | 98 |
| 4 | 42 | 5 | 53 | 2121 | 100 | 100 |
| 5 | 37 | 5 | 58 | 1857 | 96 | 93 |
| 6 | 35 | 4 | 61 | 1813 | 93 | 61 |
| 7 | 53 | 20 | 27 | 2022 | 92 | 64 |
| 8 | 49 | 18 | 33 | 1897 | 93 | 72 |
| 9 | 45 | 17 | 38 | 1712 | 94 | 72 |
| 10 | 42 | 16 | 42 | 1659 | 100 | 80 |
| 11 | 40 | 15 | 45 | 1522 | 100 | 84 |
| 12 | 37 | 14 | 49 | 1473 | 100 | 92 |
| 13 | 51 | 40 | 9 | 2031 | 92 | 53 |
| 14 | 44 | 34 | 22 | 1803 | 92 | 58 |
| 15 | 41 | 32 | 27 | 1652 | 93 | 60 |
| 16 | 38 | 30 | 32 | 1547 | 94 | 70 |
| 17 | 36 | 28 | 36 | 1448 | 100 | 82 |
| 18 | 32 | 25 | 43 | 1253 | 100 | 84 |
| 19 | 42 | 50 | 8 | 1626 | 92 | 61 |
| 20 | 39 | 48 | 13 | 1603 | 92 | 65 |
| 21 | 37 | 44 | 19 | 1501 | 92 | 68 |
| 22 | 35 | 42 | 23 | 1431 | 93 | 69 |
| 23 | 33 | 40 | 27 | 1325 | 92 | 70 |
| 24 | 30 | 36 | 34 | 1248 | 100 | 83 |
| 25 | 36 | 58 | 6 | 1522 | 92 | 58 |
| 26 | 34 | 54 | 12 | 1453 | 95 | 67 |
| 27 | 32 | 52 | 16 | 1362 | 96 | 72 |
| 28 | 29 | 47 | 24 | 1249 | 76 | 74 |
| 29 | 27 | 43 | 30 | 1149 | 94 | 82 |
| 30 | 25 | 41 | 34 | 1094 | 93 | 87 |
| 31 | 27 | 55 | 18 | 1191 | 92 | 78 |
| 32 | 26 | 53 | 21 | 1142 | 92 | 77 |

[Table 2-2]

| Comparative Reference Example B | Composition (mass%) | | | Discharge Capacity at 1st Cycle (mAh/g) | Discharge Capacity Retention Rate (%) | |
|---|---|---|---|---|---|---|
| | Si | Sn | Zn | | 50th Cycle | 100th Cycle |
| 1 | 100 | 0 | 0 | 3232 | 47 | 22 |

(continued)

| Comparative Reference Example B | Composition (mass%) | | | Discharge Capacity at 1st Cycle (mAh/g) | Discharge Capacity Retention Rate (%) | |
|---|---|---|---|---|---|---|
| | Si | Sn | Zn | | 50th Cycle | 100th Cycle |
| 2 | 56 | 44 | 0 | 1817 | 91 | 42 |
| 3 | 45 | 55 | 0 | 1492 | 91 | 42 |
| 4 | 38 | 62 | 0 | 1325 | 91 | 42 |
| 5 | 90 | 0 | 10 | 3218 | 82 | 36 |
| 6 | 77 | 0 | 23 | 2685 | 82 | 39 |
| 7 | 68 | 0 | 32 | 2398 | 82 | 39 |
| 8 | 60 | 0 | 40 | 2041 | 83 | 37 |
| 9 | 54 | 0 | 46 | 1784 | 83 | 32 |
| 10 | 49 | 0 | 51 | 1703 | 75 | 24 |
| 11 | 31 | 4 | 65 | 1603 | 91 | 40 |
| 12 | 64 | 24 | 12 | 2478 | 91 | 37 |
| 13 | 23 | 47 | 30 | 996 | 72 | 42 |
| 14 | 21 | 44 | 35 | 912 | 66 | 31 |

The tests revealed that the batteries in Reference Example B (refer to Table 2-1) each using the Si-Zn-Sn series alloy as a negative electrode active material containing the components within the predetermined ranges corresponding to the area indicated by sign X in Fig. 5, each exhibited the initial capacity exceeding at least 1000 mAh/g as shown in Fig. 9. Further, as shown in Fig. 10 and Fig. 11, it was confirmed that the Si-Zn-Sn series alloy negative electrode active material having the composition ranges within the area indicated by sign X in Fig. 5 could exhibit the discharge capacity retention rate of 92% or higher after 50 cycles and the discharge capacity retention rate exceeding 50% even after 100 cycles (refer to Reference Examples B1 to B 32 in Table 2-1).

(Reference Example C): Performance Evaluation of $Si_xZn_yAl_zA_a$ - not forming part of the present invention

[1] Production of Negative Electrode

The same production procedure in Reference Example A was repeated so as to obtain 48 negative electrode samples (samples 1 to 48 in Reference Example C) except that "V (purity: 4N): diameter of 50.8 mm; thickness of 5 mm" of the target in item (1) of Reference Example A was changed to "Al (purity: 5N): diameter of 50.8 mm (2 in); thickness of 5 mm", and "Zn (0 to 50 W), V (0 to 150 W)" with regard to the DC power source in item (2) of Reference Example A was changed to "Zn (30 to 90 W), Al (30 to 180 W)".

In particular, the negative electrode samples including the thin alloy films having various compositions were obtained in such a manner as to use the Si target, the Zn target and the Al target described above, fix the sputtering time for 10 minutes, change the power levels of the DC power source for each target within the above-described ranges, and form the thin alloy films in an amorphous state on the Ni substrates.

As for the sample preparation conditions in item (2), for example, in sample 6 of Reference Example C, the DC power source 2 (Si target) was set to 185 W, the DC power source 1 (Zn target) was set to 70 W, and the DC power source 3 (Al target) was set to 50 W.

Table 3-1 and Table 3-2 show the respective component compositions of the thin alloy films thus obtained. The obtained thin alloy films were analyzed by using the same analysis method and analysis device as those in Reference Example A.

[2] Production of Battery

A CR2032 type coin cell was prepared for each sample in the same manner as Reference Example A.

[3] Charge-discharge Test of Battery

The charge-discharge tests were performed on the respective batteries in the same manner as Reference Example A.

In the case of the long-term cycle, since a deterioration mode of the electrolyte solution is included in the cycle property (although the cycle property is improved by using a high-performance electrolyte solution), the data of the 50th cycle with the remarkable component property derived from the alloy was used.

The discharge capacities at the 1 st cycle and the 50th cycle were obtained. Then, the discharge capacity retention rate (%) at the 50th cycle was calculated. Table 3-1 and Table 3-2 show the results thus obtained. Note that "the discharge capacity retention rate (%)" represents an index for "how much of the initial capacity is maintained." The discharge capacity retention rate (%) at the 50th cycle was calculated as follows: discharge capacity retention rate (%)=(discharge capacity at 50th cycle)/(greatest discharge capacity)×100. Here, the greatest discharge capacity appears between the initial cycle (the 1 st cycle) and 10 cycles, generally between 5 cycles and 10 cycles.

[Table3-1]

| Sample No. | Composition (mass%) | | | 1st Cycle | 50th Cycle | |
|---|---|---|---|---|---|---|
| | Si | Zn | Al | Discharge Capacity (mAh/g) | Discharge Capacity (mAh/g) | Discharge Capacity Retention Rate (%) |
| 1 | 73 | 25 | 2 | 2532 | 2252 | 89 |
| 2 | 60 | 20 | 20 | 2120 | 1898 | 90 |
| 3 | 50 | 17 | 32 | 1837 | 1654 | 90 |
| 4 | 43 | 56 | 1 | 1605 | 1372 | 85 |
| 5 | 38 | 49 | 13 | 1689 | 1523 | 90 |
| 6 | 30 | 69 | 1 | 1306 | 1162 | 89 |
| 7 | 28 | 63 | 9 | 1190 | 1079 | 91 |
| 8 | 26 | 58 | 16 | 1129 | 1054 | 93 |
| 9 | 44 | 15 | 41 | 1627 | 1517 | 93 |
| 10 | 39 | 13 | 48 | 1369 | 148 | 11 |
| 11 | 34 | 12 | 54 | 1268 | 71 | 6 |
| 12 | 31 | 40 | 29 | 1268 | 1223 | 96 |
| 13 | 28 | 37 | 35 | 1166 | 1104 | 95 |
| 14 | 26 | 34 | 40 | 1099 | 1055 | 96 |
| 15 | 24 | 54 | 22 | 896 | 616 | 69 |
| 16 | 22 | 50 | 28 | 824 | 297 | 36 |
| 17 | 21 | 47 | 32 | 871 | 306 | 35 |
| 18 | 34 | 44 | 22 | 1072 | 1016 | 95 |
| 19 | 78 | 19 | 2 | 2714 | 2414 | 89 |
| 20 | 53 | 13 | 34 | 1778 | 253 | 14 |
| 21 | 66 | 33 | 2 | 2458 | 2308 | 94 |
| 22 | 55 | 27 | 18 | 2436 | 2198 | 90 |
| 23 | 56 | 42 | 2 | 2432 | 2177 | 90 |
| 24 | 48 | 36 | 16 | 2065 | 1872 | 91 |
| 25 | 42 | 31 | 27 | 1910 | 1806 | 95 |
| 26 | 46 | 11 | 43 | 1695 | 221 | 13 |

(continued)

| Sample No. | Composition (mass%) | | | 1st Cycle | 50th Cycle | |
|---|---|---|---|---|---|---|
| | Si | Zn | Al | Discharge Capacity (mAh/g) | Discharge Capacity (mAh/g) | Discharge Capacity Retention Rate (%) |
| 27 | 40 | 10 | 50 | 1419 | 154 | 11 |
| 28 | 36 | 9 | 56 | 1309 | 74 | 6 |
| 29 | 36 | 18 | 46 | 1509 | 1430 | 95 |
| 30 | 33 | 16 | 51 | 1389 | 1298 | 93 |
| 31 | 37 | 28 | 35 | 1404 | 1262 | 90 |
| 32 | 33 | 25 | 42 | 1244 | 1150 | 92 |
| 33 | 30 | 23 | 47 | 1274 | 1179 | 93 |
| 34 | 47 | 23 | 30 | 1479 | 1401 | 95 |
| 35 | 41 | 20 | 39 | 1335 | 1290 | 97 |

[Table 3-2]

| Sample No. | Composition (mass%) | | | 1st Cycle | 50th Cycle | |
|---|---|---|---|---|---|---|
| | Si | Zn | A1 | Discharge Capacity (mAh/g) | Discharge Capacity (mAh/g) | Discharge Capacity Retention Rate (%) |
| 36 | 61 | 0 | 39 | 1747 | 1504 | 86 |
| 37 | 66 | 0 | 34 | 1901 | 1664 | 88 |
| 38 | 72 | 0 | 28 | 2119 | 1396 | 66 |
| 39 | 78 | 0 | 22 | 2471 | 1158 | 47 |
| 40 | 87 | 0 | 13 | 2805 | 797 | 28 |
| 41 | 97 | 0 | 3 | 3031 | 1046 | 35 |
| 42 | 100 | 0 | 0 | 3232 | 1529 | 47 |
| 43 | 90 | 10 | 0 | 3218 | 2628 | 82 |
| 44 | 77 | 23 | 0 | 2685 | 2199 | 82 |
| 45 | 68 | 32 | 0 | 2398 | 1963 | 82 |
| 46 | 60 | 40 | 0 | 2041 | 1694 | 83 |
| 47 | 54 | 46 | 0 | 1784 | 1485 | 83 |
| 48 | 49 | 51 | 0 | 1703 | 1272 | 75 |

The tests revealed that the batteries of samples 1 to 35 in Reference Example C, particularly the samples having the composition ranges surrounded by the thick solid lines in Fig. 15 to Fig. 17, could exhibit a significantly high discharge capacity at the 1 st cycle which could not be achieved by the existing carbon-based negative electrode active materials (carbon/graphite-based negative electrode active materials). It was also revealed that a higher capacity (1072 mAh/g or higher of an initial capacity) than that of the existing Sn-based alloy negative electrode active materials could be achieved. Further, it was revealed that significantly high cycle durability, which generally has a trade-off relationship with a high capacity, could be achieved as compared with the existing Sn-based alloy negative electrode active materials having a high capacity but poor cycle durability or the multi-component alloy negative electrode active materials described in Patent Document 1. In particular, these batteries could ensure significantly high cycle durability while exhibiting 85% or higher, preferably 90% or higher, more preferably 95% or higher of the discharge capacity retention rate at the 50th cycle. Thus, it was confirmed that the samples having the composition ranges surrounded by the thick solid lines in Fig. 15 to Fig. 17 among the batteries of samples 1 to 35 could suppress a remarkable decrease of the initial capacity and maintain the high capacity more efficiently since the discharge capacity retention rate was higher than that of the other samples (refer to Table 3-1).

The results of Reference Example C revealed that selecting the first additive element Zn which suppresses amorphous-crystal phase transition at the time of the alloying with Li to extend cycle life and the second additive element Al which does not decrease the capacity of the negative electrode even when the concentration of the first additive element in the alloy increases, is considerably important and useful. The first and second additive elements selected as described above can provide the Si series alloy negative electrode active material having a high capacity and high cycle durability. Accordingly, the lithium ion secondary battery having a high capacity and high cycle durability can be provided. It was also revealed that the Si metal or the binary alloys of samples 36 to 48 in Reference Example C (refer to Table 3-2) could not ensure a good balance of a higher capacity and higher cycle durability which have a trade-off relationship.

The initial cycle of each of the cells for evaluation (CR2032 type coin cells) using the electrodes for evaluation of samples 14 and 42 in Reference Example C (refer to Table 3-1 and Table 3-2), was conducted under the same charge-discharge conditions as those in Reference Example A. Fig. 18 shows a dQ/dV curve with respect to a voltage (V) during discharge of the initial cycle in each sample.

It was confirmed according to the dQ/dV curve of sample 14 in the Fig. 18 that crystallization of the Li-Si alloy was suppressed when the elements (Zn, Al) were added thereto in addition to the element Si, since the number of downward projecting peaks decreased in the low potential region (0.4 V or lower) to result in a smooth curve. It was also revealed that decomposition of the electrolysis solution (in the vicinity of 0.4 V) was also suppressed. Here, Q represents a battery capacity (discharge capacity).

The curve of sample 42 in Reference Example C (the pure Si metal thin film) showed a sharp downward projecting peak in the vicinity of 0.4 V which indicates a change due to decomposition of the electrolysis solution. In addition, the curve showed gentle downward projecting peaks in the vicinity of 0.35 V, 0.2 V, and 0.05 V, each peak indicating a change from an amorphous state to a crystal state.

In contrast, it was confirmed that decomposition of the electrolysis solution (in the vicinity of 0.4 V) was suppressed in sample 14 (the Si-Zn-Al series ternary alloy thin film) in Reference Example C in which the elements (Zn, Al) were added in addition to the element Si, since the curve of sample 14 showed no sharp downward projecting peak. In addition, sample 14 in Reference Example C showed the smooth dQ/dV curve, and no gentle downward projecting peak indicating a change from an amorphous state to a crystal state appeared and therefore it was confirmed that crystallization of the Li-Si alloy was suppressed.

The charge-discharge cycle was repeated 50 cycles (from the initial cycle to the 50th cycle) with regard to the cell for evaluation (CR2032 type coin cell) using the electrode for evaluation of sample 14 in Reference Example C under the same charge-discharge conditions as described above. Fig. 19 shows charge-discharge curves from the initial cycle to the 50th cycle. The charge process in the figure shows a state of a charge curve per cycle due to lithiation in the electrode for evaluation in sample 14. The discharge process in the figure shows a state of a discharge curve per cycle due to delithiation.

Fig.19 shows the dense curves of the cycles indicating that sample 14 has less deterioration. In addition, the charge-discharge curves with few kinks (twists) indicate that the amorphous state can be kept. Further, a small difference in capacity between charge and discharge indicates that charge-discharge efficiency is good.

According to the test results described above, the mechanism of the ternary alloys of samples 1 to 35 in Reference Example C, particularly the ternary alloy samples having the composition ranges surrounded by the thick solid lines in Fig. 15 to Fig. 17 capable of achieving the well-balanced characteristics to exhibit the high discharge capacity at the 1st cycle and keep the high cycle property (particularly the high discharge capacity retention rate at the 50th cycle), may be assumed (estimated) as follows.

1. As shown in Fig. 18, the number of the peaks in the dQ/dV curve of the ternary alloy (sample 14) in the low potential region (up to 0.6 V) is small, which makes the curve smooth, compared with pure Si (sample 42) which is not an alloy. Such a curve is conceived to indicate that decomposition of the electrolysis solution is suppressed and that phase transition of the Li-Si alloy to a crystal phase is suppressed (refer to Fig. 18).

2. It is apparent from the results that the discharge capacity decreases as the number of the cycles to be repeated increases in each of samples 1 to 48 because of the decomposition of the electrolysis solution (refer to Table 3-1 and Table 3-2). However, it was confirmed that the ternary alloy could ensure a significantly high discharge capacity retention rate compared with pure Si of sample 42 which is not an alloy. It was also confirmed that the ternary alloy could exhibit a higher discharge capacity retention rate than the existing high-capacity Sn-based negative electrode active materials, the multi-component alloy negative electrode active materials described in Patent Document 1, or the binary alloy negative electrode active materials for reference. The tests thus revealed that the cycle property tends to improve when the high discharge capacity retention rate can be ensured (refer to "discharge capacity retention rate at 50th cycle" in Table 3-1 and Table 3-2).

3. Once the phase transition of the Li-Si alloy to the crystal phase occurs, the volumetric change of the active material increases. This causes a progression from damage of the active material itself to damage of the electrode as a whole. The dQ/dV curve shown in Fig. 18 indicates that the terminal alloy of sample 14 having the composition ranges surrounded by the thick solid lines in Fig. 15 to Fig. 17 could suppress phase transition since the number of the peaks derived from the phase transition is small so as to result in a smooth curve.

(Reference Example D): Performance Evaluation of $Si_xZn_yC_zA_a$ - not forming part of the present invention

[1] Production of Negative Electrode

The same production procedure in Reference Example A was repeated so as to obtain 29 negative electrode samples (samples 1 to 29 in Reference Example D) except that "Zn: diameter of 50.8 mm; thickness of 5 mm" and "V: diameter of 50.8 mm; thickness of 5 mm" of the targets in item (1) of Reference Example A were changed to "Zn: diameter of 50.8 mm; thickness of 3 mm" and "C: diameter of 50.8 mm; thickness of 3 mm (with a backing plate made of oxygen-free copper having a thickness of 2 mm)", respectively, and "Zn (0 to 50 W), V (0 to 150 W)" with regard to the DC power source in item (2) of Reference Example A was changed to "Zn (20 to 90 W), C (30 to 90 W)".

In particular, the negative electrode samples including the thin alloy films having various compositions were obtained in such a manner as to use the Si target, the Zn target and the C target described above, fix the sputtering time for 10 minutes, change the power levels of the DC power source for each target within the above-described ranges, and form the thin alloy films in an amorphous state on the Ni substrates.

As for the sample preparation in item (2), for example, in sample No. 5 (Reference Example) in Reference Example D, the DC power source 1 (Si target) was set to 185 W, the DC power source 2 (C target) was set to 60 W, and the DC power source 3 (Zn target) was set to 30 W. In sample No. 22 (Comparative Reference Example) in Reference Example D, the DC power source 1 (Si target) was set to 185 W, the DC power source 2 (C target) was set to 45 W, and the DC power source 3 (Zn target) was set to 0 W. In sample No. 26 (Comparative Reference Example) in Reference Example D, the DC power source 1 (Si target) was set to 185 W, the DC power source 2 (C target) was set to 0 W, and the DC power source 3 (Zn target) was set to 28 W.

Table 4 and Fig. 20 show the respective component compositions of the thin alloy films thus obtained. The obtained thin alloy films were analyzed by using the same analysis method and analysis device as those in Reference Example A.

[2] Production of Battery

A CR2032 type coin cell was prepared for each sample in the same manner as Reference Example A.

[3] Charge-discharge Test of Battery

The charge-discharge tests were performed on the respective batteries in the same manner as Reference Example A. In particular, the charge capacity and the discharge capacity at the 1st cycle and the discharge capacity at the 50th cycle were obtained, and each item in Table 4 was calculated. The discharge capacity retention rate (%) after 50 cycles in Table 4 represents a ratio of the discharge capacity at the 50th cycle to the discharge capacity at the 1 st cycle ((discharge capacity at 50th cycle)/(discharge capacity at 1st cycle)×100). In addition, "charge-discharge efficiency" represents a ratio of the discharge capacity to the charge capacity ((discharge capacity)/(charge capacity)×100).

[Table 4]

| No. | Composition (mass%) | | | Initial (1st Cycle) Discharge Capacity (mAh/g) | Discharge Capacity Retention Rate after 50 Cycles (%) | Initial (1st Cycle) Charge-Discharge Efficiency (%) | Category |
|---|---|---|---|---|---|---|---|
| | Si | Zn | C | | | | |
| 1 | 53.40 | 44.00 | 2.60 | 1819 | 77 | 100 | Reference Example D1 |

(continued)

| No. | Composition (mass%) | | | Initial (1st Cycle) Discharge Capacity (mAh/g) | Discharge Capacity Retention Rate after 50 Cycles (%) | Initial (1st Cycle) Charge-Discharge Efficiency (%) | Category |
|---|---|---|---|---|---|---|---|
| | Si | Zn | C | | | | |
| 2 | 42.45 | 55.48 | 2.07 | 1668 | 74 | 98 | Reference Example D2 |
| 3 | 35.22 | 63.08 | 1.72 | 1378 | 77 | 97 | Reference Example D3 |
| 4 | 30.10 | 68.43 | 1.47 | 1221 | 72 | 97 | Reference Example D4 |
| 5 | 51.95 | 17.68 | 30.37 | 1693 | 75 | 99 | Reference Example D5 |
| 6 | 34.59 | 45.20 | 20.21 | 1326 | 78 | 98 | Reference Example D6 |
| 7 | 29.63 | 53.05 | 17.32 | 1215 | 71 | 98 | Reference Example D7 |
| 8 | 25.92 | 58.93 | 15.15 | 1129 | 74 | 98 | Reference Example D8 |
| 9 | 39.85 | 13.57 | 46.59 | 1347 | 69 | 99 | Reference Example D9 |
| 10 | 28.77 | 37.60 | 33.63 | 1103 | 79 | 98 | Reference Example D10 |
| 11 | 25.26 | 45.21 | 29.53 | 1059 | 72 | 98 | Reference Example D11 |
| 12 | 97.73 | 1.79 | 0.48 | 3099 | 48 | 89 | Comparative Reference Example D1 |
| 13 | 84.44 | 15.15 | 0.41 | 2752 | 52 | 90 | Comparative Reference Example D2 |
| 14 | 74.33 | 25.31 | 0.36 | 2463 | 53 | 89 | Comparative Reference Example D3 |
| 15 | 82.56 | 1.51 | 15.93 | 2601 | 59 | 90 | Comparative Reference Example D4 |
| 16 | 72.87 | 13.07 | 14.06 | 2483 | 68 | 90 | Comparative Reference Example D5 |
| 17 | 65.22 | 22.20 | 12.58 | 2136 | 55 | 90 | Comparative Reference Example D6 |
| 18 | 100.00 | 0.00 | 0.00 | 3232 | 47 | 91 | Comparative Reference Example D7 |

(continued)

| No. | Composition (mass%) | | | Initial (1st Cycle) Discharge Capacity (mAh/g) | Discharge Capacity Retention Rate after 50 Cycles (%) | Initial (1st Cycle) Charge-Discharge Efficiency (%) | Category |
|---|---|---|---|---|---|---|---|
| | Si | Zn | C | | | | |
| 19 | 95.36 | 0.00 | 4.64 | 3132 | 58 | 92 | Comparative Reference Example D8 |
| 20 | 83.69 | 0.00 | 16.31 | 2778 | 64 | 91 | Comparative Reference Example D9 |
| 21 | 71.96 | 0.00 | 28.04 | 2388 | 51 | 91 | Comparative Reference Example D10 |
| 22 | 69.52 | 0.00 | 30.48 | 2370 | 68 | 91 | Comparative Reference Example D11 |
| 23 | 67.24 | 0.00 | 32.76 | 2295 | 54 | 91 | Comparative Reference Example D12 |
| 24 | 65.11 | 0.00 | 34.89 | 2240 | 32 | 87 | Comparative Reference Example D13 |
| 25 | 63.11 | 0.00 | 36.89 | 2120 | 59 | 91 | Comparative Reference Example D14 |
| 26 | 85.15 | 14.85 | 0.00 | 2618 | 76 | 88 | Comparative Reference Example D15 |
| 27 | 80.83 | 19.17 | 0.00 | 2268 | 70 | 87 | Comparative Reference Example D16 |
| 28 | 77.15 | 22.85 | 0.00 | 2132 | 74 | 87 | Comparative Reference Example D17 |
| 29 | 73.97 | 26.03 | 0.00 | 2640 | 80 | 89 | Comparative Reference Example D18 |

The tests revealed according to Table 4 that the batteries of samples No. 1 to 11 of Reference Examples D could exhibit a good balance of the initial charge-discharge efficiency and the discharge capacity retention rate. In particular, the samples having the composition ranges satisfying $25<x<54$, $17<y<69$ and $1<z<34$ exhibited a good balance (refer to Fig. 21). In contrast, the batteries of samples No. 12 to 29 of Comparative Reference Examples D each showed a significant decrease of the initial charge-discharge efficiency and/or the discharge capacity retention rate although the initial charge capacity was high.

Next, a negative electrode for an electric device including a negative electrode active material layer containing a negative electrode active material using $Si_{41}Zn_{20}Sn_{39}$ selected among the Si alloys described above and further containing a conductive auxiliary agent and a binder, was subjected to performance evaluation in each of Examples.

Here, the other alloys used in the present invention other than $Si_{41}Zn_{20}Sn_{39}$ (the alloys of $Si_xZn_ySn_zA_a$ other than $Si_{41}Zn_{20}Sn_{39}$) can obtain the results identical or similar to those of the following examples using $Si_{41}Zn_{20}Sn_{39}$. The

reason thereof is that, as shown in the reference examples, the other alloys used in the present invention have characteristics similar to those of $Si_{41}Zn_{20}Sn_{39}$. That is, the alloys having similar characteristics can obtain similar results even if the type of the alloys is changed.

In each of the following examples and comparative examples, the negative electrode for an electric device containing the negative electrode active material using $Si_{41}Zn_{20}Sn_{39}$ selected among the Si alloys described above and changing the type of current collectors (elastic elongation), was subjected to performance evaluation.

[Production of Si Alloy]

The Si alloy described above was produced by a mechanical alloying method (or an arc plasma melting method). In particular, the Si alloy was obtained in a manner such that a planetary ball mill P-6 (manufactured by Fritsch, Germany) was used, and zirconia pulverization balls and raw material powder of each alloy were put into a zirconia pulverizing pot so as to subject the mixture to alloying processing at 600 rpm for 48 hours.

[Production of Negative Electrode]

(Example 1)

First, 80 parts by mass of a negative electrode active material, 5 parts by mass of a conductive auxiliary agent and 15 parts by mass of a binder were mixed in N-methyl-2-pyrrolidone (NMP) as a solvent so as to prepare negative electrode active material slurry. In this example, the Si alloy powder ($Si_{41}Zn_{20}Sn_{39}$; average particle diameter of primary particles: 0.3 $\mu$m) prepared above was used as the negative electrode active material. In addition, short-chain acetylene black as short-chain carbon black was used as the conductive auxiliary agent, and polyimide was used as the binder.

Next, a copper alloy foil (copper alloy 1: Cu to which approximately 0.3% by mass of each of Cr, Sn and Zn was added) having a thickness of 10 $\mu$m with 1.43% of elastic elongation and 580 N/mm$^2$ of tensile strength was prepared.

In this example, the elastic elongation (%) and the tensile strength (N/mm$^2$) of the current collector were measured by use of a digital material testing machine 5565 (manufactured by Instron) at a velocity of 10 mm/min and a chuck interval of 50 mm. The sample used was a current collecting foil formed into a wedge having a total length of 7 mm and a parallel part width of 5 mm.

The prepared negative electrode active material slurry was applied evenly to both surfaces of the copper alloy foil (copper alloy 1) in a manner such that the thickness thereof on each side after drying was 50 $\mu$m, and then dried in a vacuum for 24 hours so as to obtain a negative electrode.

(Example 2)

A negative electrode of this example was produced in the same manner as Example 1 except that a copper alloy foil (copper alloy 2: Cu to which approximately 0.3% by mass of Zr was added) having a thickness of 10 $\mu$m with 1.53% of elastic elongation and 450 N/mm$^2$ of tensile strength was used as the negative electrode current collector.

(Example 3)

A negative electrode of this example was produced in the same manner as Example 1 except that a copper alloy foil (copper alloy 3: Cu to which approximately 0.1% by mass of Zr was added) having a thickness of 10 $\mu$m with 1.39% of elastic elongation and 420 N/mm$^2$ of tensile strength was used as the negative electrode current collector.

(Comparative Example 1)

A negative electrode of this example was produced in the same manner as Example 1 except that a copper foil (tough pitch copper: Cu with purity of 99.9% by mass or higher) having a thickness of 10 $\mu$m with 1.28% of elastic elongation and 139 N/mm$^2$ of tensile strength was used as the negative electrode current collector.

(Comparative Example 2)

A negative electrode of this example was produced in the same manner as Comparative Example 1 except that 80 parts by mass of silicon (pure Si) powder (purity: 99.999% by mass; average particle diameter of primary particles: 45 $\mu$m) were used as the negative electrode active material.

(Comparative Example 3)

A negative electrode of this example was produced in the same manner as Comparative Example 2 except that polyvinylidene fluoride (PVdF) was used as the binder material.

[Production of Positive Electrode]

As a positive electrode active material, $Li_{1.85}Ni_{0.18}CO_{0.10}Mn_{0.87}O_3$ was prepared in a manner described in Example 1 (paragraph [0046]) of JP 2012-185913 A. Next, 90 parts by mass of the positive electrode active material thus obtained, 5 parts by mass of acetylene black as a conductive auxiliary agent and 5 parts by mass of polyvinylidene fluoride as a binder were mixed together and dispersed in N-methyl pyrrolidone to prepare positive electrode slurry. The positive electrode slurry thus obtained was applied evenly to both surfaces of a positive electrode current collector formed of an aluminum foil in a manner such that the thickness of a positive electrode active material layer on each side was 30 $\mu$m, and then dried so as to obtain a positive electrode.

[Production of Battery]

The produced positive electrode was placed to face the negative electrode, and a separator (polyolefin, film thickness: 20 $\mu$m) was interposed therebetween. A stacked body of the negative electrode, the separator and the positive electrode was placed on the bottom side of a coin cell (CR2032; material: stainless steel (SUS316)). Further, a gasket was attached thereto in order to ensure insulation between the positive electrode and the negative electrode, an electrolysis solution described below was injected therein by use of a syringe, a spring and a spacer were stacked thereon, and an upper member of the coin cell was placed over and cramped to seal so as to obtain a lithium ion secondary battery for each example.

The electrolysis solution used was prepared in a manner such that lithium hexafluorophosphate ($LiPF_6$) as supporting salt was dissolved, at a concentration of 1 mol/L, into an organic solvent in which ethylene carbonate (EC) and diethyl carbonate (DEC) were mixed in a ratio of 1:2 (volume ratio).

[Charge-discharge Test of Battery]

The charge-discharge tests were performed on the respective batteries in the same manner as Reference Example A.

In particular, the respective batteries were charged and discharged by use of the charge-discharge tester (HJ0501SM8A manufactured by Hokuto Denko Corporation) in the thermostat bath (PFU-3K manufactured by ESPEC Corp.) set at 300 K (27°C). The respective batteries were charged at 0.1 mA from 2 V to 10 mV in a constant-current/constant-voltage mode during charging (in the process of Li intercalation to the negative electrode as an evaluation target). Subsequently, the respective batteries were discharged at 0.1 mA from 10 mV to 2 V in a constant-current mode during discharging (in the process of Li release from the negative electrode). This procedure, which is regarded as a single charge-discharge cycle, was repeated 50 times.

Thereafter, a discharge capacity at the 50th cycle was obtained, and a discharge capacity retention rate (%) at the 50th cycle with respect to the discharge capacity at the 1 st cycle was calculated. Here, "the discharge capacity retention rate (%)" at the 50th cycle represents an index for "how much of the initial capacity is maintained." The discharge capacity retention rate (%) was calculated according to the following formula.

$$\text{Discharge capacity retention rate (\%)} = (\text{discharge capacity at 50th cycle})/(\text{discharge capacity at 1st cycle}) \times 100$$

Table 5 and Fig. 22 show the results of the obtained discharge capacity retention rates (%) indicated by values normalized in a manner such that the discharge capacity retention rate of Comparative Example 1 is readjusted to 100 (an improvement rate (%) of the discharge capacity retention rate).

[Table 5]

| | Active Material | Conductive Auxiliary Agent | Binder | Current Collector | Elastic Elongation of Current Collector (%) | Tensile Strength of Current Collector ($N/mm^2$) | Improvement Rate of Discharge Capacity Retention Rate (%) |
|---|---|---|---|---|---|---|---|
| Example 1 | Si Alloy | Short-Chain Carbon Black | Polyimide | Copper Alloy 1 | 1.43 | 580 | 124 |
| Example 2 | Si Alloy | Short-Chain Carbon Black | Polyimide | Copper Alloy 2 | 1.53 | 450 | 122 |
| Example 3 | Si Alloy | Short-Chain Carbon Black | Polyimide | Copper Alloy 3 | 1.39 | 420 | 108 |
| Comparative Example 1 | Si Alloy | Short-Chain Carbon Black | Polyimide | Tough Pitch Copper | 1.28 | 139 | 100 |
| Comparative Example 2 | Pure Si | Short-Chain Carbon Black | Polyimide | Tough Pitch Copper | 1.28 | 139 | 84 |
| Comparative Example 3 | Pure Si | Short-Chain Carbon Black | PVdF | Tough Pitch Copper | 1.28 | 139 | 63 |

The tests revealed according to Table 5 and Fig. 22 that the batteries of Examples 1 to 3 each using the current collector having the elastic elongation of 1.30% or higher exhibited a high discharge capacity retention rate compared with the batteries of Comparative Examples 1 to 3. The reason thereof may be that the current collector used in each of Examples 1 to 3 could elastically follow the volumetric change of the negative electrode active material layer containing the Si alloy at the time of charge and discharge so as to suppress deformation of the electrode layer. Particularly, the batteries of Examples 1 and 2 each using the current collector having the elastic elongation of 1.40% or greater or 1.50% or greater exhibited a much higher discharge capacity retention rate.

On the other hand, in the battery of Comparative Example 1 using the current collector with the elastic deformation of a predetermined value or lower, the current collector was easily subjected to plastic deformation in association with the volumetric change of the negative electrode active material layer due to charge and discharge. As a result, the negative electrode active material layer was distorted so that an even distance between the negative electrode and the positive electrode could not be kept. This may be the reason why the battery could not ensure a high discharge capacity retention rate.

In the battery of Comparative Example 2 using pure Si as the negative electrode active material, the volumetric change of the negative electrode active material layer was larger than that of the Si alloy because of the expansion-contraction of the negative electrode active material in association with charge and discharge of the battery. Thus, the current collector could not follow such a larger volumetric change of the negative electrode active material layer, which may be the reason why the capacity was decreased significantly.

The battery of Comparative Example 3 using PVdF as the binder in the negative electrode active material layer showed a much lower discharge capacity retention rate. This may be because the binder could not follow the expansion-contraction of the active material in association with charge and discharge since the elastic modulus of PVdF (1.0 GPa) used as the binder in Comparative Example 3 was lower than the elastic modulus of polyimide (3.73 GPa) used in Examples 1 to 3 and Comparative Examples 1 and 2, which resulted in an increase of the volumetric change of the negative electrode active material layer. As a result, the current collector could not follow the volumetric change of the negative electrode active material layer, which may be the reason why the capacity was decreased more remarkably.

REFERENCE SIGNS LIST

| | |
|---|---|
| 10, 50 | LITHIUM ION SECONDARY BATTERY (LAMINATED BATTERY) |
| 11 | POSITIVE ELECTRODE CURRENT COLLECTOR |
| 12 | NEGATIVE ELECTRODE CURRENT COLLECTOR |
| 13 | POSITIVE ELECTRODE ACTIVE MATERIAL LAYER |
| 15 | NEGATIVE ELECTRODE ACTIVE MATERIAL LAYER |
| 17 | ELECTROLYTE LAYER |
| 19 | SINGLE CELL LAYER |
| 21, 57 | POWER GENERATION ELEMENT |
| 25, 58 | POSITIVE ELECTRODE CURRENT COLLECTING PLATE |
| 27, 59 | NEGATIVE ELECTRODE CURRENT COLLECTING PLATE |
| 29, 52 | BATTERY EXTERIOR MEMBER (LAMINATED FILM) |

**Claims**

**1.** A negative electrode for an electric device, comprising a current collector and an electrode layer containing a negative electrode active material, a conductive auxiliary agent and a binder and formed on a surface of the current collector, wherein the negative electrode active material contains an alloy represented by the following formula (1):

$$Si_xZn_yM_zA_a \qquad (1)$$

in the formula (1), M is Sn,
A is an inevitable impurity, and
x, y, z and a represent mass percent values and satisfy conditions of 23<x<64, 0<y<65, 4≤z<34, 0<a<0.5 and x+y+z+a=100, and
an elastic elongation of the current collector is 1.30% or greater, wherein the elastic elongation of the current collector is measured at 25 °C in accordance with a tension test method prescribed in JIS K 6251 (2010).

**2.** A negative electrode for an electric device, comprising a current collector and an electrode layer containing a negative electrode active material, a conductive auxiliary agent and a binder and formed on a surface of the current collector, wherein the negative electrode active material contains an alloy represented by the following formula (1):

$$Si_xZnyM_zA_a \qquad (1)$$

in the formula (1), M is Sn,
A is an inevitable impurity, and
x, y, z and a represent mass percent values and satisfy conditions of 23<x<44, 0<y<65, 34≤z≤58, 0<a<0.5 and x+y+z+a=100, and
an elastic elongation of the current collector is 1.30% or greater, wherein the elastic elongation of the current collector is measured at 25 °C in accordance with a tension test method prescribed in JIS K 6251 (2010).

**3.** The negative electrode for an electric device according to claim 1 or 2, wherein the elastic elongation of the current collector is 1.40% or greater.

4. The negative electrode for an electric device according to claim 3, wherein the elastic elongation of the current collector is 1.50% or greater.

5. The negative electrode for an electric device according to any one of claims 1, 3 and 4, wherein y satisfies $27<y<61$.

6. The negative electrode for an electric device according to any one of claims 2 to 4, wherein x satisfies $23<x<34$.

7. The negative electrode for an electric device according to claim 5, wherein y and z satisfy $38<y<61$ and $4\leq z<24$, respectively.

8. The negative electrode for an electric device according to claim 5, wherein x satisfies $24\leq x<38$.

9. The negative electrode for an electric device according to claim 2, wherein x, y and z satisfy $23<x<38$, $27<y<65$ and $34\leq z<40$, respectively.

10. The negative electrode for an electric device according to claim 2, wherein x and z satisfy $23<x<29$ and $40\leq z\leq 58$, respectively.

11. An electric device comprising the negative electrode for an electric device according to any one of claims 1 to 10.

## Patentansprüche

1. Negative Elektrode für eine elektrische Vorrichtung, die einen Stromkollektor und eine Elektrodenschicht aufweist, die ein Negativelektroden-Aktivmaterial, ein leitfähiges Hilfsmittel und ein Bindemittel enthält und auf einer Oberfläche des Stromkollektors ausgebildet ist,
wobei das Negativelektroden-Aktivmaterial eine durch die folgende Formel (1) repräsentierte Legierung enthält:

$$Si_xZn_yM_zA_a \qquad (1)$$

M in der Formel (1) Sn ist,
A ist eine unvermeidliche Verunreinigung ist, und
x, y, z und a Massenprozentwerte repräsentieren und die Bedingungen $23<x<64$, $0<y<65$, $4\leq z<34$, $0<a<0,5$ und $x+y+z+a=100$ erfüllen, und
eine elastische Dehnung des Stromkollektors 1,30% oder mehr beträgt, wobei die elastische Dehnung des Stromkollektors bei 25 °C gemäß einem in JIS K 6251 (2010) vorgeschriebenen Zugspannungsprüfverfahren gemessen wird.

2. Negative Elektrode für eine elektrische Vorrichtung, die einen Stromkollektor und eine Elektrodenschicht aufweist, die ein Negativelektroden-Aktivmaterial, ein leitfähiges Hilfsmittel und ein Bindemittel enthält und auf einer Oberfläche des Stromkollektors ausgebildet ist,
wobei das Negativelektroden-Aktivmaterial eine durch die folgende Formel (1) repräsentierte Legierung enthält:

$$Si_xZn_yM_zA_a \qquad (1)$$

M in der Formel (1) Sn ist,
A ist eine unvermeidliche Verunreinigung ist, und
x, y, z und a Massenprozentwerte repräsentieren und die Bedingungen $23<x<44$, $0<y<65$, $34\leq z\leq 58$, $0<a<0,5$ und $x+y+z+a=100$ erfüllen, und
eine elastische Dehnung des Stromkollektors 1,30% oder mehr beträgt, wobei die elastische Dehnung des Stromkollektors bei 25 °C gemäß einem in JIS K 6251 (2010) vorgeschriebenen Zugspannungsprüfverfahren gemessen wird.

3. Negative Elektrode für eine elektrische Vorrichtung nach Anspruch 1 oder 2, wobei die elastische Dehnung des Stromkollektors 1,40% oder mehr beträgt.

4. Negative Elektrode für eine elektrische Vorrichtung nach Anspruch 1 oder 2, wobei die elastische Dehnung des Stromkollektors 1,50% oder mehr beträgt.

**5.** Negative Elektrode für eine elektrische Vorrichtung nach einem der Ansprüche 1, 3 und 4, wobei y $27<y<61$ erfüllt.

**6.** Negative Elektrode für eine elektrische Vorrichtung nach einem der Ansprüche 2 bis 4, wobei x $23<x<34$ erfüllt.

**7.** Negative Elektrode für eine elektrische Vorrichtung nach Anspruch 5, wobei y und z $38<y<61$ bzw. $4\leq z<24$ erfüllen.

**8.** Negative Elektrode für eine elektrische Vorrichtung nach Anspruch 5, wobei x $24\leq x<38$ erfüllt.

**9.** Negative Elektrode für eine elektrische Vorrichtung nach Anspruch 2, wobei x, y und z $23<x<38$, $27<y<65$ bzw. $34\leq z<40$ erfüllen.

**10.** Negative Elektrode für eine elektrische Vorrichtung nach Anspruch 2, wobei x und z $23<x<29$ bzw. $40\leq z\leq 58$ erfüllen.

**11.** Elektrische Vorrichtung, welche die negative Elektrode für eine elektrische Vorrichtung nach einem der Ansprüche 1 bis 10 aufweist.

### Revendications

**1.** Électrode négative pour un dispositif électrique, comprenant un collecteur de courant et une couche d'électrode contenant un matériau actif d'électrode négative, un agent auxiliaire conducteur et un liant et formée sur une surface du collecteur de courant,
dans laquelle le matériau actif d'électrode négative contient un alliage représenté par la formule (1) suivante :

$$Si_xZn_yM_zA_a \qquad (1)$$

dans la formule (1), M représente Sn,
A représente une impureté inévitable, et
x, y, z et a représentent des valeurs de pourcentage massique et satisfont les conditions $23 < x < 64$, $0 < y < 65$, $4 \leq z < 34$, $0 < a < 0,5$ et $x + y + z + a = 100$, et
un allongement élastique du collecteur de courant est supérieur ou égal à 1,30%, où l'allongement élastique du collecteur de courant est mesuré à 25°C selon un procédé d'essai de traction prescrit dans JIS K 6251 (2010).

**2.** Électrode négative pour un dispositif électrique, comprenant un collecteur de courant et une couche d'électrode contenant un matériau actif d'électrode négative, un agent auxiliaire conducteur et un liant et formée sur une surface du collecteur de courant,
dans laquelle le matériau actif d'électrode négative contient un alliage représenté par la formule (1) suivante :

$$Si_xZn_yM_zA_a \qquad (1)$$

dans la formule (1), M représente Sn,
A représente une impureté inévitable, et
x, y, z et a représentent des valeurs de pourcentage massique et satisfont les conditions $23 < x < 44$, $0 < y < 65$, $34 \leq z \leq 58$, $0 < a < 0,5$ et $x + y + z + a = 100$, et
un allongement élastique du collecteur de courant est supérieur ou égal à 1,30%, où l'allongement élastique du collecteur de courant est mesuré à 25°C selon un procédé d'essai de traction prescrit dans JIS K 6251 (2010).

**3.** Électrode négative pour un dispositif électrique selon la revendication 1 ou 2, dans laquelle l'allongement élastique du collecteur de courant est supérieur ou égal à 1,40%.

**4.** Électrode négative pour un dispositif électrique selon la revendication 3, dans laquelle l'allongement élastique du collecteur de courant est supérieur ou égal à 1,50%.

**5.** Électrode négative pour un dispositif électrique selon l'une quelconque des revendications 1, 3 et 4, dans laquelle y satisfait $27 < y < 61$.

**6.** Électrode négative pour un dispositif électrique selon l'une quelconque des revendications 2 à 4, dans laquelle x satisfait $23 < x < 34$.

7. Électrode négative pour un dispositif électrique selon la revendication 5, dans laquelle y et z satisfont $38 < y < 61$ et $4 \leq z < 24$, respectivement.

8. Électrode négative pour un dispositif électrique selon la revendication 5, dans laquelle x satisfait $24 \leq x < 38$.

9. Électrode négative pour un dispositif électrique selon la revendication 2, dans laquelle x, y et z satisfont $23 < x < 38$, $27 < y < 65$ et $34 \leq z < 40$, respectivement.

10. Électrode négative pour un dispositif électrique selon la revendication 2, dans laquelle x et z satisfont $23 < x < 29$ et $40 \leq z \leq 58$, respectivement.

11. Dispositif électrique comprenant l'électrode négative pour un dispositif électrique selon l'une quelconque des revendications 1 à 10.

FIG. 1

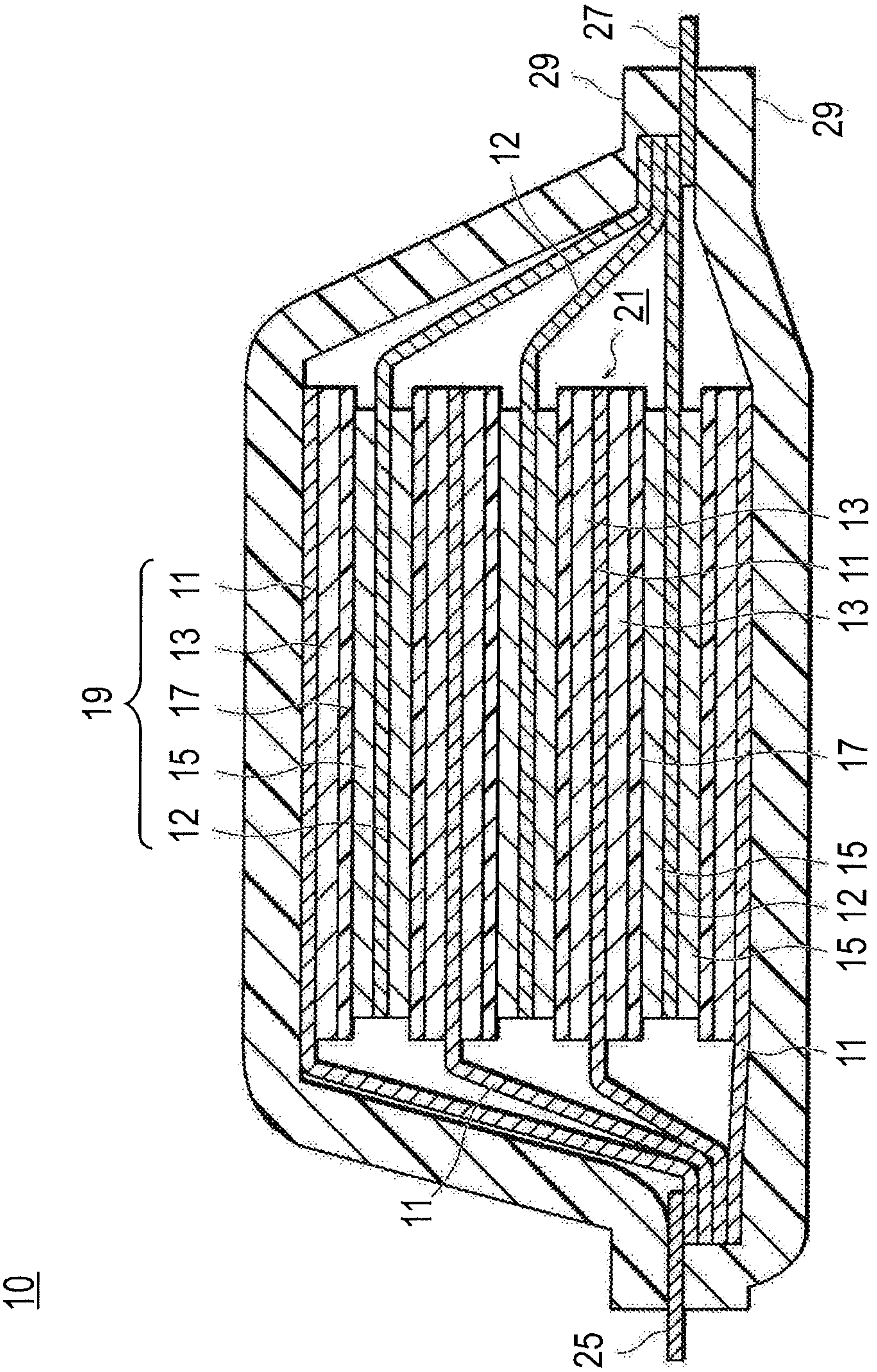

FIG. 2

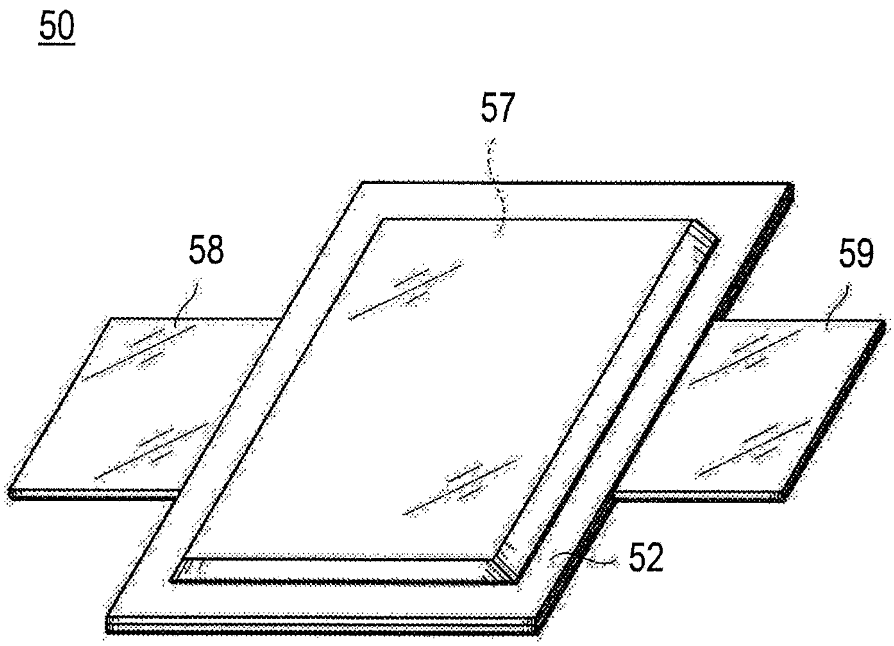

FIG. 3

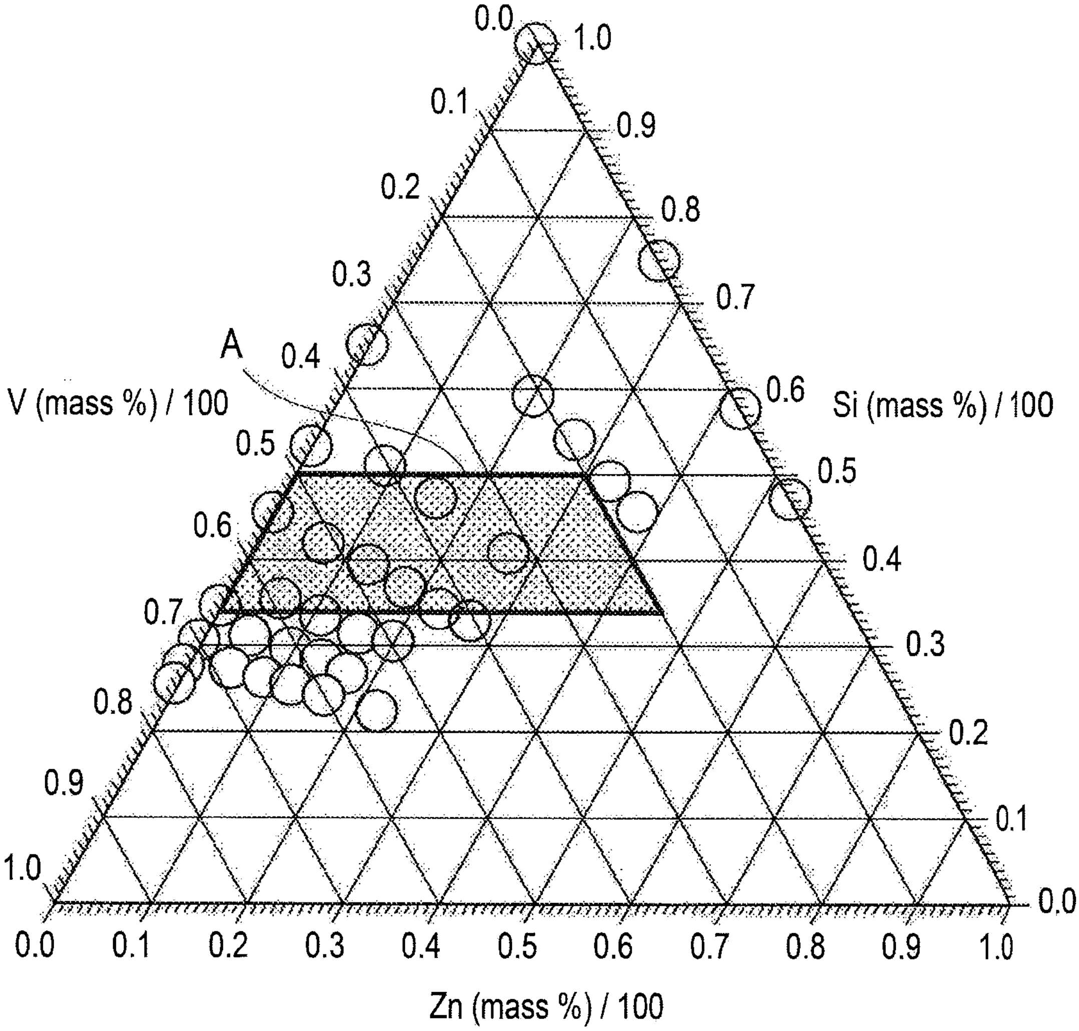

FIG. 4

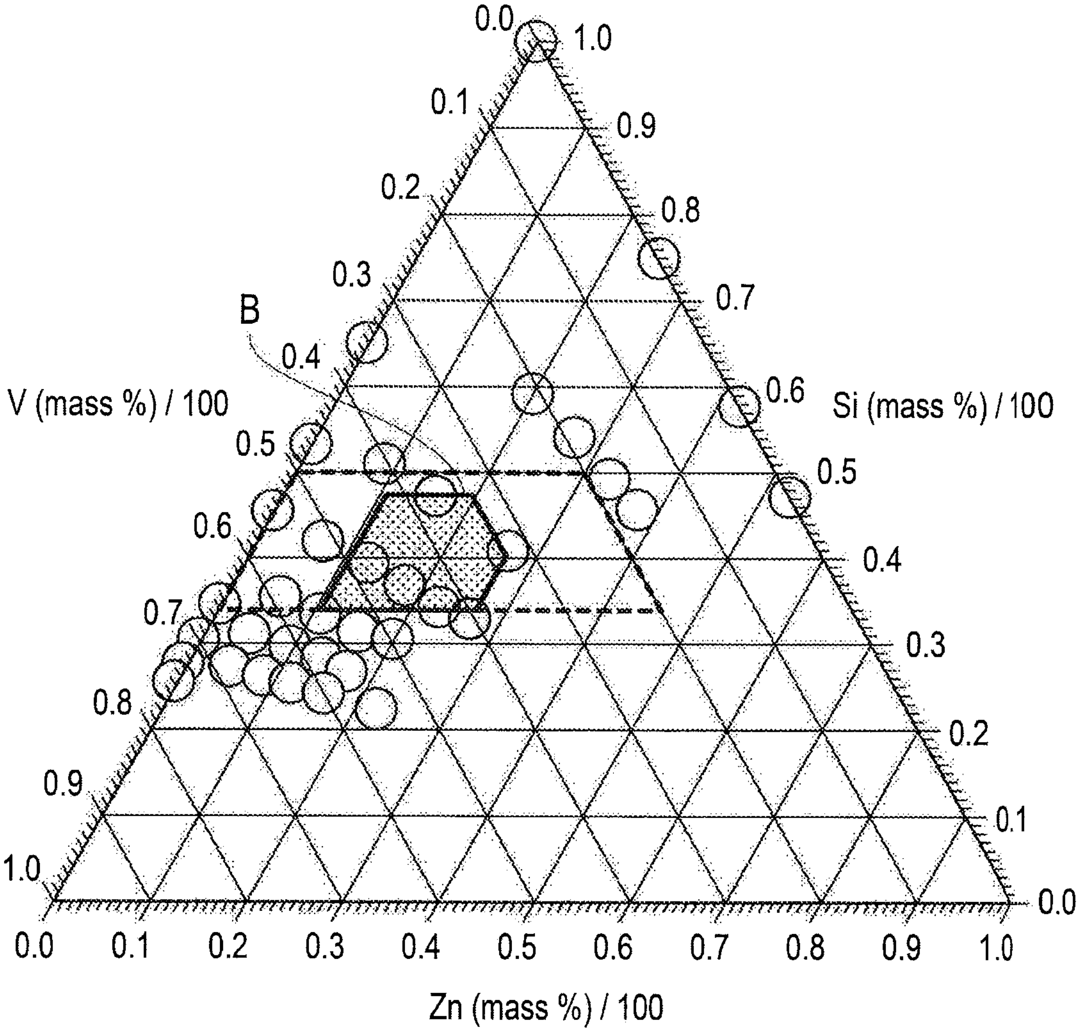
0.0
1.0
0.1
0.9
0.2
0.8
0.3
0.7
B
0.4
0.6
V (mass %) / 100
Si (mass %) / 100
0.5
0.5
0.6
0.4
0.7
0.3
0.8
0.2
0.9
0.1
1.0
0.0
0.0 0.1 0.2 0.3 0.4 0.5 0.6 0.7 0.8 0.9 1.0
Zn (mass %) / 100

FIG. 5

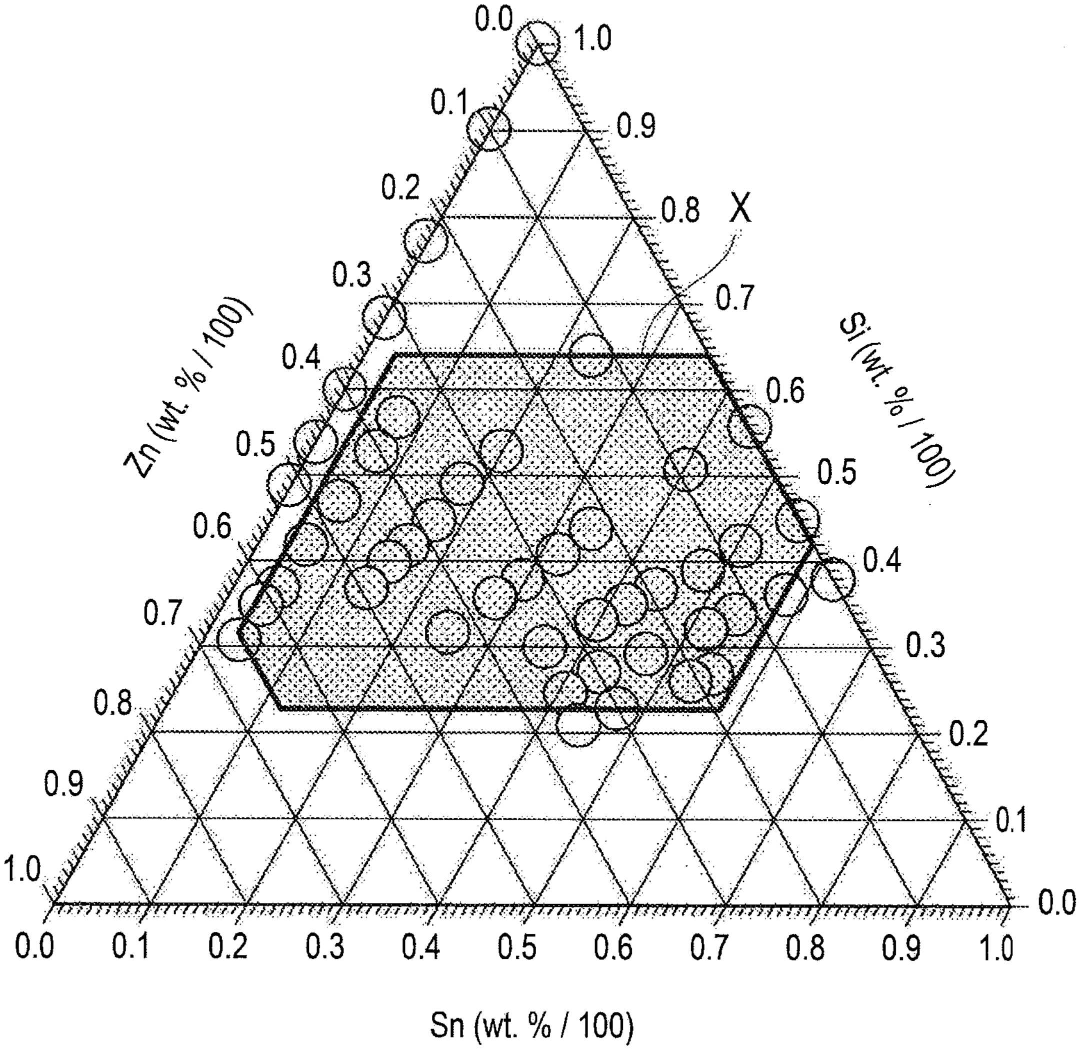
0.0
0.1
0.2
0.3
0.4
0.5
0.6
0.7
0.8
0.9
1.0
Zn (wt. % / 100)
1.0
0.9
0.8
0.7
0.6
0.5
0.4
0.3
0.2
0.1
0.0
Si (wt. % / 100)
X
0.0
0.1
0.2
0.3
0.4
0.5
0.6
0.7
0.8
0.9
1.0
Sn (wt. % / 100)

FIG. 6

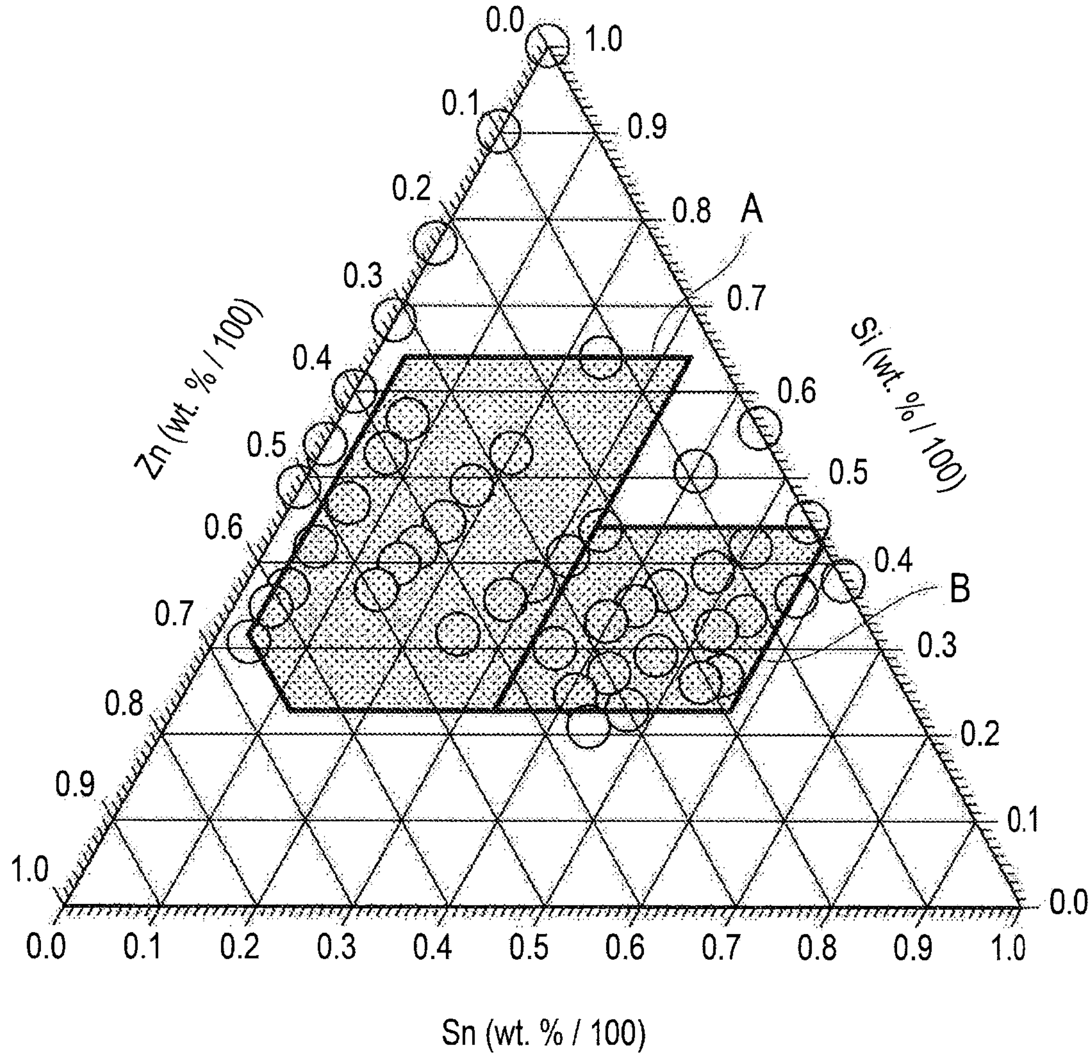
0.0
0.1
0.2
0.3
0.4
0.5
0.6
0.7
0.8
0.9
1.0
Zn (wt. % / 100)
1.0
0.9
0.8
0.7
0.6
0.5
0.4
0.3
0.2
0.1
0.0
Si (wt. % / 100)
A
B
0.0 0.1 0.2 0.3 0.4 0.5 0.6 0.7 0.8 0.9 1.0
Sn (wt. % / 100)

FIG. 7

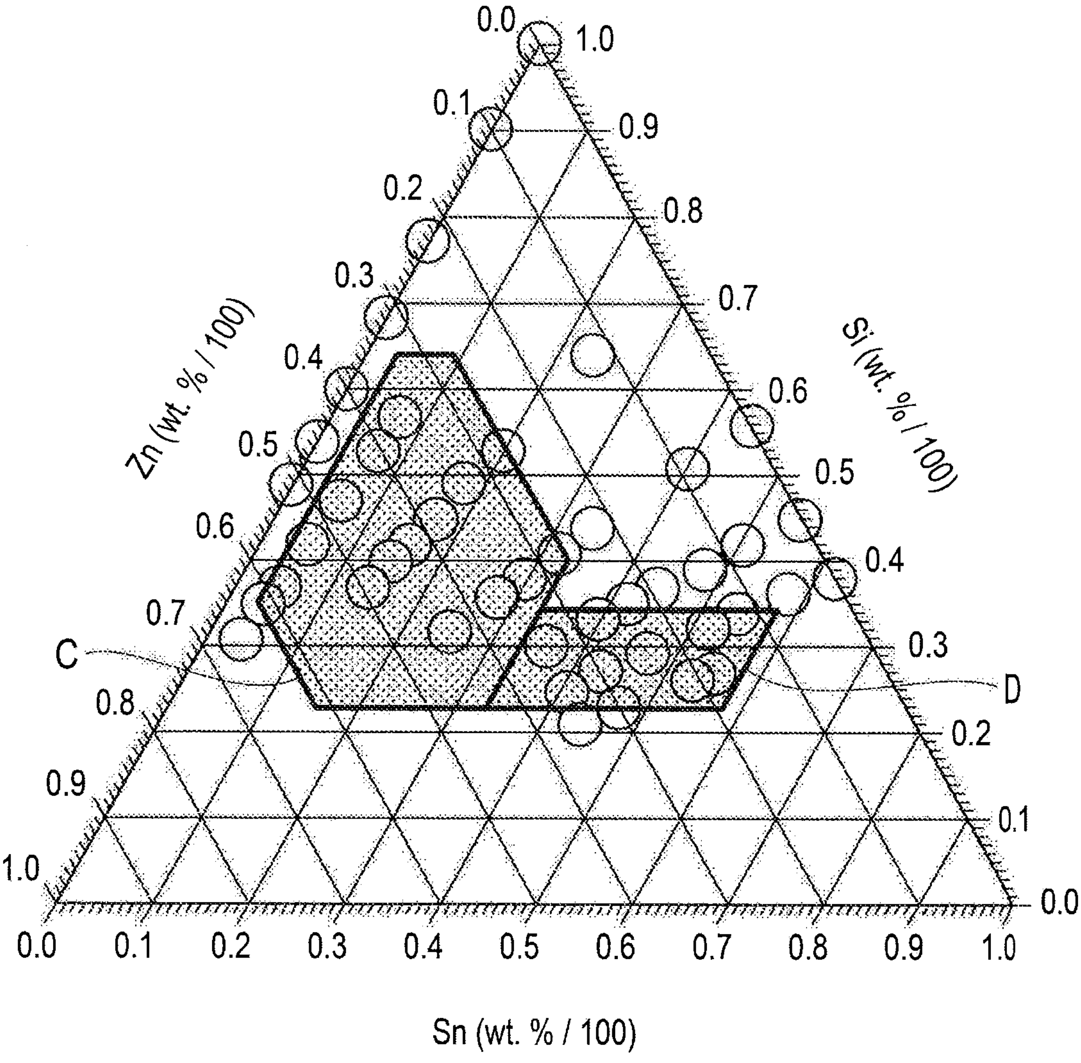

FIG. 8

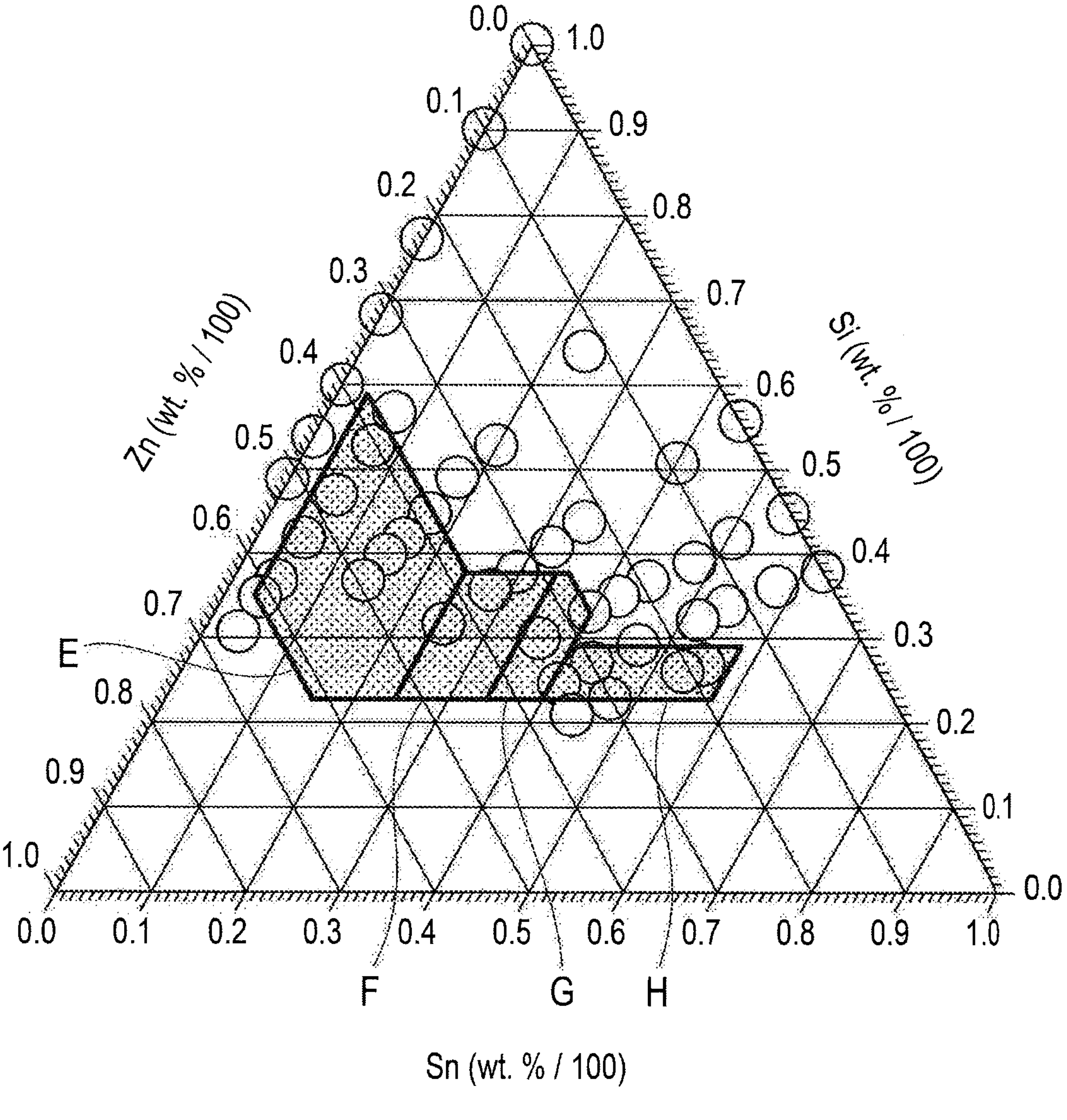

FIG. 9

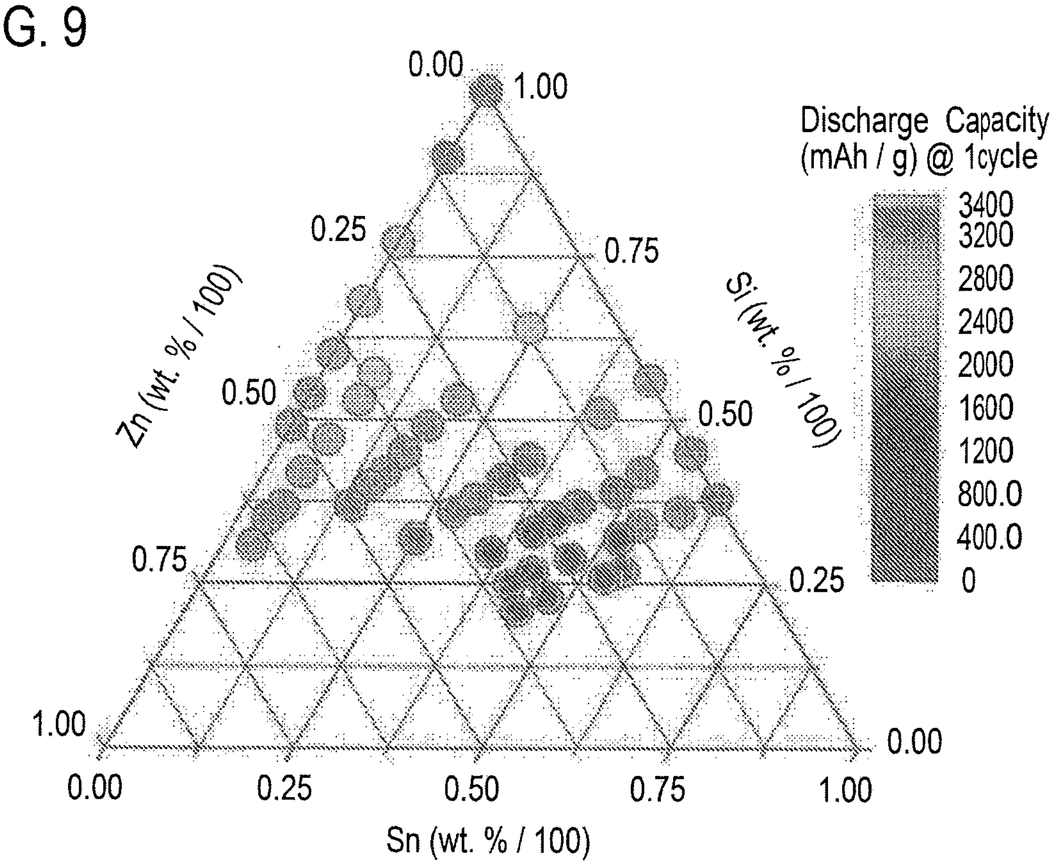
0.00
1.00
0.25
0.75
0.50
0.50
0.75
0.25
1.00
0.00
Zn (wt. % / 100)
Si (wt. % / 100)
0.00
0.25
0.50
0.75
1.00
Sn (wt. % / 100)
Discharge Capacity
(mAh / g) @ 1cycle
3400
3200
2800
2400
2000
1600
1200
800.0
400.0
0

FIG. 10

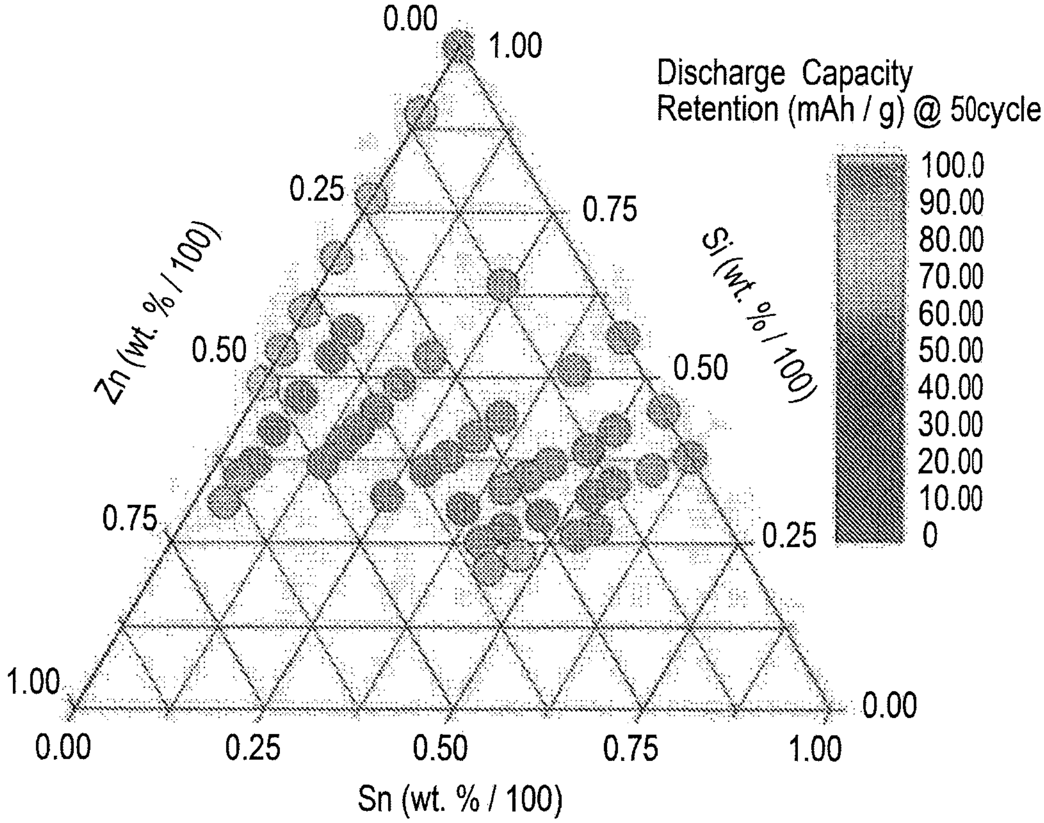
0.00
1.00
0.25
0.75
0.50
0.50
0.75
0.25
1.00
0.00
Zn (wt. % / 100)
Si (wt. % / 100)
0.00
0.25
0.50
0.75
1.00
Sn (wt. % / 100)
Discharge Capacity
Retention (mAh / g) @ 50cycle
100.0
90.00
80.00
70.00
60.00
50.00
40.00
30.00
20.00
10.00
0

FIG. 11

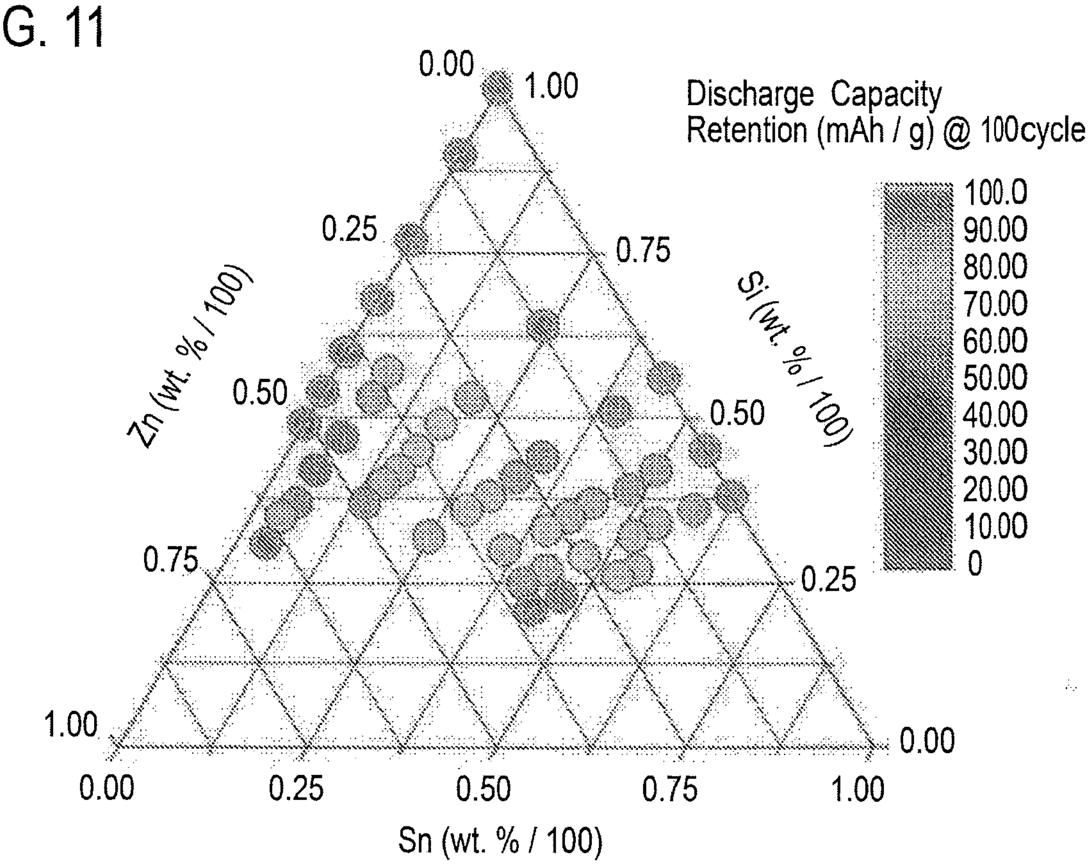
0.00
1.00
0.25
0.75
0.50
0.50
0.75
0.25
1.00
0.00
0.00
0.25
0.50
0.75
1.00
Zn (wt. % / 100)
Si (wt. % / 100)
Sn (wt. % / 100)
Discharge Capacity
Retention (mAh / g) @ 100cycle
100.0
90.00
80.00
70.00
60.00
50.00
40.00
30.00
20.00
10.00
0

FIG. 12

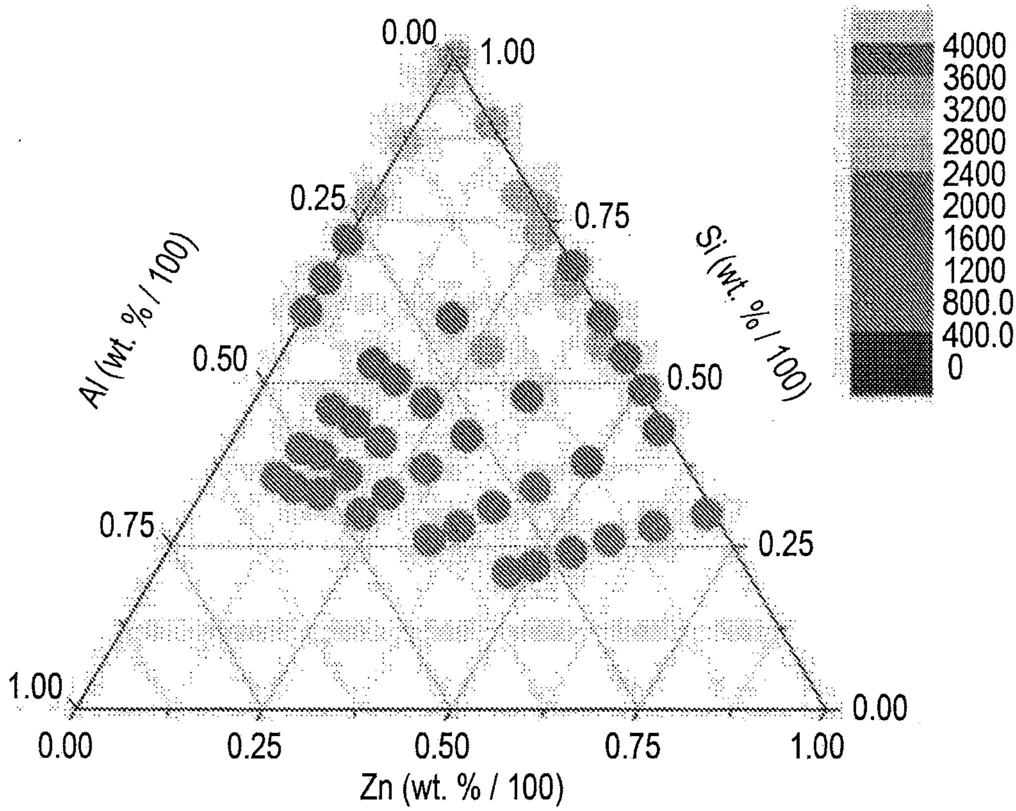
0.00
1.00
0.25
0.75
0.50
0.50
0.75
0.25
1.00
0.00
0.00
0.25
0.50
0.75
1.00
Al (wt. % / 100)
Si (wt. % / 100)
Zn (wt. % / 100)
4000
3600
3200
2800
2400
2000
1600
1200
800.0
400.0
0

FIG. 13

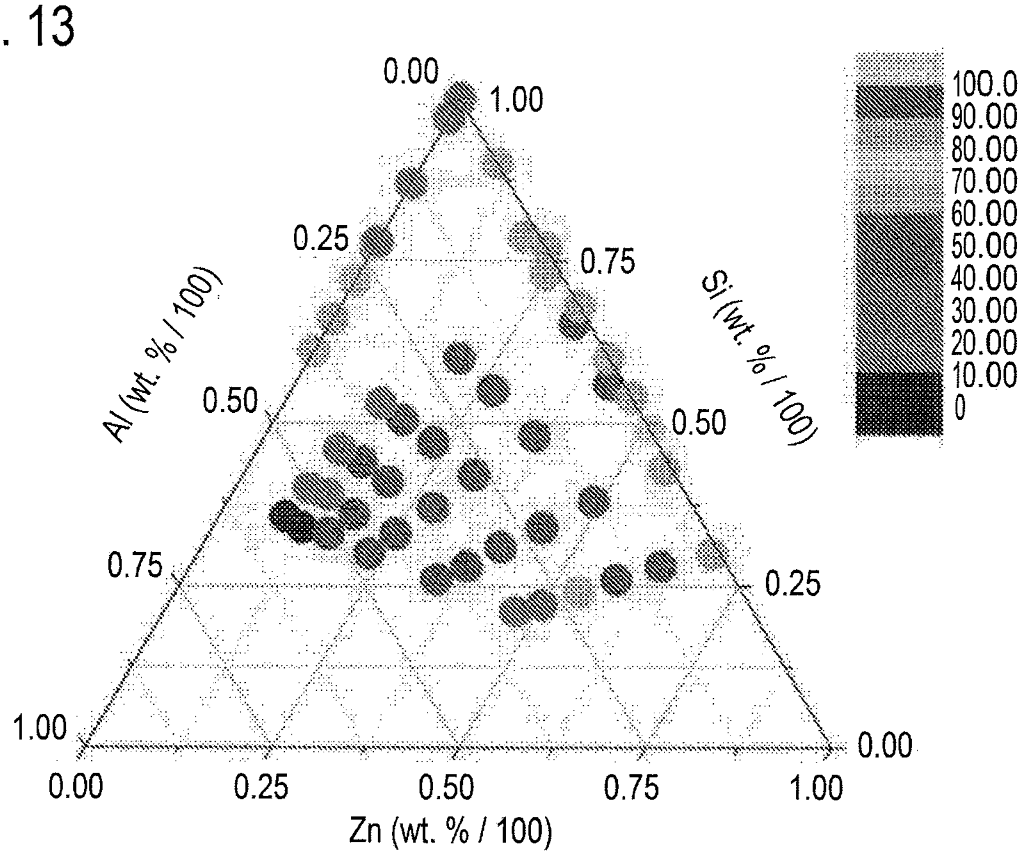
0.00
1.00
0.25
0.75
0.50
0.50
0.75
0.25
1.00
0.00
0.00
0.25
0.50
0.75
1.00
Al (wt. % / 100)
Si (wt. % / 100)
Zn (wt. % / 100)
100.0
90.00
80.00
70.00
60.00
50.00
40.00
30.00
20.00
10.00
0

FIG. 14

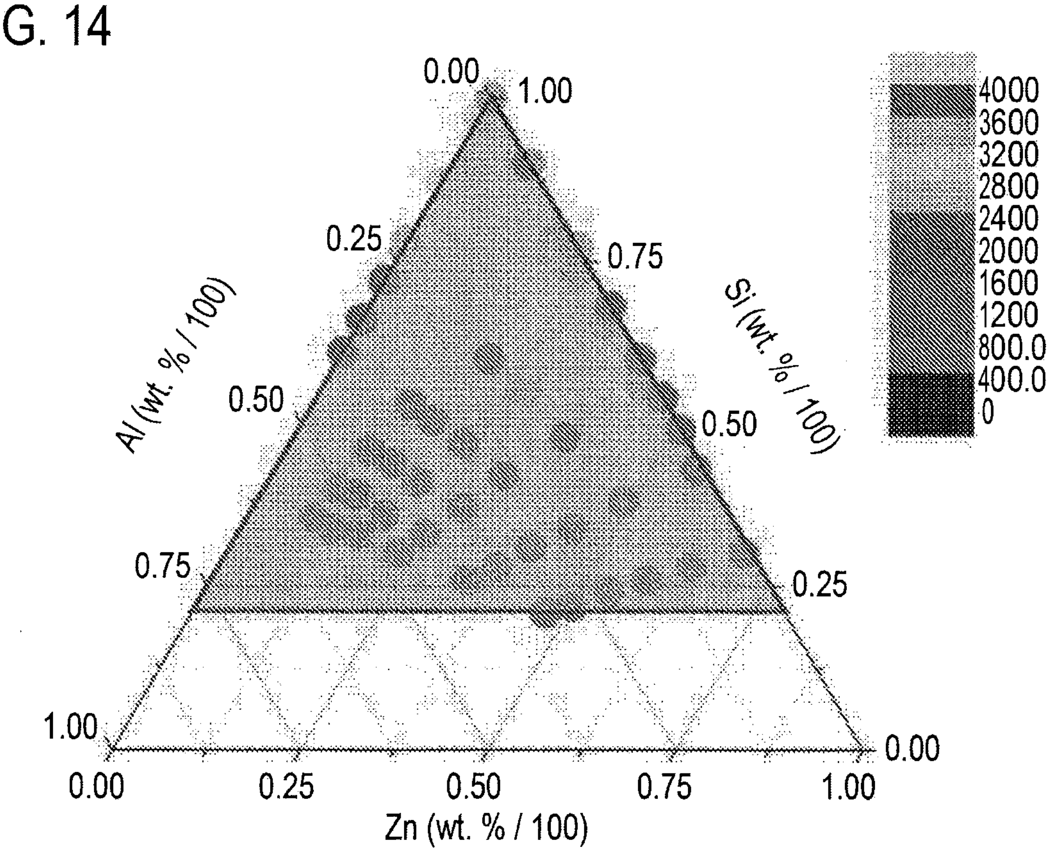
0.00
1.00
0.25
0.75
0.50
0.50
0.75
0.25
1.00
0.00
0.00
0.25
0.50
0.75
1.00
Al (wt. % / 100)
Si (wt. % / 100)
Zn (wt. % / 100)
4000
3600
3200
2800
2400
2000
1600
1200
800.0
400.0
0

FIG. 15

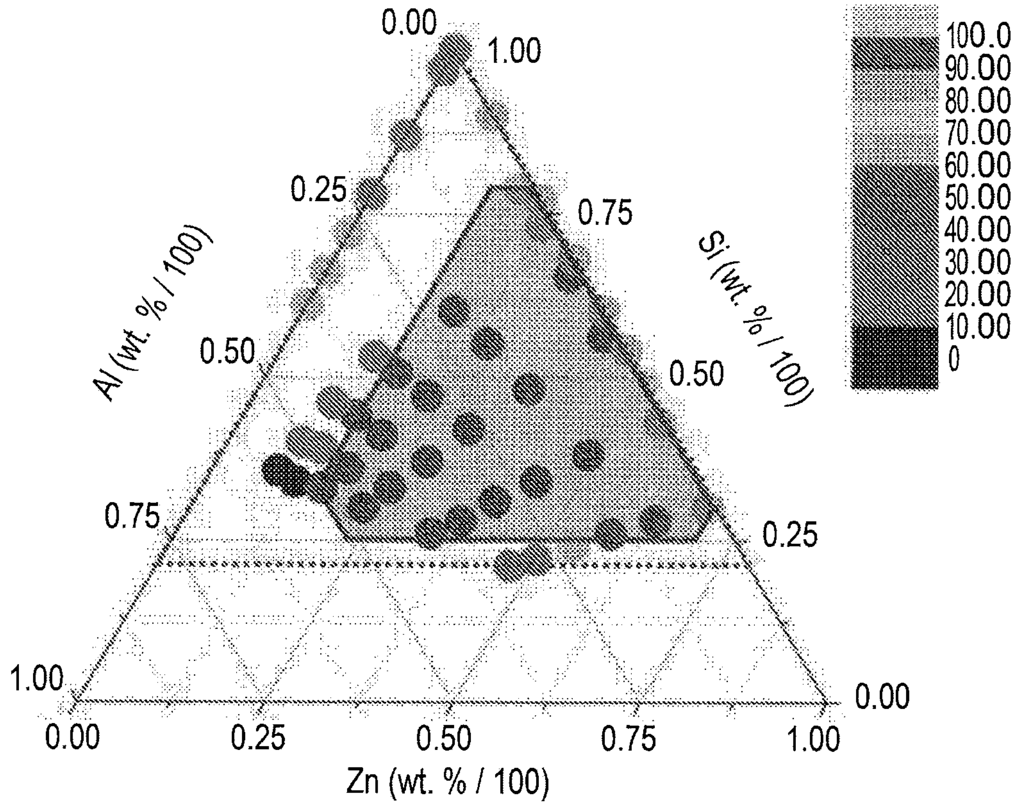
0.00
1.00
0.25
0.75
0.50
0.50
0.75
0.25
1.00
0.00
0.00
0.25
0.50
0.75
1.00
Al (wt. % / 100)
Si (wt. % / 100)
Zn (wt. % / 100)
100.0
90.00
80.00
70.00
60.00
50.00
40.00
30.00
20.00
10.00
0

FIG. 16

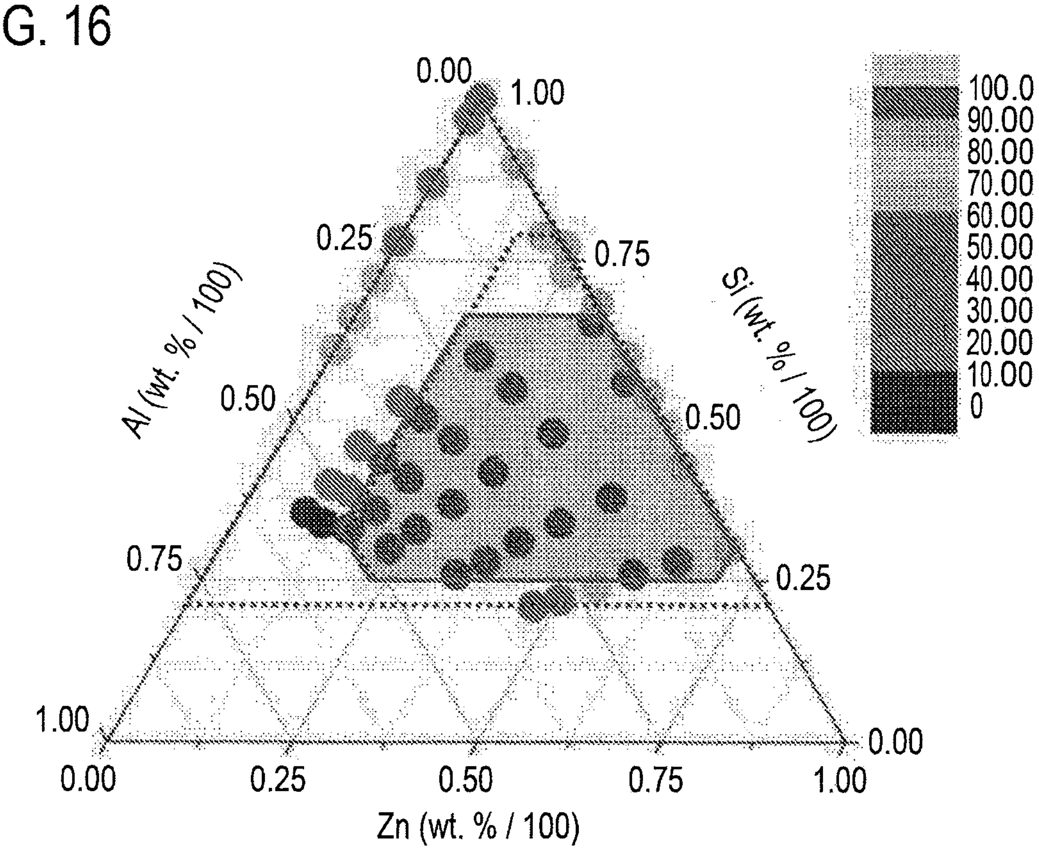
0.00
1.00
0.25
0.75
0.50
0.50
0.75
0.25
1.00
0.00
0.00
0.25
0.50
0.75
1.00
Al (wt. % / 100)
Si (wt. % / 100)
Zn (wt. % / 100)
100.0
90.00
80.00
70.00
60.00
50.00
40.00
30.00
20.00
10.00
0

FIG. 17

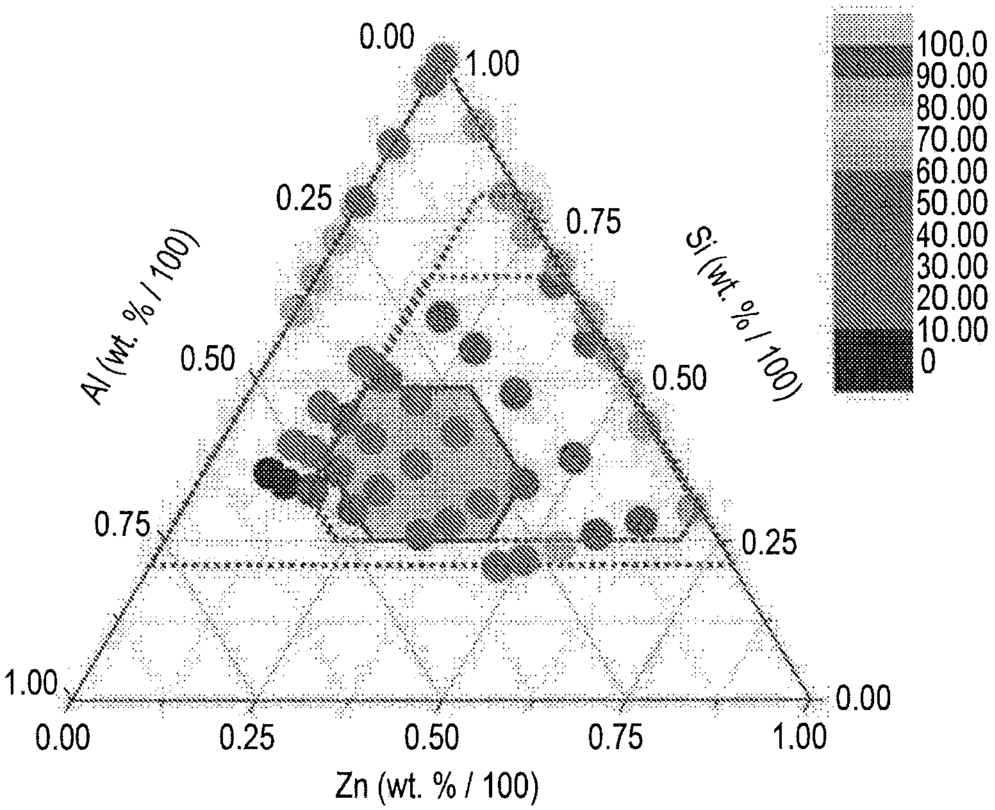
0.00
1.00
0.25
0.75
0.50
0.50
0.75
0.25
1.00
0.00
0.00
0.25
0.50
0.75
1.00
Al (wt. % / 100)
Si (wt. % / 100)
Zn (wt. % / 100)
100.0
90.00
80.00
70.00
60.00
50.00
40.00
30.00
20.00
10.00
0

FIG. 18

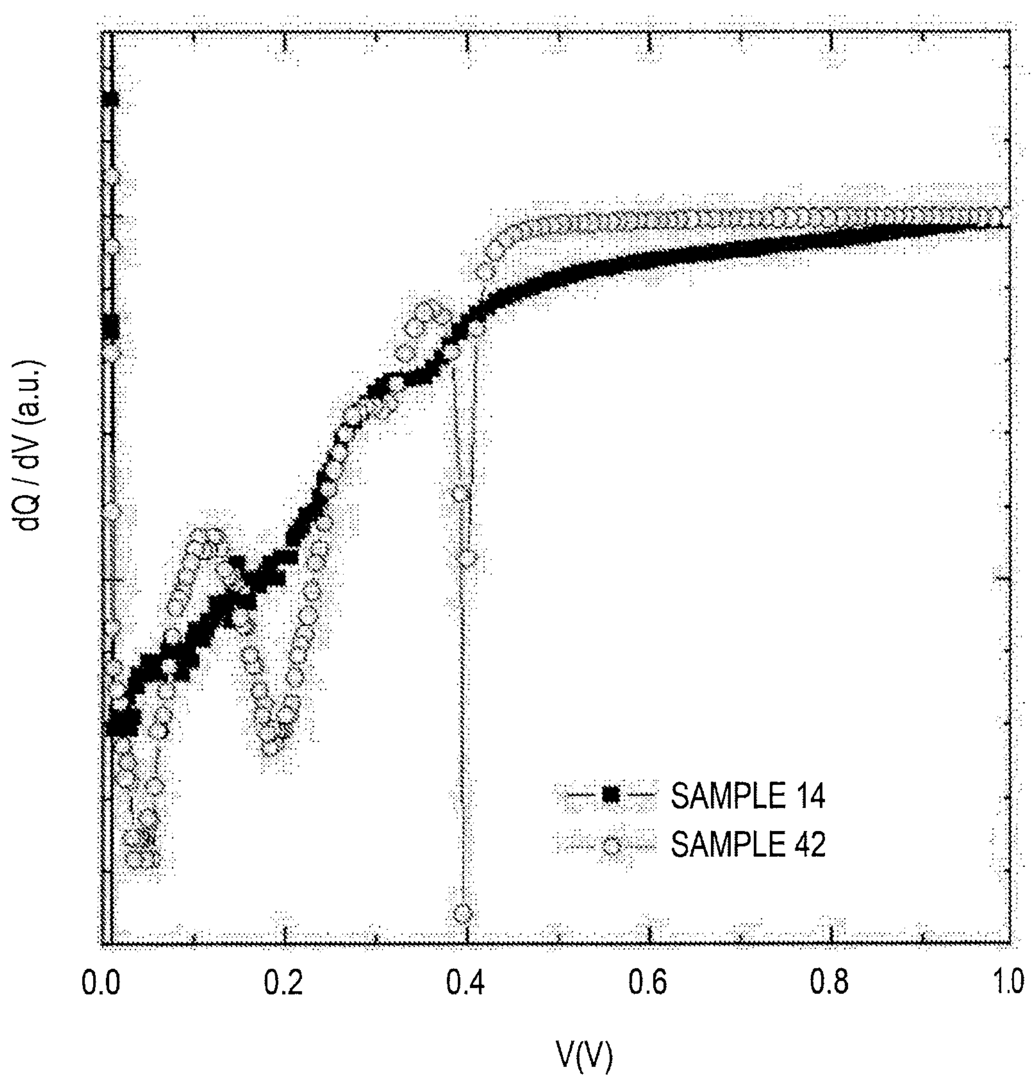

FIG. 19

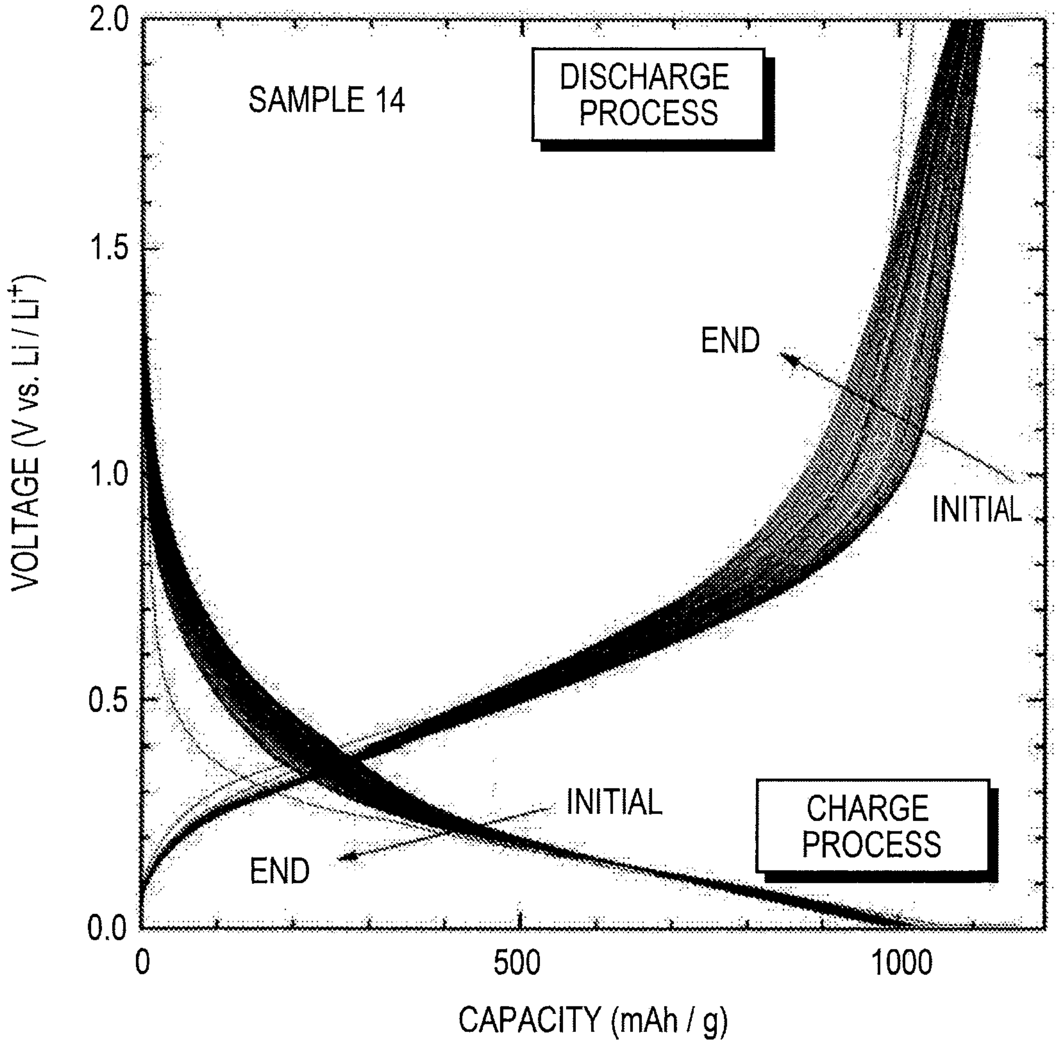
2.0
1.5
1.0
0.5
0.0
VOLTAGE (V vs. Li / Li+)
0
500
1000
CAPACITY (mAh / g)
SAMPLE 14
DISCHARGE PROCESS
END
INITIAL
INITIAL
END
CHARGE PROCESS

FIG. 20

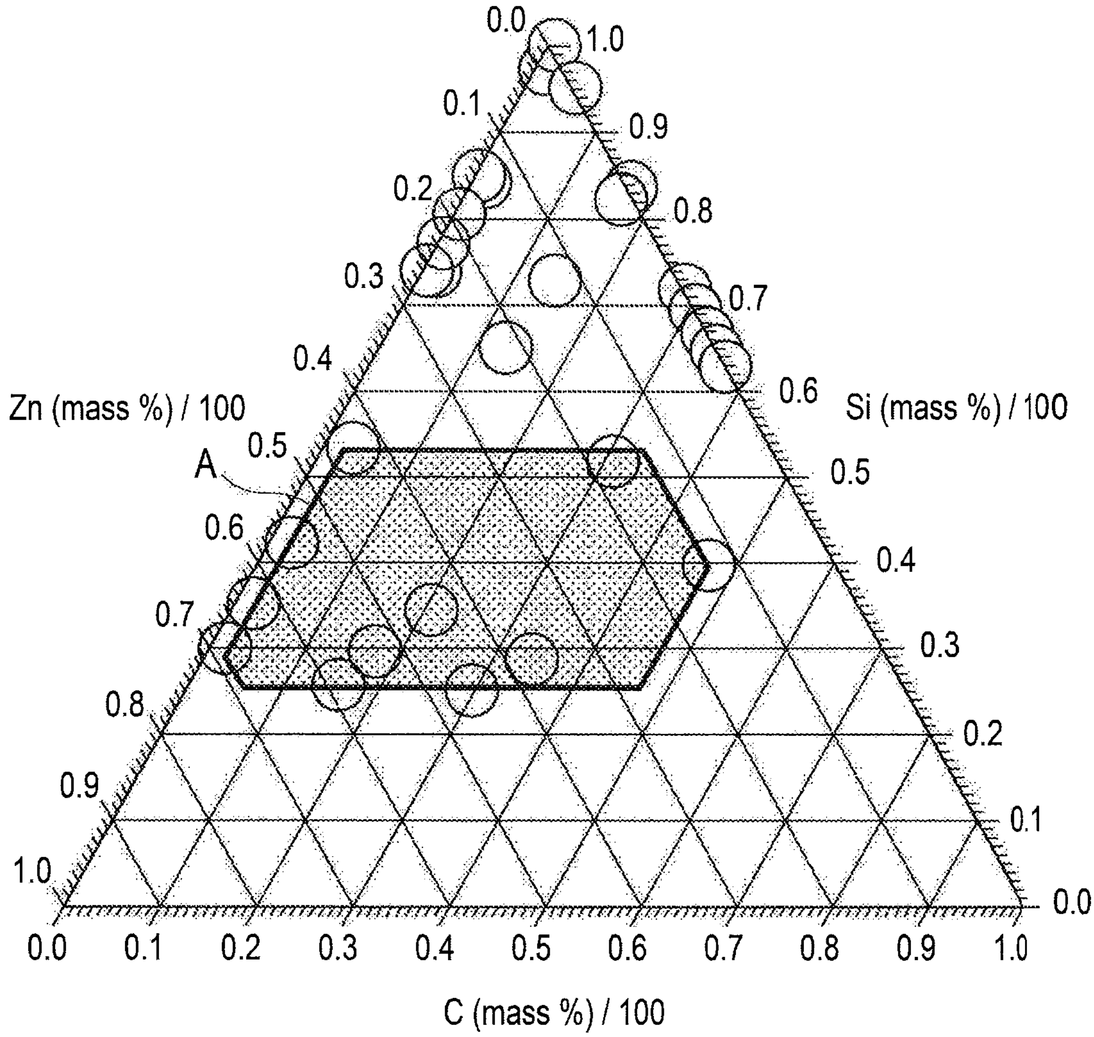
0.0
0.1
0.2
0.3
0.4
0.5
0.6
0.7
0.8
0.9
1.0
Zn (mass %) / 100
A
1.0
0.9
0.8
0.7
0.6
0.5
0.4
0.3
0.2
0.1
0.0
Si (mass %) / 100
0.0 0.1 0.2 0.3 0.4 0.5 0.6 0.7 0.8 0.9 1.0
C (mass %) / 100

FIG. 21

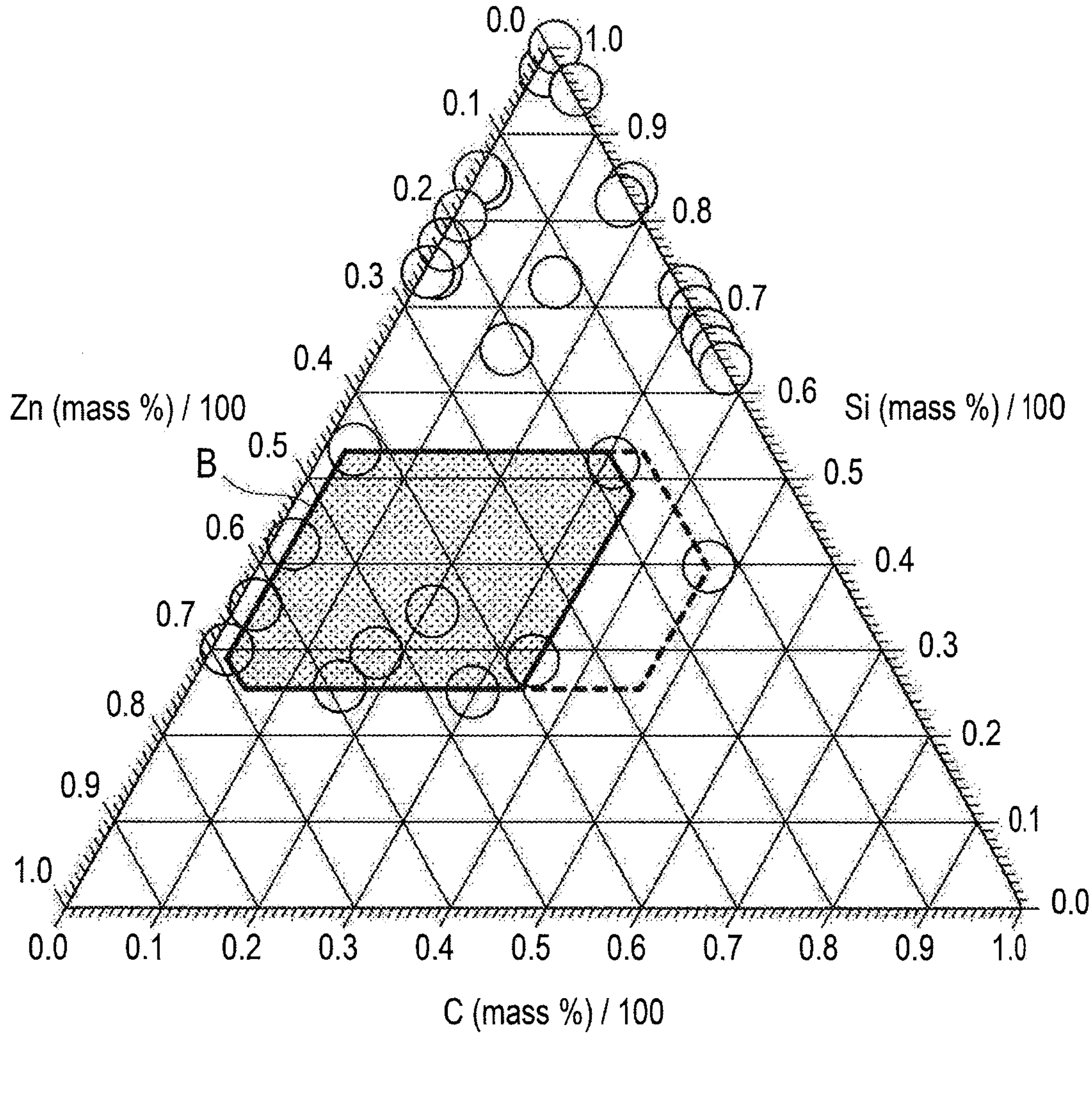
0.0
1.0
0.1
0.9
0.2
0.8
0.3
0.7
0.4
0.6
Zn (mass %) / 100
Si (mass %) / 100
0.5
B
0.5
0.6
0.4
0.7
0.3
0.8
0.2
0.9
0.1
1.0
0.0
0.0 0.1 0.2 0.3 0.4 0.5 0.6 0.7 0.8 0.9 1.0
C (mass %) / 100

FIG. 22

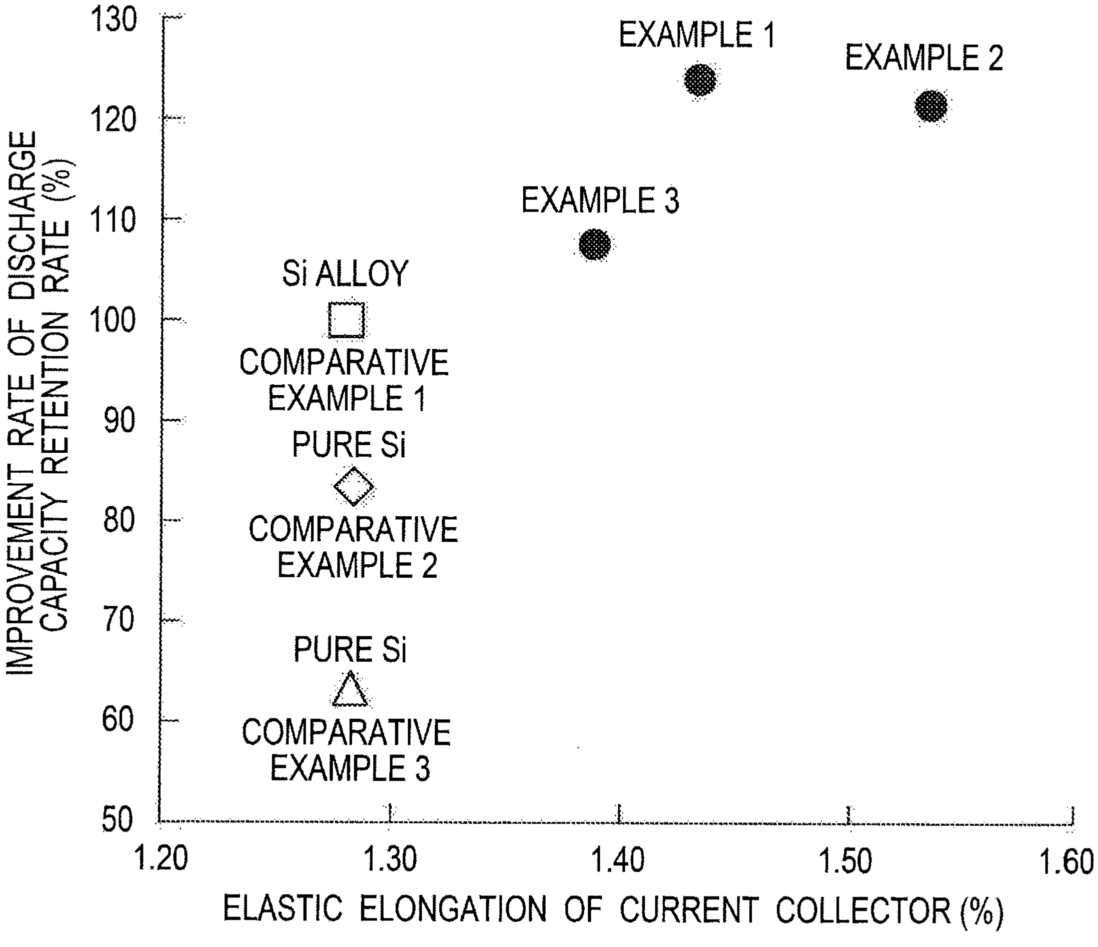
IMPROVEMENT RATE OF DISCHARGE CAPACITY RETENTION RATE (%)
130
120
110
100
90
80
70
60
50
EXAMPLE 1
EXAMPLE 2
EXAMPLE 3
Si ALLOY
COMPARATIVE EXAMPLE 1
PURE Si
COMPARATIVE EXAMPLE 2
PURE Si
COMPARATIVE EXAMPLE 3
1.20
1.30
1.40
1.50
1.60
ELASTIC ELONGATION OF CURRENT COLLECTOR (%)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP T2009517850 W
- JP 2012185913 A